(19) Europäisches Patentamt
European Patent Office
Office européen des brevets

(11) **EP 4 174 772 B1**

(12) **EUROPEAN PATENT SPECIFICATION**

(45) Date of publication and mention
of the grant of the patent:
**03.06.2026 Bulletin 2026/23**

(21) Application number: **22167347.8**

(22) Date of filing: **08.04.2022**

(51) International Patent Classification (IPC):
*G06T 7/33* (2017.01)    *G06T 7/55* (2017.01)
*G06T 7/73* (2017.01)    *G06T 17/00* (2006.01)
*G06T 19/00* (2011.01)    *G01C 21/00* (2006.01)
*G01C 21/20* (2006.01)

(52) Cooperative Patent Classification (CPC):
**G06T 7/73; G01C 21/206; G01C 21/383;
G06T 7/33; G06T 7/55; G06T 17/00;**
G06T 2207/20081; G06T 2207/20084;
G06T 2207/20221; G06T 2210/04

(54) **AUTOMATED BUILDING FLOOR PLAN GENERATION USING VISUAL DATA OF MULTIPLE BUILDING IMAGES**

AUTOMATISCHE GENERIERUNG VON GEBÄUDEGRUNDRISSEN UNTER VERWENDUNG VISUELLER DATEN AUS MEHREREN GEBÄUDEBILDERN

GÉNÉRATION AUTOMATISÉE DE PLAN D'ÉTAGE DE BÂTIMENT À L'AIDE DE DONNÉES VISUELLES DE PLUSIEURS IMAGES DE BÂTIMENTS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.10.2021 US 202163272854 P**
**26.01.2022 US 202217585433**

(43) Date of publication of application:
**03.05.2023 Bulletin 2023/18**

(73) Proprietor: **MFTB Holdco, Inc.**
**Seattle, Washington 98101 (US)**

(72) Inventors:
• **Lambert, John W**
**Seattle (US)**
• **LI, Yuguang**
**Seattle (CN)**
• **Boyadzhiev, Ivaylo**
**Seattle (BG)**
• **Wixson, Lambert E**
**Seattle (US)**

(74) Representative: **Reddie & Grose LLP**
**The White Chapel Building**
**10 Whitechapel High Street**
**London E1 8QS (GB)**

(56) References cited:
**US-A1- 2013 278 755    US-A1- 2021 125 397
US-A1- 2021 225 081**

**Description**

TECHNICAL FIELD

The following disclosure relates generally to techniques for automatically analyzing visual data of images captured in multiple rooms of a building to generate a floor plan for the building, such as to use analysis of visual data of the images to align pairs of images that have little or no overlapping visual coverage, and for subsequently using the generated floor plan in one or more manners such as to improve navigation of the building.

BACKGROUND

In various fields and circumstances, such as architectural analysis, property inspection, real estate acquisition and development, remodeling and improvement services, general contracting, automated navigation and other circumstances, it may be desirable to view information about the interior of a house, office, or other building without having to physically travel to and enter the building, including to determine actual as-built information about the building rather than design information from before the building is constructed. However, it can be difficult to effectively capture, represent and use such building interior information, including to display visual information captured within building interiors to users at remote locations (*e.g.,* to enable a user to fully understand the layout and other details of the interior, including to control the display in a user-selected manner). In addition, while a floor plan of a building may provide some information about layout and other details of a building interior, such use of floor plans has some drawbacks in certain situations, including that floor plans can be difficult to construct and maintain, to accurately scale and populate with information about room interiors, to visualize and otherwise use, etc. US 2021/0125397 discloses techniques for using computing devices to perform automated operations for analyzing video (or other image sequences) acquired in a defined area, as part of generating mapping information of the defined area for subsequent use (e.g., for controlling navigation of devices, for display on client devices in corresponding GUIs, etc.). The defined area may include an interior of a multi-room building, such as from an analysis of some or all image frames of the video (e.g., 360-degree image frames from 360-degree video) using structure-from-motion techniques to identify objects with associated plane and normal orthogonal information, and then clustering detected planes and/or normals from multiple analyzed images to determine likely wall locations. US 2021/0225081 discloses devices, systems, and methods that generate floorplans and measurements using a three-dimensional representation of a physical environment generated based on sensor data. US 2013/0278755 discloses a method of spatially referencing a plurality of images captured from a plurality of different locations within an indoor space by determining the location from which the plurality of images were captured. The method may include obtaining a plurality of distance-referenced images each captured from one position in the indoor space and at a different azimuth from the other distance-referenced images, a plurality of distance measurements, and orientation indicators each indicative of the azimuth of the corresponding one of the distance-referenced images.

BRIEF DESCRIPTION OF THE DRAWINGS

Figures 1A-1B are diagrams depicting an exemplary building interior environment and computing system(s) for use in embodiments of the present disclosure, including to generate and present information representing areas of the building.

Figures 2A-2S illustrate examples of automated operations for analyzing visual data of images captured in multiple rooms of a building to generate a floor plan for the building, such as based at least in part on using visual data of the images to align pairs of images that have little or no overlapping visual coverage, and for generating and providing information about the floor plan for the building.

Figure 3 is a block diagram illustrating computing systems suitable for executing embodiments of one or more systems that perform at least some of the techniques described in the present disclosure.

Figure 4 illustrates an example flow diagram for an Image Capture and Analysis (ICA) system routine in accordance with an embodiment of the present disclosure.

Figures 5A-5B illustrate an example flow diagram for a Mapping Information Generation Manager (MIGM) system routine in accordance with an embodiment of the present disclosure.

Figure 6 illustrates an example flow diagram for a Building Map Viewer system routine in accordance with an embodiment of the present disclosure.

DETAILED DESCRIPTION

The present disclosure describes techniques for using computing devices to perform automated operations related to analyzing visual data from images captured in multiple rooms of a building to generate a floor plan for the building, and for subsequently using the generated floor plan in one or more further automated manners. The images may, for example, include panorama images (*e.g.,* in an equirectangular projection format) and/or other types of images (*e.g.,* in a rectilinear perspective or orthographic format) that are acquired at acquisition locations in or around a multi-room building (*e.g.,* a house, office, etc.) and that have little or no visual overlap, referred to generally herein as 'target images' - in addition, in at least some such embodiments, the automated floor plan generation is further performed without having or using information from any depth sensors or other distance-measuring devices about distances from a target image's acquisition location to walls or other objects in the surrounding building, and without using any image registration or matching of identified visual objects across images, and instead using only visual data of the images (*e.g.,* RGB pixel data) in the manners described herein. The generated floor plan for a building (including structural layouts of individual rooms within the building) may be further used in various manners in various embodiments, such as in conjunction with generating other mapping-related information for the building, including for controlling navigation of mobile devices (*e.g.,* autonomous vehicles), for display or other presentation over one or more computer networks on one or more client devices in corresponding GUIs (graphical user interfaces), etc. Additional details are included below regarding the automated generation and use of floor plan information and optionally other related generated mapping information, and some or all of the techniques described herein may be performed via automated operations of a Mapping Information Generation Manager ("MIGM") system in at least some embodiments, as discussed further below.

As noted above, automated operations of an MIGM system may include generating a floor plan for a multi-room building based on analyzing visual data from multiple target images captured at the building, such as multiple panorama images captured at multiple acquisition locations in the multiple rooms and optionally other areas of the building - in at least some embodiments, the multiple panorama images each includes 360° of horizontal visual coverage around a vertical axis and visual coverage of some or all of the floor and/or ceiling in one or more rooms (*e.g.,* 180° or more of vertical visual coverage), and each may in some situations be presented using an equirectangular projection (with vertical lines and other vertical information in a captured environment being shown as straight lines in the projection, and with horizontal lines and other horizontal information in the environment being shown in the projection in a curved manner if they are above or below a horizontal centerline of the image, with an amount of curvature increasing as a distance from the horizontal centerline increases). The image acquisition device(s) that captures the target panorama images may, for example, be a mobile computing device that includes one or more cameras or other imaging systems (optionally including one or more fisheye lenses), and optionally includes additional hardware sensors to capture non-visual data, such as one or more inertial measurement unit (or "IMU") sensors that capture data reflecting the motion of the device, and/or may be a camera device that lacks computing capabilities and is optionally associated with a nearby mobile computing device.

In at least some embodiments, the automated operations of the MIGM system include analyzing visual data of pairs of target images that have little-to-no overlap in visual coverage in order to identify target images that are likely to be acquired at acquisition locations proximate to each other (*e.g.,* in adjacent rooms or other adjacent areas), performing a global optimization operation to refine the alignment of inter-image directions and acquisition locations (in combination, referred to at times herein as inter-image "pose" information) and optionally distances for some or all of the multiple target images for the building into globally aligning those target images using a common coordinate system, and then using information identified from the images' visual data that includes structural room layouts (*e.g.,* locations of walls and inter-wall borders) and structural wall elements (*e.g.,* windows, doorways and non-doorway wall openings, etc.) along with the aligned global information of those target images to generate a floor plan of the building (*e.g.,* a two-dimension, or 2D, floor plan, such as with indications of the locations of windows and/or doorways and/or other wall openings and optionally various other additional information, as discussed further below.

As part of the automated operations of the MIGM system to identify target images that are likely to be acquired at acquisition locations proximate to each other, the MIGM system may analyze each target panorama image (or other target image) to determine structural layout information for the room(s) or other area(s) visible in that target image, such as by supplying the image to a trained machine learning model (*e.g.,* as part of a layout determination neural network or other type of neural network, as part of a vision image transformer network, etc.) that both determines the locations of the walls visible in that target image and identifies structural elements of those walls and any visible floor(s) and ceiling(s) (*e.g.,* windows and/or sky-lights; passages into and/or out of the room, such as doorways and other openings in walls, stairways, hallways, etc.; borders between adjacent walls; borders between walls and a floor; borders between walls and a ceiling; borders between a floor and a ceiling; corners (or solid geometry vertices) where at least three surfaces or planes meet; etc.) in a single pass, and optionally identifies other fixed structural elements (*e.g.,* countertops, bath tubs, sinks, islands, fireplaces, etc.), as well as to optionally generate 2D or 3D bounding boxes for the identified elements or otherwise track locations of the identified elements. In some embodiments, the trained layout determination machine learning model may further use additional data captured during or near the acquisition of that target image (*e.g.*, IMU motion data of the image acquisition device and/or accompanying mobile computing device), while in other embodiments no such additional data may be used. In at least some such embodiments, the determined structural layout information from a target image may be 2D structural information (*e.g.*, indications of positions of walls relative to each other, optionally with additional information added such as locations of structural wall elements including doorways and/or non-doorway wall openings and/or windows), while in other embodiments the determined structural layout information may include a partial or complete 3D structure for visible room(s) or other building area(s), optionally using inferred depth from monocular depth estimation performed using the RGB visual data of the target image and/or optionally including estimated semantic information about objects and/or surfaces visible in the target image (*e.g.,* from a trained semantic machine learning model, such as part of a segmentation neural network or a vision image transformer network, and whether the same as or different from the trained layout determination machine learning model). Such a 3D structure from a target image may correspond to an estimated partial or full room shape for each of one or more rooms visible in the visual data of the target image, such as, for example, a 3D point cloud (with a plurality of 3D data points corresponding to locations on the walls and optionally the floor and/or ceiling) and/or disconnected partial planar surfaces (corresponding to portions of the walls and optionally the floor and/or ceiling) and/or wireframe structural lines (*e.g.,* to show one or more of borders between walls, borders between walls and ceiling, borders between walls and floor, outlines of doorways and/or other inter-room wall openings, outlines of windows, etc.). In addition, in embodiments in which such room shapes are generated, they may be further used as part of one or more additional operations, such as when generating a floor plan (*e.g.,* to generate a 3D model floor plan using 3D room shapes, to generate a 2D floor plan by fitting 3D room shapes together and then removing height information, etc.), and/or when determining local alignment information (*e.g.,* by aligning the 3D room shapes generated from two panorama images of a pair, such as in addition to aligning views rendered from those panorama images or instead of aligning views rendered from those panorama images), and/or when performing global alignment information from determined local information for pairs of panorama images or other images. In at least some such embodiments, automated operations of the trained layout determination machine learning model are performed in situations where there is not sufficient visual overlap in images (or enough other supplemental data, if any) to estimate room shapes using combinations of multiple images and techniques that involve identifying matching objects across multiple images such as SfM (Structure from Motion) and/or SLAM (Simultaneous Localization And Mapping) and/or MVS (multiple-view stereovision) analysis. In addition, in at least some such embodiments, the determination of structural layout information for a target image may further determine, within the determined layout(s) of the room(s) or other area(s), the target image 'pose' (the acquisition location of the target image, such as in three dimensions or degrees of freedom, and sometimes represented in a three-dimensional grid as an X, Y, Z tuple, and the orientation of the target image, such as in three additional dimensions or degrees of freedom, and sometimes represented as a three-dimensional rotational tuple or other directional vector), which is also referred to at times herein as an 'acquisition pose' or an 'acquisition position' of the target image. Additional details are included below regarding the analysis of visual data of a target image to determine layout information for the room(s) or other area(s) visible in that target image.

In addition, the automated operations of the MIGM system to identify target images that are likely to be acquired at acquisition locations proximate to each other may further use the visual data of each target image (and optionally determined layout information for that target image) to render one or more two-dimensional image views (*e.g.*, a orthographic primary projection along an axis in a perspective format, such as a vertical axis; a projected image in a perspective format, such as along a vertical axis; etc.) in rectilinear format that each is based on a subset of the visual data of the target panorama image, such as that includes visual data of some or all of the floor and optionally an indication of the walls connected to the floor (referred to at times herein as a "floor view image" or "floor image", such as part of a "top-down" view), and/or that includes visual data of some or all of the ceiling and optionally an indication of the walls connected to the ceiling (referred to at times herein as a "ceiling view image" or "ceiling image", such as part of a "bottom-up" view) - in some embodiments, other views may be generated and used for comparison to determine local alignment information between a pair of images (*e.g.*, rendered views of one or more visible planar surfaces and/or that each include some or all of one or more walls of a surrounding room, or otherwise corresponding to designated horizontal and/or vertical directions, such as four views that each differ by 90° horizontally), whether in addition to or instead of floor and/or ceiling views. As part of rendering one or more views for each target image, at least some such rendered views may optionally include one or more of various types of information that is overlaid or otherwise used within a rendered image, such as one or more of the following: a texture map of the area shown in the view, such as by using monocular-depth estimation to place RGB pixel values into corresponding positions in the view; identification of locations of floor and/or ceiling features learned by the trained machine learning model (*e.g.,* lights, fans, vents, carpets, furniture, etc.); estimated semantic information, optionally color-coded (*e.g.,* to identify structural elements, built-in features such as toilets and fireplaces, etc.); etc. Additional details are included below regarding the generating of views for a target image.

After generating one or more rendered view images from a target image, the automated operations of the MIGM system further include comparing the visual contents of each target image and its rendered view image(s) to some or all other target images and their rendered view images, such as in a pairwise manner to identify any portions of the image/view(s) for each image of the pair that appear to match each other, and optionally generating an alignment score or other alignment indication (*e.g.*, a probability or other likelihood) that the two images include visual coverage of a common area, or that the two images otherwise include visual data indicating a likelihood that the two images of the pair were acquired at acquisition locations proximate to each other - as one example, comparison of visual data of two images of a pair may identify that visible objects and/or elements in one image indicate it is likely to be a kitchen (*e.g.*, tile, a sink, etc.) and that visible objects and/or elements in the other image of the pair indicate it is likely to be a family room, with there being a corresponding statistical likelihood (*e.g.*, a probabilistic prior) that those two room types are adjacent and that the two images' acquisition locations are therefore correspondingly proximate. The 'best' pairwise image alignments (*e.g.*, those with the highest alignment scores or other highest alignment indication) may then be selected and combined to form a group of inter-connected target images that includes some or all of the target images, such as by performing a global optimization operation to refine the alignment of inter-image poses for those some or all target images and globally aligning those target images' acquisition locations into a common coordinate system. The global alignment of those target images' acquisition locations may then be used by the MIGM system, along with determined room layout information, to generate a floor plan for the building that includes some or all of the building rooms and/or other areas, such as for further use in one or more automated manners - in at least some such embodiments, information about determined structural elements of rooms and other building areas may be used to fit layouts together, such as to match doorways and other wall openings between two rooms, to use windows for exterior walls that do not have another room on the other side (unless visual data available through a window between two rooms shows matches for images acquired in those two rooms) and that optionally have a matching external area on the other side, to discard alignments that are impossible or infeasible (*e.g.*, in which structural elements of a first layout, such as a wall, would penetrate free space of a second layout in a manner inconsistent with the visual data of the image from which the second layout was generated; in which the sizes, such as relative widths and/or heights, of matching identified objects in the rendered views corresponding to the layouts, such as doorways and/or non-doorway wall openings and/or windows, are not within a defined threshold of being the same; using other defined criteria, etc.). In some embodiments, local alignment information may be determined for, rather than a pair of images, one or more sub-groups each having two or more images (*e.g.*, at least three images), and the group of inter-connected target images used to determine the global alignment information may include multiple such image sub-groups. In addition, in at least some embodiments, the floor plan may be generated in a format using vector graphics, while in other embodiments the floor plan may have other forms (*e.g.*, bitmapped graphics). Furthermore, in some embodiments, global alignment information is determined in a manner similar to that described elsewhere herein but without performing a separate determination of local alignment information for pairs or other sub-groups of images, such as to directly perform the determination of the global alignment information from comparison of rendered views and/or other information (*e.g.*, determined 3D room shapes) for some or all available target images. Additional details are included below regarding using visual data of the target images to align them and to use information about a group of aligned target images to generate a floor plan and/or other related mapping information for a building (*e.g.*, a three-dimensional, or 3D, model of the building; inter-connected linked target images, such as for use to provide a virtual tour of corresponding acquisition locations of the building; etc.).

In addition, in some embodiments, the automated operations of the MIGM system include obtaining input information of one or more types from one or more users (*e.g.*, system operator users of the MIGM system that assist in its operations, end users that obtain results of information from the MIGM system, etc.), such as to be incorporated into subsequent automated analyses in various manners, including to replace or supplement automatically generated information of the same type, to be used as constraints and/or prior probabilities during later automated analysis (*e.g.*, using a trained machine learning model), etc. Furthermore, in some embodiments, the automated operations of the MIGM system further include obtaining and using additional types of information during its analysis activities, with non-exclusive examples of such additional types of information uses including the following: obtaining and using names or other tags for particular rooms or other building areas, such as for use in grouping target images whose acquisition locations are in such rooms or other areas; obtaining information to use as initial pose information for a target image (*e.g.*, to be refined in subsequent automated determination of structural layout information from the target image); obtaining and using other image acquisition metadata to group target images or to otherwise assist in image analysis, such as to use image acquisition time information and/or order information to identify consecutive images that may be captured in proximate acquisition locations; etc. Additional details are included below regarding other automated operations of the MIGM system in some embodiments and situations.

The described techniques provide various benefits in various embodiments, including to allow partial or complete floor plans of multi-room buildings and other structures to be automatically generated from target image(s) acquired for the building or other structure, including to provide more complete and accurate room shape information and/or in greater varieties of conditions (*e.g.*, in situations in which acquired target images do not have sufficient visual overlap to use other techniques that match features in images, such as SfM and SLAM), and including in some embodiments without having or using information from depth sensors or other distance-measuring devices about distances from images' acquisition

locations to walls or other objects in a surrounding building or other structure, and/or without using any image registration or matching of visual elements across images. Non-exclusive examples of additional such benefits of the described techniques include the following: the ability to analyze the visual data of a target image to detect objects of interest in an enclosing room or other building area (*e.g.*, structural wall elements, such as windows, doorways and other wall openings, etc.) and to determine locations of those detected objects in a determined layout for the enclosing room or other building area; the ability to analyze additional captured data (*e.g.*, movement data from one or more IMU sensors, visual data from one or more image sensors, etc.) to determine a travel path of an image acquisition device in multiple rooms, to identify wall openings (*e.g.*, doorways, staircases, etc.) of the multiple rooms based at least in part on that additional data (and optionally on visual data of one or more target images acquired in the one or more rooms), and to optionally further use such information about identified wall openings as part of positioning together determined 2D room layouts and/or 3D room shapes of the multiple rooms; the ability to inter-connect multiple target images and display at least one of the target images with user-selectable visual indicators in the directions of other linked target images that when selected cause the display of a respective other one of the linked target images (*e.g.*, as part of a virtual tour), such as by placing the various target images in a common coordinate system that shows at least their relative locations, or to otherwise determine at least directions between pairs of target images (*e.g.*, based at least in part on an automated analysis of the visual contents of the target images in the pair, and optionally based on further movement data from the mobile computing device along a travel path between the target images), and to link the various target images using the determined inter-image directions; etc. Furthermore, the described automated techniques allow such room shape information to be determined more quickly than previously existing techniques, and in at least some embodiments with greater accuracy, including by using information acquired from the actual building environment (rather than from plans on how the building should theoretically be constructed), as well as enabling the capture of changes to structural elements that occur after a building is initially constructed. Such described techniques further provide benefits in allowing improved automated navigation of a building by devices (*e.g.,* semiautonomous or fully-autonomous vehicles), based at least in part on the determined acquisition locations of images and/or the generated floor plan information (and optionally other generated mapping information), including to significantly reduce computing power and time used to attempt to otherwise learn a building's layout. In addition, in some embodiments, the described techniques may be used to provide an improved GUI in which a user may more accurately and quickly obtain information about a building's interior (*e.g.*, for use in navigating that interior) and/or other associated areas, including in response to search requests, as part of providing personalized information to the user, as part of providing value estimates and/or other information about a building to a user, etc. Various other benefits are also provided by the described techniques, some of which are further described elsewhere herein.

As noted above, in at least some embodiments and situations, some or all of the images acquired for a building may be panorama images that are each acquired at one of multiple acquisition locations in or around the building, such as to generate a panorama image at each such acquisition location from one or more of a video captured at that acquisition location (*e.g.*, a 360° video taken from a smartphone or other mobile device held by a user turning at that acquisition location), or multiple images captured in multiple directions from the acquisition location (*e.g.*, from a smartphone or other mobile device held by a user turning at that acquisition location; from automated rotation of a device at that acquisition location, such as on a tripod at that acquisition location; etc.), or a simultaneous capture of all the image information for a particular acquisition location (*e.g.*, using one or more fisheye lenses), etc. It will be appreciated that such a panorama image may in some situations be presented using an equirectangular projection (with vertical lines and other vertical information in an environment being shown as straight lines in the projection, and with horizontal lines and other horizontal information in the environment being shown in the projection in a curved manner if they are above or below a horizontal centerline of the image and with an amount of curvature increasing as a distance from the horizontal centerline increases) and provide up to 360° coverage around horizontal and/or vertical axes (*e.g.*, 360° of coverage along a horizontal plane and around a vertical axis), while in other embodiments the acquired panorama images or other images may include less than 360° of vertical coverage (*e.g.,* for images with a width exceeding a height by more than a typical aspect ratio, such as at or exceeding 21:9 or 16:9 or 3:2 or 7:5 or 4:3 or 5:4 or 1:1, including for so-called 'ultrawide' lenses and resulting ultrawide images). In addition, it will be appreciated that a user viewing such a panorama image (or other image with sufficient horizontal and/or vertical coverage that only a portion of the image is displayed at any given time) may be permitted to move the viewing direction within the panorama image to different orientations to cause different subset images of the panorama image to be rendered, and that such a panorama image may in some situations be stored and/or presented using an equirectangular projection (including, if the panorama image is represented using an equirectangular projection, and if a particular subset image of it is being rendered, to convert the image being rendered into a planar coordinate system before it is displayed, such as into a perspective image). Furthermore, acquisition metadata regarding the capture of such panorama images may be obtained and used in various manners, such as data acquired from IMU sensors or other sensors of a mobile device as it is carried by a user or otherwise moved between acquisition locations - non-exclusive examples of such acquisition metadata may include one or more of acquisition time; acquisition location, such as GPS coordinates or other indication of location;

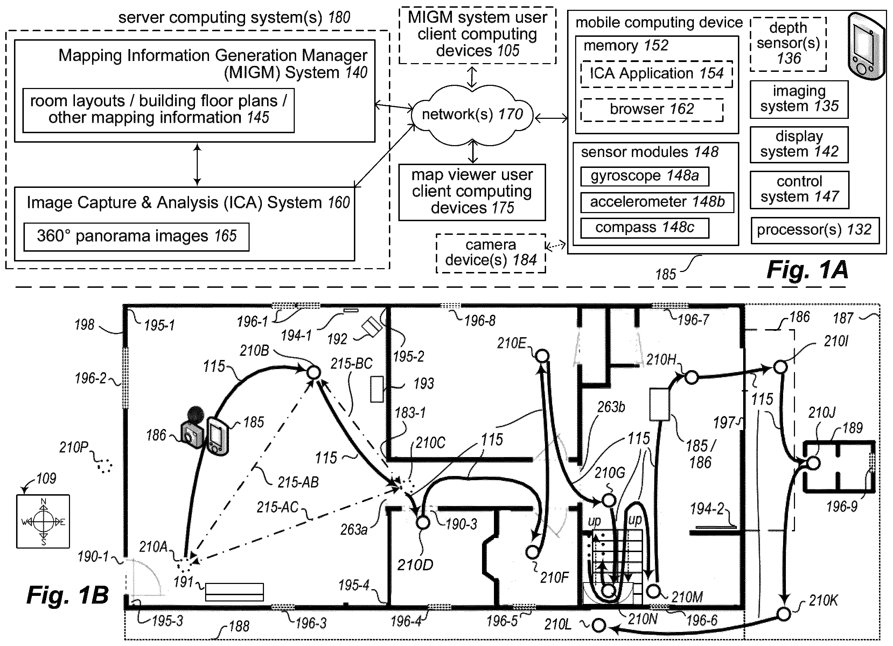

acquisition direction and/or orientation; relative or absolute order of acquisition for multiple images acquired for a building or that are otherwise associated; etc., and such acquisition metadata may further optionally be used as part of determining the images' acquisition locations in at least some embodiments and situations, as discussed further below. Additional details are included below regarding automated operations of device(s) implementing an Image Capture and Analysis (ICA) system involved in acquiring images and optionally acquisition metadata, including with respect to Figures 1A-1B, 2A-2D and 4 and elsewhere herein.

As is also noted above, a building floor plan having associated room layout or shape information for some or all rooms of the building may be generated in at least some embodiments, and further used in one or more manners, such as in the subsequent automated determination of an additional image's acquisition location within the building. A building floor plan with associated room shape

information may have various forms in various embodiments, such as a 2D (two-dimensional) floor map of the building (*e.g.,* an orthographic top view or other overhead view of a schematic floor map that does not include or display height information) and/or a 3D (three-dimensional) or 2.5D (two and a half-dimensional) floor map model of the building that does display height information. In addition, layouts and/or shapes of rooms of a building may be automatically determined in various manners in various embodiments, including in some embodiments at a time before automated determination of a particular image's acquisition location within the building. For example, in at least some embodiments, a Mapping Information Generation Manager (MIGM) system may analyze various target images acquired in and around a building in order to automatically determine room shapes of the building's rooms (*e.g.,* 3D room shapes, 2D room shapes, etc., such as to reflect the geometry of the surrounding structural elements of the building) - the analysis may include, for example, automated operations to 'register' the camera positions for the images in a common frame of refence so as to 'align' the images and to estimate 3D locations and shapes of objects in the room, such as by determining features visible in the content of such images (*e.g.*, to determine the direction and/or orientation of the acquisition device when it took particular images, a path through the room traveled by the acquisition device, etc., but without a 'dense' set of images that are separated by at most a defined distance (such as 6 feet) that enable use of SLAM techniques for multiple video frame images and/or other SfM techniques to generate a 3D point cloud for the room including 3D points along walls of the room and at least some of the ceiling and floor of the room and optionally with 3D points corresponding to other objects in the room, etc.) and/or by determining and aggregating information about planes for detected features and normal (orthogonal) directions to those planes to identify planar surfaces for likely locations of walls and other surfaces of the room and to connect the various likely wall locations (*e.g.*, using one or more constraints, such as having 90° angles between walls and/or between walls and the floor, as part of the so-called 'Manhattan world assumption') and form an estimated partial room shape for the room. After determining the estimated partial room layouts and/or shapes of the rooms in the building, the automated operations may, in at least some embodiments, further include positioning the multiple room shapes together to form a floor plan and/or other related mapping information for the building, such as by connecting the various room shapes, optionally based at least in part on information about doorways and staircases and other inter-room wall openings identified in particular rooms, and optionally based at least in part on determined travel path information of a mobile computing device between rooms. Additional details are included below regarding automated operations of device(s) implementing an MIGM system involved in determining room shapes and combining room shapes to generate a floor plan, including with respect to Figures 1A-1B, 2E-2S and 5A-5B and elsewhere herein.

For illustrative purposes, some embodiments are described below in which specific types of information are acquired, used and/or presented in specific ways for specific types of structures and by using specific types of devices - however, it will be understood that the described techniques may be used in other manners in other embodiments, and that the invention is thus not limited to the exemplary details provided. As one non-exclusive example, while floor plans may be generated for houses that do not include detailed measurements for particular rooms or for the overall houses, it will be appreciated that other types of floor plans or other mapping information may be similarly generated in other embodiments, including for buildings (or other structures or layouts) separate from houses (including to determine detailed measurements for particular rooms or for the overall buildings or for other structures or layouts), and/or for other types of environments in which different target images are captured in different areas of the environment to generate a map for some or all of that environment (*e.g.*, for roads, neighborhoods, cities, runways, etc.). As another non-exclusive example, while floor plans for houses or other buildings may be used for display to assist viewers in navigating the buildings, generated mapping information may be used in other manners in other embodiments. As yet another non-exclusive example, while some embodiments discuss obtaining and using data from one or more types of image acquisition devices (*e.g.*, a mobile computing device and/or a separate camera device), in other embodiments the one or more devices used may have other forms, such as to use a mobile device that acquires some or all of the additional data but does not provide its own computing capabilities (*e.g.*, an additional 'non-computing' mobile device), multiple separate mobile devices that each acquire some of the additional data (whether mobile computing devices and/or non-computing mobile devices), etc. In addition, the term "building" refers herein to any partially or fully enclosed structure, typically but not necessarily encompassing one or more rooms that visually or otherwise divide the interior space of the structure, and in some situations including one or more adjacent or otherwise associated external areas and/or external accessory structures - nonlimiting examples of such buildings include houses, apartment buildings or individual apartments therein, condominiums, office buildings, commercial buildings or other wholesale and retail structures (*e.g.,* shopping malls, department stores, warehouses, etc.), etc. The term "acquire" or "capture" as used herein with reference to a building interior, acquisition location, or other location (unless context clearly indicates otherwise) may refer to any recording, storage, or logging of media, sensor data, and/or other information related to spatial and/or visual characteristics and/or otherwise perceivable characteristics of the building interior or other location or subsets thereof, such as by a recording device or by another device that receives information from the recording device. As used herein, the term "panorama image" may refer to a visual representation that is based on, includes or is separable into multiple discrete component images originating from a substantially similar physical location in different directions and that depicts a larger field of view than any of the discrete component images depict individually, including images with a sufficiently wide-angle view from a physical location to include angles beyond that perceivable from a person's gaze in a single direction (*e.g.,* greater than 120° or 150° or 180°, etc.). The term "sequence" of acquisition locations, as used herein, refers generally to two or more acquisition locations that are each visited at least once in a corresponding order, whether or not other non-acquisition locations are visited between them, and whether or not the visits to the acquisition locations occur during a single continuous period of time or at multiple different times, or by a single user and/or device or by multiple different users and/or devices. In addition, various details are provided in the drawings and text for exemplary purposes, but are not intended to limit the scope of the invention. For example, sizes and relative positions of elements in the drawings are not necessarily drawn to scale, with some details omitted and/or provided with greater prominence (*e.g.,* via size and positioning) to enhance legibility and/or clarity. Furthermore, identical reference numbers may be used in the drawings to identify similar elements or acts.

Figure 1A is an example block diagram of various devices and systems that may participate in the described techniques in some embodiments. In particular, target panorama images 165 are indicated in Figure 1A that have been captured by one or more mobile computing devices 185 with imaging systems and/or by one or more separate camera devices 184 (*e.g.*, without onboard computing capabilities), such as with respect to one or more buildings or other structures and under control of an Interior Capture and Analysis ("ICA") system 160 executing in this example on one or more server computing systems 180 - Figure 1B shows one example of such panorama image acquisition locations 210 for a particular example house 198, as discussed further below, and additional details related to the automated operation of the ICA system are included elsewhere herein. In at least some embodiments, at least some of the ICA system may execute in part on mobile computing device 185 (*e.g.*, as part of ICA application 154, whether in addition to or instead of ICA system 160 on the one or more server computing systems 180) to control acquisition of target images and optionally additional non-visual data by that mobile computing device and/or by one or more nearby (*e.g.*, in the same room) optional separate camera devices 184 operating in conjunction with that mobile computing device, as discussed further with respect to Figure 1B.

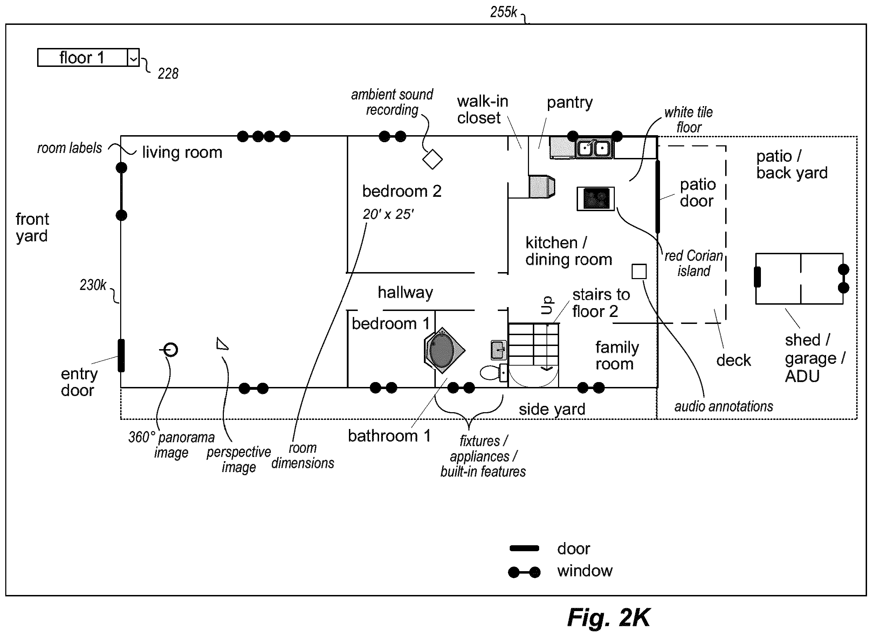

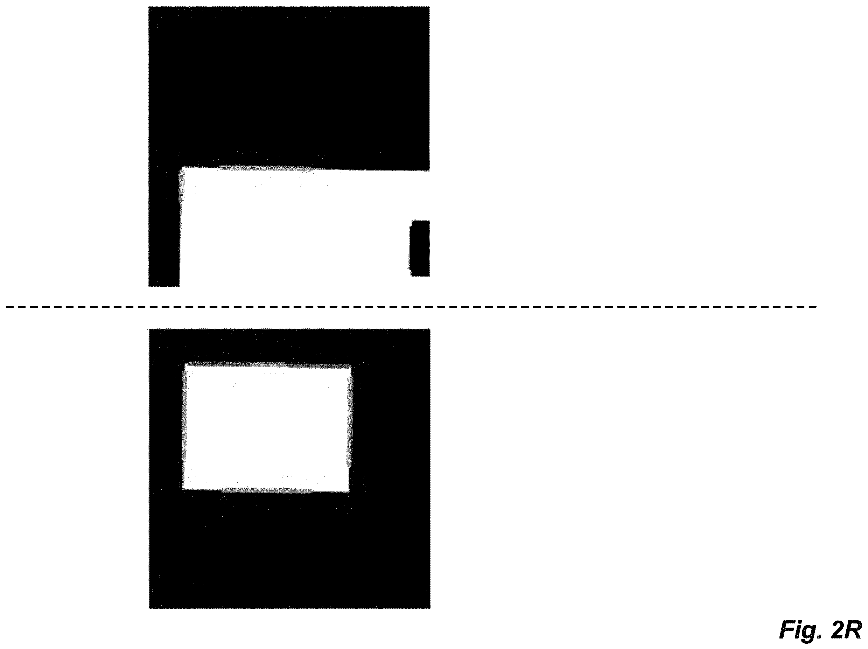

Figure 1A further illustrates an MIGM (Mapping Information Generation Manager) system 140 that is executing on one or more server computing systems 180 to analyze visual data of acquired target images (*e.g.*, panorama images 165) acquired in each of some or all building rooms or other building areas, and to use results of the analysis to further generate and provide building floor plans 145 and/or other mapping-related information (*e.g.*, linked panorama images, 3D models, etc.) based on use of the target images and optionally associated metadata about their acquisition and linking - Figures 2K-2L show non-exclusive examples of such floor plans, as discussed further below, and additional details related to the automated operations of the MIGM system are included elsewhere herein. In some embodiments, the ICA system 160 and/or MIGM system 140 may execute on the same server computing system(s), such as if multiple or all of those systems are operated by a single entity or are otherwise executed in coordination with each other (*e.g.,* with some or all functionality of those systems integrated together into a larger system), while in other embodiments the MIGM system may instead operate separately from the ICA system (*e.g.,* without interacting with the ICXA system), such as to obtain target images and/or optionally other information (*e.g.,* other additional images, etc.) from one or more external sources and optionally store them locally (not shown) with the MIGM system for further analysis and use.

In at least some embodiments and situations, one or more system operator users (not shown) of MIGM client computing devices 105 may optionally further interact over the network(s) 170 with the MIGM system 140, such as to assist with some of the automated operations of the MIGM system and/or for subsequently using information determined and generated by the MIGM system in one or more further automated manners. One or more other end users (not shown) of one or more other client computing devices 175 may further interact over one or more computer networks 170 with the MIGM system 140 and optionally the ICA system 160, such as to obtain and use generated floor plans and/or other generated mapping information, and/or to optionally interact with such a generated floor plan and/or other generated mapping information, and/or to obtain and optionally interact with additional information such as one or more associated target images (*e.g.,* to change between a floor plan view and a view of a particular target image at an acquisition location within or near the floor plan; to change the horizontal and/or vertical viewing direction from which a corresponding subset of a panorama image is displayed, such as to determine a portion of a panorama image to which a current user viewing direction is directed, etc.). In addition, while not illustrated in Figures 1A-1B, a floor plan (or portion of it) may be linked to or

EP 4 174 772 B1

otherwise associated with one or more other types of information, including for a floor plan of a multi-story or otherwise multi-level building to have multiple associated sub-floor plans for different stories or levels that are interlinked (*e.g.,* via connecting stairway passages), for a two-dimensional ("2D") floor plan of a building to be linked to or otherwise associated with a three-dimensional ("3D") model floor plan of the building, etc. - in other embodiments, a floor plan of a multi-story or multi-level building may instead include information for all of the stories

or other levels together and/or may display such information for all of the stories or other levels simultaneously. In addition, while not illustrated in Figure 1A, in some embodiments the client computing devices 175 (or other devices, not shown) may receive and use generated floor plan information and/or other related information in additional manners, such as to control or assist automated navigation activities by those devices (*e.g.,* by autonomous vehicles or other devices), whether instead of or in addition to display of the generated information.

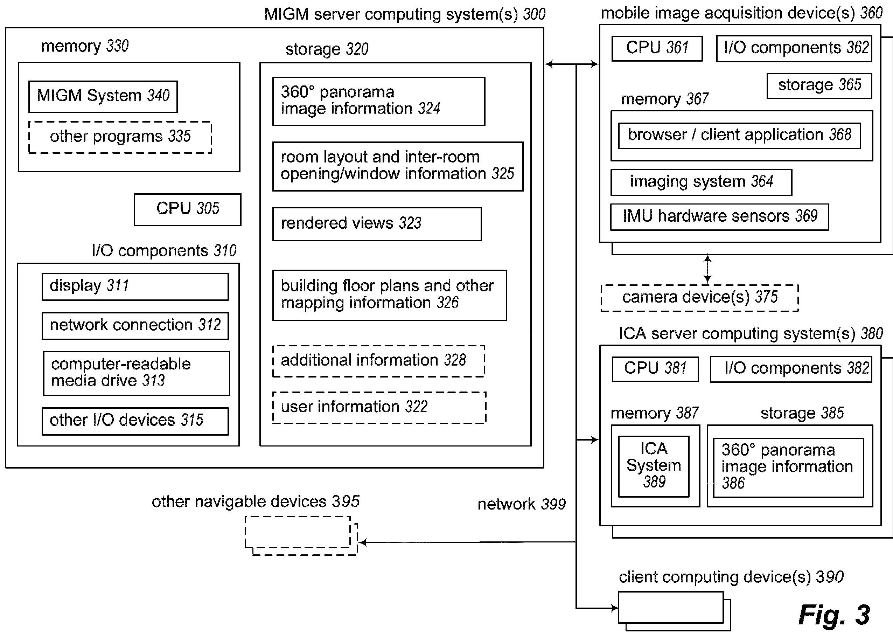

In the computing environment of Figure 1A, the network 170 may be one or more publicly accessible linked networks, possibly operated by various distinct parties, such as the Internet. In other implementations, the network 170 may have other forms. For example, the network 170 may instead be a private network, such as a corporate or university network that is wholly or partially inaccessible to nonprivileged users. In still other implementations, the network 170 may include both private and public networks, with one or more of the private networks having access to and/or from one or more of the public networks. Furthermore, the network 170 may include various types of wired and/or wireless networks in various situations. In addition, the client computing devices 105 and 175 and server computing systems 180 may include various hardware components and stored information, as discussed in greater detail below with respect to Figure 3.

In the example of Figure 1A, ICA system 160 may perform automated operations involved in generating multiple target panorama images (*e.g.*, each a 360 degree panorama around a vertical axis) at multiple associated acquisition locations (*e.g.*, in multiple rooms or other areas within a building or other structure and optionally around some or all of the exterior of the building or other structure), such as for use in generating and providing a representation of the building (including its interior) or other structure. In some embodiments, further automated operations of the ICA system may further include analyzing information to determine relative positions/directions between each of two or more acquisition locations, creating inter-panorama positional/directional links in the panoramas to each of one or more other panoramas based on such determined positions/directions, and then providing information to display or otherwise present multiple linked panorama images for the various acquisition locations within the building, while in other embodiments some or all such further automated operations may instead be performed by the MIGM system.

Figure 1B depicts a block diagram of an exemplary building environment in which panorama images may be captured, linked and used to generate and provide a corresponding building floor plan, as well as for use in presenting the panorama images to users. In particular, Figure 1B includes a building 198 with an interior that was captured at least in part via multiple target panorama images, such as by a user (not shown) carrying one or more mobile computing devices 185 with image acquisition capabilities and/or one or more separate camera devices 184 through the building interior to a sequence of multiple acquisition locations 210 to capture the target images and optionally additional non-visual data for the multiple acquisition locations 210. An embodiment of the ICA system (*e.g.*, ICA system 160 on server computing system(s) 180; a copy of some or all of the ICA system executing on the user's mobile device, such as ICA application system 154 executing in memory 152 on device 185; etc.) may automatically perform or assist in the capturing of the data representing the building interior. The mobile computing device 185 of the user may include various hardware components, such as a camera or other imaging system 135, one or more sensors 148 (*e.g.*, a gyroscope 148a, an accelerometer 148b, a compass 148c, etc., such as part of one or more IMUs, or inertial measurement units, of the mobile device; an altimeter; light detector; etc.), one or more hardware processors 132, memory 152, a display 142, optionally a GPS receiver, and optionally other components that are not shown (*e.g.*, additional non-volatile storage; transmission capabilities to interact with other devices over the network(s) 170 and/or via direct device-to-device communication, such as with an associated camera device 184 or a remote server computing system 180; one or more external lights; a microphone, etc.) - however, in some embodiments, the mobile device may not have access to or use hardware equipment to measure the depth of objects in the building relative to a location of the mobile device (such that relationships between different panorama images and their acquisition locations may be determined in part or in whole based on analysis of the visual data of the images, and optionally in some such embodiments by further using information from other of the listed hardware components (*e.g.*, IMU sensors 148), but without using any data from

any such depth sensors), while in other embodiments the mobile device may have one or more distance-measuring sensors or other depth-sensing sensors/devices 136 (*e.g.*, using lidar or other laser rangefinding techniques, structured light, synthetic aperture radar or other types of radar, etc.) used to measure depth to surrounding walls and other surrounding objects that may be supplied to a trained machine learning model (*e.g.*, as part of a convolutional neural network or other type of neural network, as part of a vision image transformer network, etc.) to determine and/or validate local alignment information for a pair of panorama images (*e.g.*, in combination with one or more views rendered from the panorama images and/or with one or more potential relative alignments determined between the two panorama images, such as based on matching one or more structural elements in both panorama images that may be the same structural element(s) and/or by using determined pose information for the two panorama images relative to structural layout

9

information that may correspond to the same room or other building area; instead of one or more views rendered from the panorama images and/or one or more potential relative alignments determined between the two panorama images; etc.). In addition, 2D and/or 3D structural layout data for at least some of a room (*e.g.*, a 3D point cloud, a 3D mesh, etc.) may be generated using depth data from one or more depth-sensing devices and used in various manners, such as in rendered views by combining that 3D structural layout data with one or more of the following: pixel data from one or more images; object data (*e.g.*, for structural elements of the room, such as one or more of windows, doorways, non-doorway wall openings, walls, floors, ceilings, wall-to-wall borders, wall-to-floor borders, wall-to-ceiling borders, etc., optionally identified and associated with corresponding semantic labels or other semantic information; furniture and other room contents, optionally identified and associated with corresponding semantic labels or other semantic information; etc.), such as from analysis of one or more images (*e.g.*, using segmentation masks to identify pixels corresponding to objects, generating 2D and/or 3D models of objects, identifying particular object types, etc.); estimated depth data from analysis of visual data of one or more images (*e.g.*, using monocular depth estimation); etc. While not illustrated for the sake of brevity, the one or more camera devices 184 may similarly each include at least one or more

image sensors and storage on which to store acquired target images and transmission capabilities to transmit the captured target images to other devices (*e.g.,* an associated mobile computing device 185, a remote server computing system 180, etc.), optionally along with one or more lenses and lights and other physical components (*e.g.,* some or all of the other components shown for the mobile computing device). While directional indicator 109 is provided for viewer reference, the mobile device and/or ICA system may not use absolute directional information in at least some embodiments, such as to instead determine relative directions and distances between panorama images' acquisition locations 210 without use of actual geographical positions/directions.

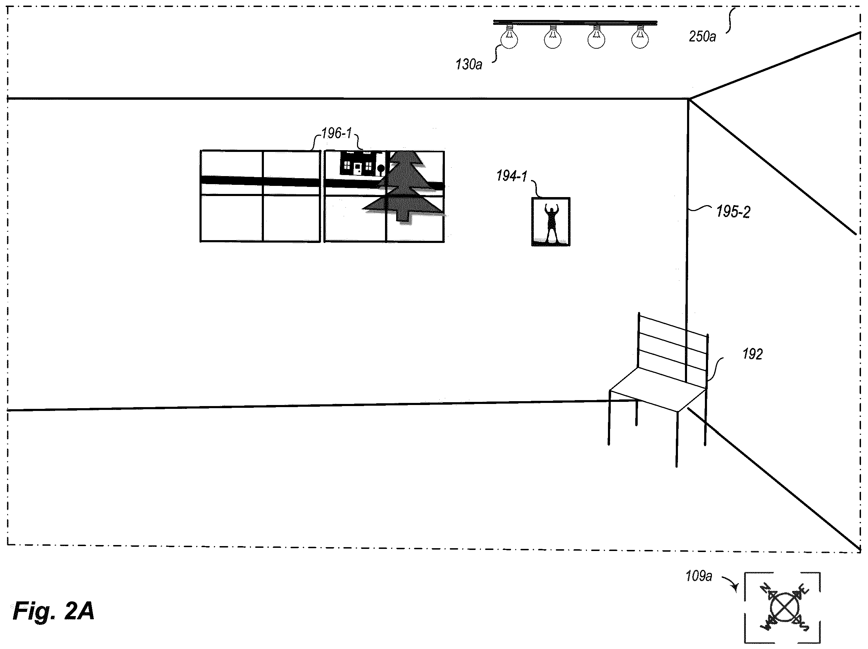

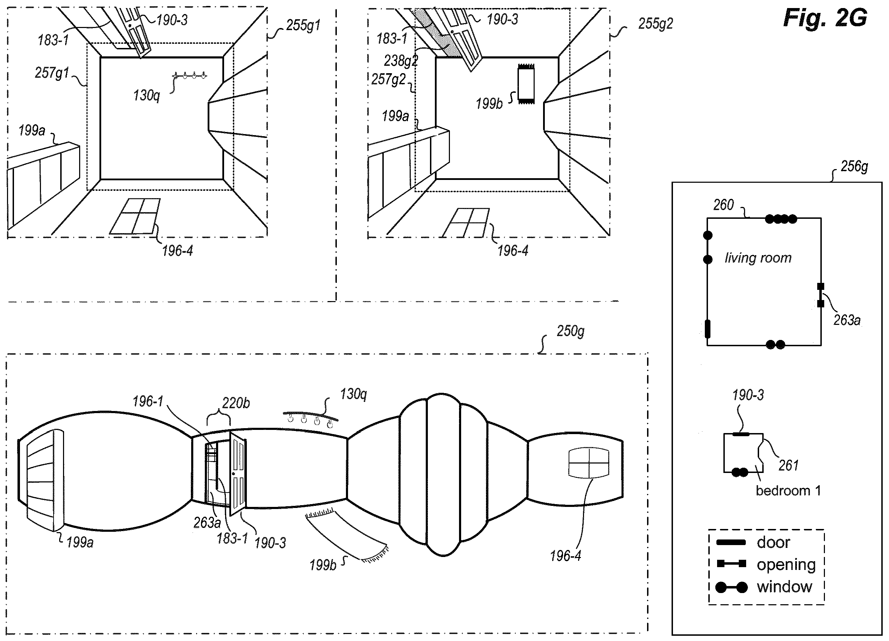

In operation, the mobile computing device 185 and/or camera device 184 (hereinafter for the example of Figure 1B, "one or more image acquisition devices") arrive at a first acquisition location within a first room of the building interior (*e.g.*, the living room, such as after entering the building from an external doorway 190-1), and captures visual data for a portion of the building interior that is visible from that acquisition location (*e.g.*, some or all of the first room, and optionally small portions of one or more other adjacent or nearby rooms, such as through doors, halls, stairs or other connecting passages from the first room) - in this example embodiment, a first image may be captured at acquisition location 210B (as discussed further with respect to example images shown in Figures 2A-2D) before proceeding to capture a second image at acquisition location 210D (as discussed further with respect to an example image shown in Figure 2G), but in other embodiments other image(s) may also be captured at one or both of acquisition locations 210A and 210C. In at least some situations, the one or more image acquisition devices may be carried by or otherwise accompanied by one or more users, while in other embodiments and situations may be mounted on or carried by one or more self-powered devices that move through the building under their own power. In addition, the capture of the visual data from an acquisition location may be performed in various manners in various embodiments (*e.g.*, by using one or more lenses that capture all of the image data simultaneously, by an associated user turning his or her body in a circle while holding the one or more image acquisition devices stationary relative to the user's body, by an automated device on which the one or more image acquisition devices are mounted or carried

rotating the one or more image acquisition devices, etc.), and may include recording a video at the acquisition location and/or taking a succession of one or more images at the acquisition location, including to capture visual information depicting a number of objects or other elements (*e.g.,* structural details) that may be visible in images (*e.g.,* video frames) captured from or near the acquisition location. In the example of Figure 1B, such objects or other elements include various elements that are structurally part of the walls (or "wall elements"), such as the doorways 190 and 197 and their doors (*e.g.,* with swinging and/or sliding doors), windows 196, inter-wall borders (*e.g.,* corners or edges) 195 (including corner 195-1 in the northwest corner of the building 198, corner 195-2 in the northeast corner of the first room, corner 195-3 in the southwest corner of the building 198, and corner 195-4 in the southeast corner of the first room), other corners 183 (*e.g.,* corner 183-1 at the northern side of the wall opening between the living room and the hallway to the east), etc. - in addition, such objects or other elements in the example of Figure 1B may further include other elements within the rooms, such as furniture 191-193 (*e.g.,* a couch 191; chair 192; table 193; etc.), pictures or paintings or televisions or other objects 194 (such as 194-1 and 194-2) hung on walls, light fixtures, etc. The one or more image acquisition devices may optionally further capture additional data (*e.g.,* additional visual data using imaging system 135, additional motion data using sensor modules 148, optionally additional depth data using distance-measuring sensors 136, etc.) at or near the acquisition location, optionally while being rotated, as well as to further optionally capture further such additional data while the one or more image acquisition devices move to and/or from acquisition locations. Actions of the image acquisition device(s) may in some embodiments be controlled or facilitated via use of program(s) executing on the mobile computing device 185 (*e.g.,* via automated instructions to image acquisition device(s) or to another mobile device, not shown, that is carrying those devices through the building under its own power; via instructions to an associated user in the room; etc.), such as ICA application system 154 and/or optional browser 162, control system 147 to manage I/O (input/output) and/or communications and/or networking for the device 185 (*e.g.,* to receive instructions from and present information to its user), etc. The user may also optionally provide a textual or auditory identifier to be

associated with an acquisition location, such as "entry" for acquisition location 210A or "living room" for acquisition location 210B, while in other embodiments the ICA system may automatically generate such identifiers (*e.g.,* by automatically analyzing video and/or other recorded information for a building to perform a corresponding automated determination, such as by using machine learning) or the identifiers may not be used.

After visual data and optionally other information for the first acquisition location has been captured, the image acquisition device(s) (and user, if present) may optionally proceed to a next acquisition location (*e.g.,* from acquisition location 210B to acquisition location 210D, from acquisition location 210B to acquisition location 210C, from acquisition location 210A to acquisition location 210B, etc.), optionally recording movement data during movement between the acquisition locations, such as video and/or other data from the hardware components (*e.g.,* from one or more IMU sensors 148, from the imaging system 135, from the distance-measuring sensors 136, etc.). At the next acquisition location, the one or more image acquisition devices may similarly capture one or more images from that acquisition location, and optionally additional data at or near that acquisition location. The process may repeat for some or all rooms of the building and optionally outside the building, as illustrated for acquisition locations 210A-210P, including in this example to capture target panorama image(s) on an external deck or patio or balcony area 186, to capture target panorama image(s) on a larger external back yard or patio area 187, to capture target panorama image(s) on a separate side yard area 188, to capture target panorama image(s) near or in an external additional accessory structure area 189 (*e.g.,* a garage, shed, accessory dwelling unit, greenhouse, gazebo, car port, etc.) that may have one or more rooms, to capture target panorama image(s) in a front yard outside the external doorway 190-1, etc. Acquired video and/or other images for each acquisition location are further analyzed to generate a target panorama image for each of some or all of acquisition locations 210A-210P, including in some embodiments to stitch together multiple constituent images from an acquisition location to create a target panorama image for that acquisition location and/or to otherwise combine visual data in different images (*e.g.,* objects and other elements, latent space features, etc.).

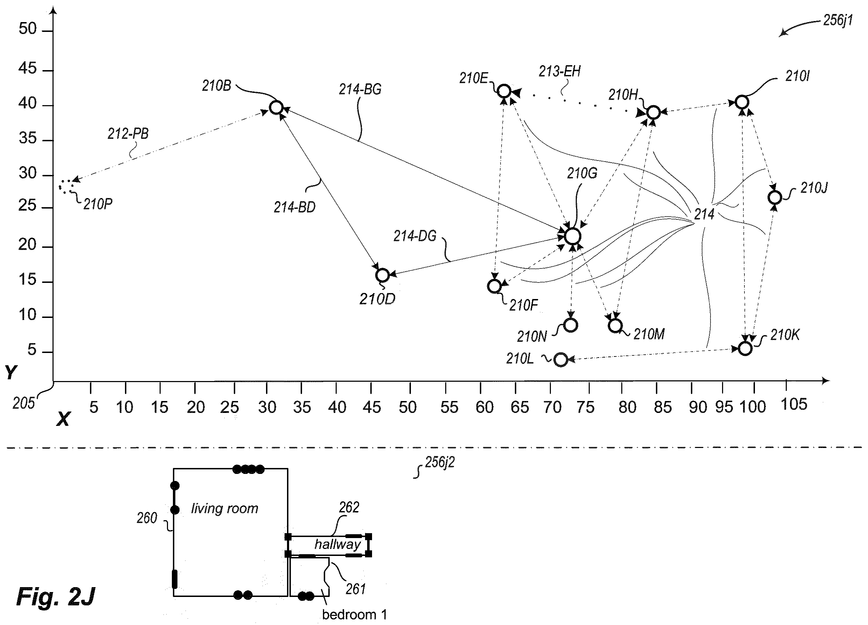

In addition to generating such target panorama images, further analysis may be performed in at least some embodiments by the MIGM system (*e.g.,* concurrently with the image capture activities or subsequent to the image capture) to determine layouts (*e.g.,* room shapes and optionally locations of identified structural elements and other objects) for each of the rooms (and optionally for other defined areas, such as a deck or other patio outside of the building or other external defined area), including to optionally determine acquisition position information for each target image, and to further determine a floor plan for the building and any associated surrounding area (*e.g.,* a lot or parcel on which the building is situated) and/or other related mapping information for the building (*e.g.,* a 3D model of the building and any associated surrounding area, an interconnected group of linked target panorama images, etc.). If 'dense' panorama images had instead been acquired, such as for each of the acquisition locations 210A-210C, the overlapping features visible in those panorama images may be used in some situations to 'link' at least those panorama images and their acquisition locations together (with some corresponding directional lines 215 between example acquisition locations 210A-210C being shown for the sake of illustration), such as using SfM and/or SLAM techniques. However, in situations without such dense panorama images (*e.g.,* if images are not acquired at acquisition locations 210A or 210C, such as discussed further with respect to the examples of 2A-2S), a copy of the MIGM system may instead determine estimated relative positional information between pairs of acquisition locations using associated acquired images that have little or no visual overlap (*e.g.,* with visual data of small or no common areas that are visible in both such acquired images) using only visual data (*e.g.,* only RGB data) of such acquired images - Figure 2J illustrates additional details about corresponding inter-image links that may be determined and used by the MIGM system, including in some embodiments and situations to further link at least some acquisition locations whose associated target images have no visual overlap with any other target image and/or to use other determined alignments to link two acquisition locations whose images do not include any overlapping visual coverage.

Various details are provided with respect to Figures 1A-1B, but it will be appreciated that the provided details are non-exclusive examples included for
illustrative purposes, and other embodiments may be performed in other manners without some or all such details.

Figures 2A-2S illustrate examples of automated operations for analyzing visual data of images captured in multiple rooms of a building to generate a floor plan for the building based at least in part on using visual data of the images to align pairs of images that have little or no overlapping visual coverage, and for generating and presenting information about the floor plan for the building, such as based on target images captured within the building 198 of Figure 1B.

In particular, Figure 2A illustrates an example image 250a, such as a nonpanorama perspective image captured by one or more image acquisition devices in a northeasterly direction from acquisition location 210B in the living room of house 198 of Figure 1B (or a northeasterly facing subset formatted in a rectilinear manner of a 360-degree panorama image taken from that acquisition location) - the directional indicator 109a is further displayed in this example to illustrate the northeasterly direction in which the image is taken. In the illustrated example, the displayed image includes several visible elements (*e.g.,* light fixture 130a), furniture (*e.g.,* chair 192), two windows 196-1, and a picture 194-1 hanging on the north wall of the living room. No passages into or out of the living room (*e.g.,* doorways or other wall openings) are visible in this image. However, multiple room borders are visible in the image 250a, including horizontal borders between a visible portion of the north wall of the living room and the living room's ceiling and floor, horizontal borders between a visible portion of the east wall of the living room and the living room's ceiling and floor, and the inter-wall vertical border 195-2 between the north and east walls.

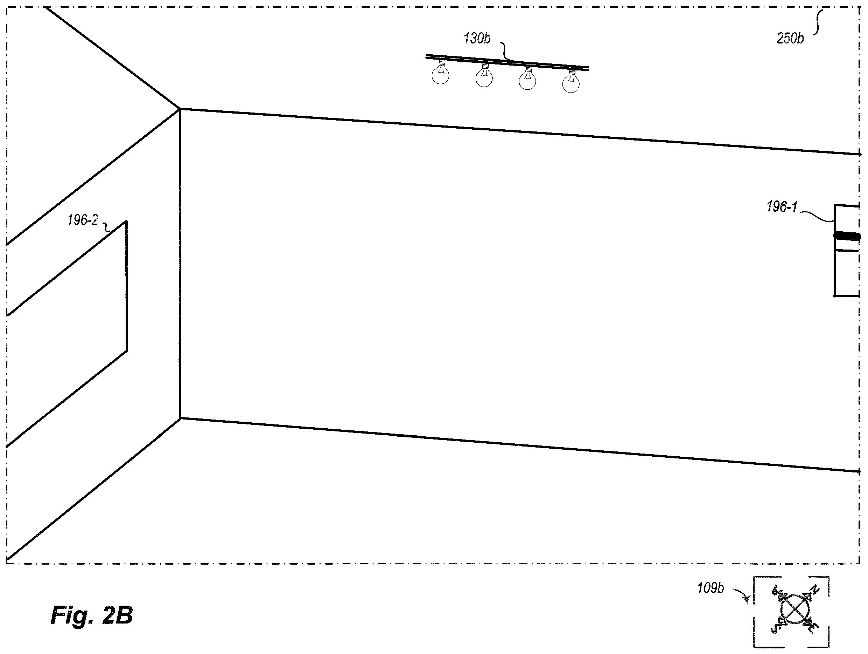

Figure 2B continues the example of Figure 2A, and illustrates an additional perspective image 250b captured by the one or more image acquisition devices in a northwesterly direction from acquisition location 210B in the living room of house 198 of Figure 1B (or a northwesterly facing subset formatted in a rectilinear manner of a 360-degree panorama image taken from that acquisition location) - directional indicator 109b is also displayed to illustrate a northwesterly direction in which the image is taken. In this example image, a small portion of one of the windows 196-1 continues to be visible, along with a portion of window 196-2 and a new lighting fixture 130b. In addition, horizontal and vertical room borders are visible in image 250b in a manner similar to that of Figure 2A.

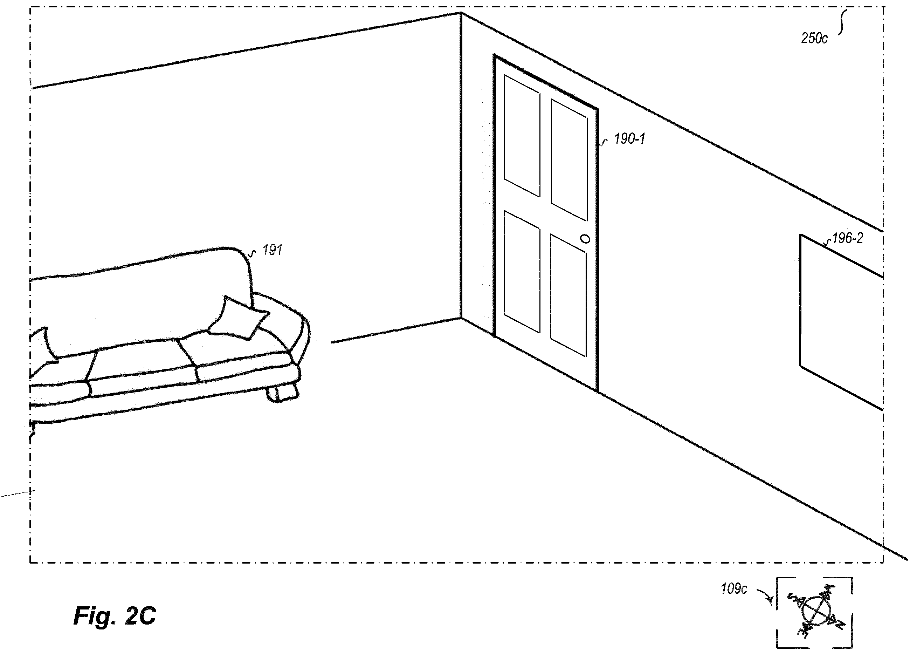

Figure 2C continues the examples of Figures 2A-2B, and illustrates a third perspective image 250c captured by the one or more image acquisition devices in a southwesterly direction in the living room of house 198 of Figure 1B from acquisition location 210B (or a southwesterly facing subset formatted in a rectilinear manner of a 360-degree panorama image taken from that acquisition location) - directional indicator 109c is also displayed to illustrate a southwesterly direction in which the image is taken. In this example image, a portion of window 196-2 continues to be visible, as is a couch 191 and visual horizontal and vertical room borders in a manner similar to that of Figures 2A and 2B. This example image further illustrates a wall opening passage into/out of the living room, which in this example is doorway 190-1 to enter and leave the living room (which is a door to the house exterior and a front yard, as shown in Figure 1B). It will be appreciated various other perspective images may be captured from acquisition location 210B and/or other acquisition locations.

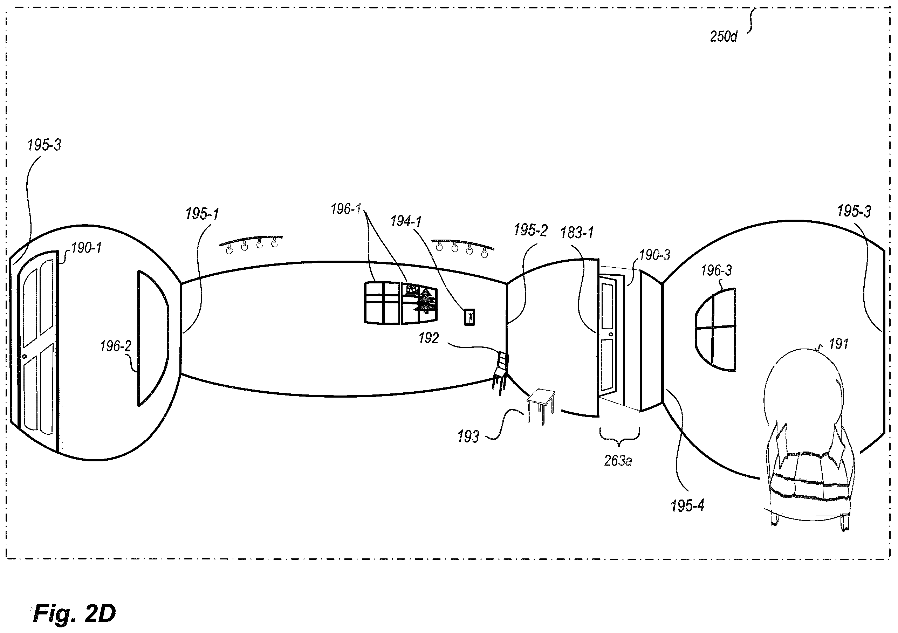

Figure 2D continues the examples of Figures 2A-2C, and illustrates further information 250d for a portion of the house 198 of Figure 1B, including the living room and limited portions of the hallway and a bedroom to the east of the living room (including doorway 190-3 between the hallway and the living room, visible through wall opening 263a between the living room and hallway, as well as structural wall elements of the living room that include the inter-wall border 183-1 and windows 196-1) - in particular, the information 250d illustrates a 360° target panorama image acquired at acquisition location 210B, with the entire panorama image displayed using an equirectangular projection format. As discussed with respect to Figures 1B and 2A-2C, in some embodiments, target panorama images may be captured at various locations in the house interior, such as at location 210B in the living room, with corresponding visual contents of example target panorama image 250d subsequently used to determine a layout of at least the living room. In addition, in at least some embodiments, additional images may be captured, such as if the one or more image acquisition devices (not shown) are capturing video or one or more other sequences of continuous or near-continuous images as they move through the interior of the house.

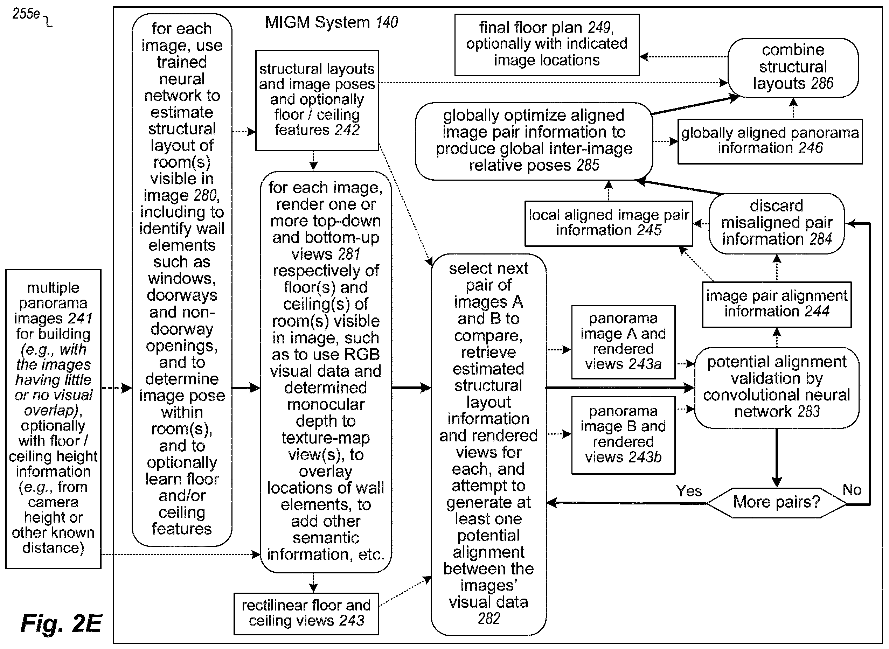

Figure 2E continues the examples of Figures 2A-2D, with Figure 2E illustrating further information 255e that shows an example high-level overview of a flow of information processing during automated operations of the MIGM system in at least some embodiments. In particular, in the example of Figure 2E, multiple panorama images 241 are first acquired for a building, such as to correspond to acquisition locations 210B and 210D-210P illustrated in Figure 1B - some or all of the panorama images may, for example, be generated by an embodiment of the ICA system, or may instead be provided to the illustrated MIGM system 140 from one or more other sources.

In this example, after the multiple panorama images 241 are provided to the MIGM system, they are each analyzed in step 280 to determine structural layout information for the room(s) or other area(a) visible in the image, such as by providing each image as input to a corresponding trained layout determination machine learning model. In this example, the processing of step 280 includes identifying structural wall elements in each image and determining image pose information for each image within its determined structural layout. In addition, in some embodiments, the machine learning model (*e.g.,* part of a neural network) may further learn to identify particular floor and/or ceiling features of use, and if so may further identify any such floor or ceiling features that are visible in each image along with their location. The output of the step 280 includes the generated structural layout information 242, which, after step 280 is completed, is further provided as input to step 281 along with the multiple panorama images 241, although in other embodiments the steps 280 and 281 may be performed at least partially concurrently (such as for step 281 to begin the analysis of a first image that has already been analyzed in step 280, while step 280 concurrently performs its analysis for a second image). In this example embodiment, the operations of step 281 include, for each image, rendering one or more top-down and/or bottom-up views for the floor(s) and/or ceiling(s), respectively, that are visible in the image. As discussed in greater detail elsewhere herein, the rendered views may further use RGB visual data of the image in various manners, such as to estimate monocular depth information that is used to texture-map the pixels of one or some or all of the rendered views, to overlay indications of locations of wall elements and/or other semantic information on one or some or all of the rendered views, etc. The output of step 281 includes the rendered views 243.

After step 281 (or concurrently with step 281 once step 281 has analyzed at least two images), the operations of the MIGM system continue in step 282, which takes as input the rendered views 243 and structural layout information 242, selects the next pair of images (referred to as images A and B for the sake of reference), beginning with a first pair, and attempts to determine at least one potential alignment between the visual data of those images (*e.g.*, based on matching one or more structural elements visible in both images that may be the same structural element(s) and/or by using determined pose information for the two images relative to structural layout information that may correspond to the same room or other building area) - in at least some such embodiments, the order in which pairs of images are considered may be random. After step 282, the operations of the MIGM system continue in step 283, where the rendered views 243a for image A and rendered views 243b for image B (and optionally the original images A and B as well) are used to attempt to validate one of the determined potential alignments by using the visual data of the two images of the pair, generating corresponding output image pair alignment information 244. The automated operations then continue to determine if there are more pairs of images to compare (*e.g.*, until all pairs of images have been compared), and if so returns to step 282 to select a next pair of images to compare. Otherwise, the automated operations continue to step 284, where the image pair alignment information 244 for the various pairs of images is analyzed, and misaligned pair information is discarded (*e.g.*, so as to retain only the alignment information between pairs of images having an alignment score or other indication of alignment that is above a defined threshold). The output of step 284 includes locally aligned image pair information 245, which is then used as input in step 285, where the automated operations proceed to globally optimize the aligned image pair information, as discussed in greater detail elsewhere herein, in order to produce global inter-image relative pose information 246. In step 286, the automated operations then use the globally aligned panorama information 246 and the structural layout information 242 to generate a floor plan 249 for the building based on the visual data of the target images 241, optionally with indications on the floor plan of the acquisition locations of the target images and/or of some or all of the other information determined in block 280.

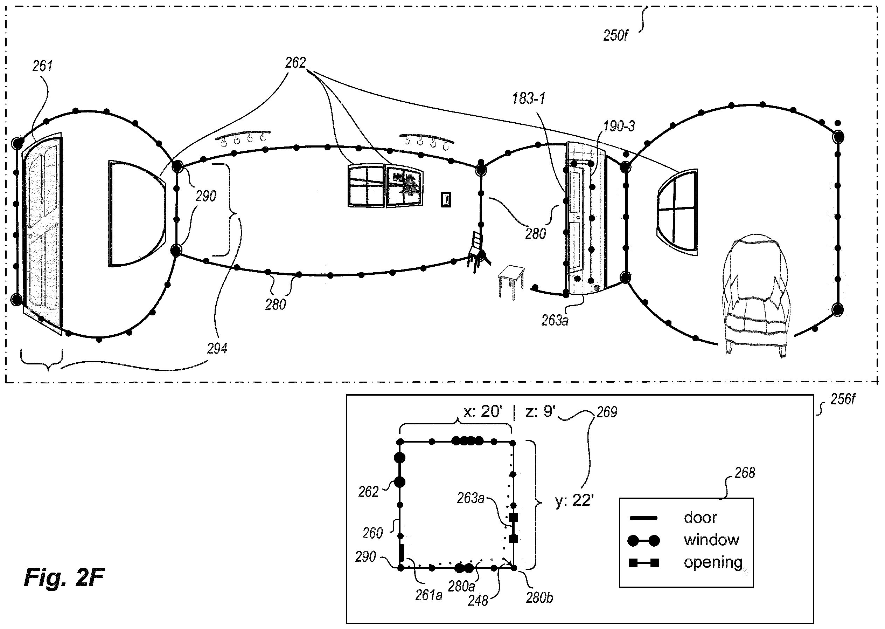

Figures 2F-2L further illustrate examples of the various operations 280-286 discussed with respect to Figure 2E. In particular, Figure 2F continues the examples of Figures 2A-2E, and again illustrates the 360° target panorama image 250d from Figure 2D of the living room, but with additional information added in the resulting target panorama image 250f of Figure 2F. In particular, Figure 2F illustrates an example of structural information that may be generated for target panorama image 250d in step 280 of Figure 2E, with the resulting structural layout information 242 of Figure 2E for target panorama image 250d able to be stored in various manners. In particular, in this example, the visual data of the target panorama image 250d is analyzed to identify layout information that includes borders 280 and corners 290 in resulting target panorama image 250f (including inter-wall border 183-1, and optionally some of the hallway that is visible through the non-doorway wall opening between the living room and the hallway), such as to correspond to a 3D shape of the room, with a resulting 2D layout 260 shown as part of information 256f. It will be appreciated that initial structural information that is determined for the room may not be exact in some situations (*e.g.*, not be completely rectangular, even if the corresponding room actually is), such as is illustrated with initial room shape variant 280a in information 256f (corresponding to the southeasterly corner of the living room being incorrectly located) - if so, adjustments 248 may be made to correct such imperfections, such as by further automated operations of the MIGM system (*e.g.*, to apply shape constraints and/or optimizations to the initial room shape, such as to enforce presumptions for factors such as straight walls and 90° corners so that adjacent walls are perpendicular and opposing walls are parallel). After any final adjustments have been made, the structural layout information for the living room is defined. in addition, while such structural layout determination activities are not illustrated for other rooms of the house 198, it will be appreciated that such further activities may be performed for all of the target images, corresponding to some or all rooms and other areas of the house.

In addition, the visual data of the target panorama image 250d is further analyzed in this example to identify layout information that includes locations of windows, doorways and non-doorway openings, including in this example to identify a bounding box 261 for doorway 190-1, bounding boxes 262 for the various windows 196-1 to 196-3, bounding box 263a for the wall opening between the living room and hallway, and a bounding box for doorway 190-3 visible through the wall opening between the living room and hallway, with locations of those structural elements further illustrated in information 256f (as well as in Figure 1B), along with a legend 268 provided for the sake of illustration. In some embodiments, additional automated operations may be performed to identify dimension information for the room, with visual dimension representations 294 being overlaid on the panorama image 250f to correspond to features of the room that have known or likely sizes, such as the width of a door (or window), the height of a wall (or door or window), etc., although it will be appreciated that other types of elements may be used for size information in other embodiments, including one or more objects of known size that are added to one or more images captured in one or more rooms (*e.g.*, a piece of 8½x11 inch paper laid on a floor of a room; a smart phone with a known pattern visible on its screen, such as a particular model of an iPhone smart phone; etc.), with additional automated operations involving identifying one or more aspects of the known-size object(s) (*e.g.*, a location and size of the diagonal of the paper; the pattern on the smart phone screen, along with a determination or other identification of the particular smart phone model in order to retrieve the size of the screen on which the pattern is displayed; etc.), whether in addition to or instead of identifying the location and size of other elements of the room that were not added for that purpose. In such embodiments, the determination of such dimension information may be further used to determine a camera height for the camera used to capture that image (and thus the camera height for all images if they all use the same camera height). Corresponding dimension information 269 is added in the information 256f, such as to specify overall dimensions of the living room.

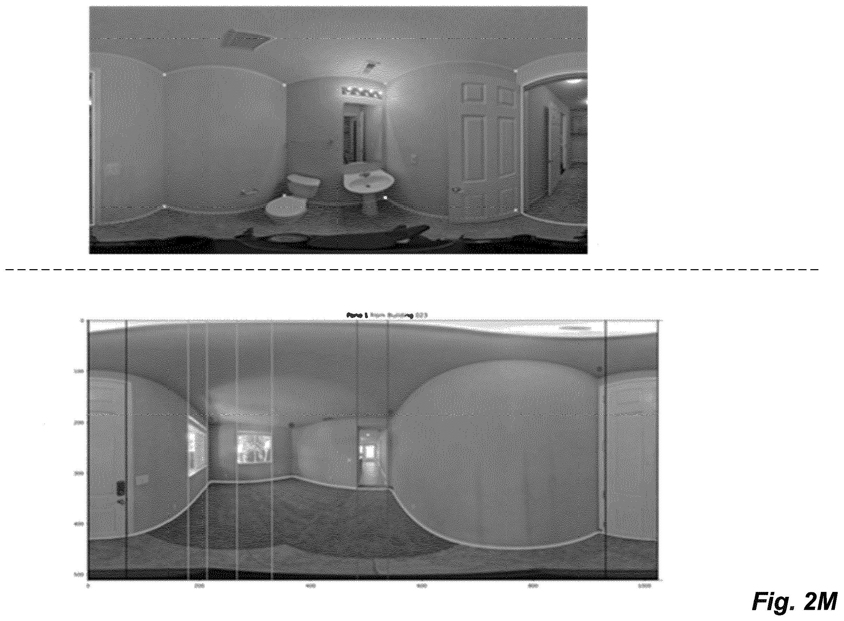

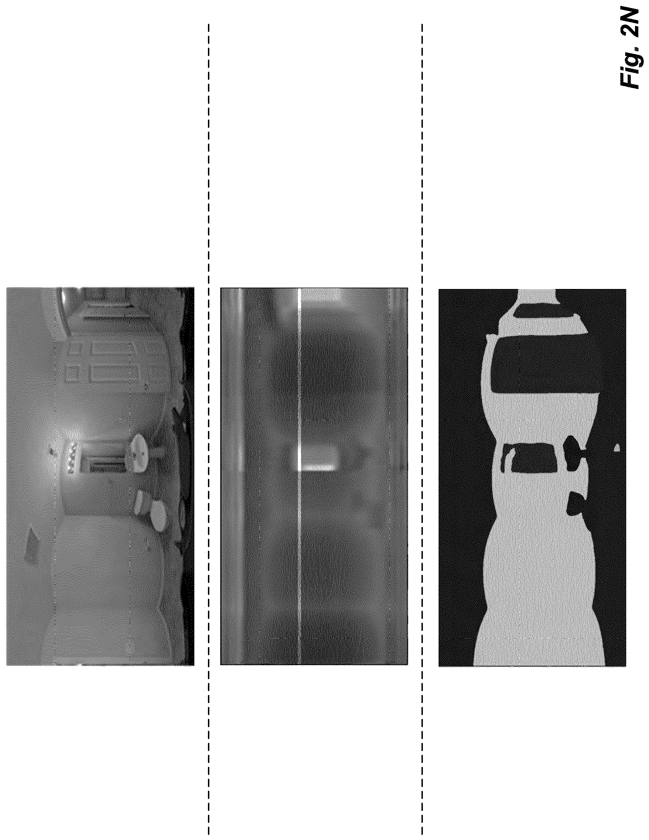

Figure 2M illustrates additional examples of identifying structural information in target panorama images, using actual photographs of real building interiors, using overlaid lines and dots of yellow, red, green and purple. For example, in some embodiments, hypothesized layout alignments are derived from automatically identified estimated semantic objects (or alternatively, from user-annotated semantic objects), such as windows, doorways, non-doorway wall openings, room corners, and wall boundaries - in such embodiments, a trained layout determination machine learning model (*e.g.,* as part of a convolutional neural network or other type of neural network, as part of a vision image transformer network, etc.) may be used that jointly estimates layout and positions of semantic objects (in other embodiments, user-annotated layouts and/or user annotated semantic object positions may be used). In addition, analysis of the visual RGB data may further be used to estimate depth data, with one non-exclusive example being the HoHoNet network, and such information may further be used as part of determining a 3D room shape based on monocular depth data estimated from the RGB data of the image, with one non-exclusive example being the HorizonNet network. In addition, a trained object detection machine learning model (*e.g.,* as part of a convolutional neural network or other type of neural network, as part of a vision image transformer network, etc.) may be used to determine bounding boxes, with one non-exclusive example being the Faster RCNN network. Figure 2N further illustrates examples of results of such processing, with a top image illustrating RGB texture, a middle image illustrating estimated monocular depth information, and a bottom image illustrating overlaid semantic information (*e.g.,* to identify the walls separate from the floor and ceiling, to identify the doorways separate from the walls and floor and ceiling, and to illustrate the toilet and sink separate from the others).

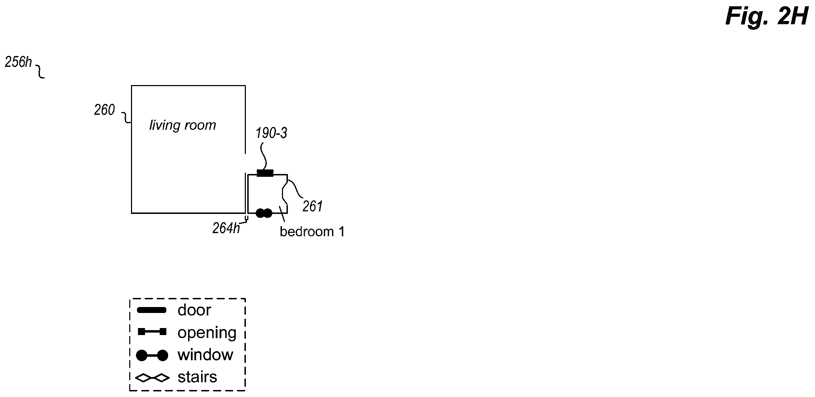

Figure 2G continues the examples of Figures 2A-2F, and illustrates an example of visual information that may be used to render floor and/or ceiling views in step 281 of Figure 2E for a target panorama image 250g that corresponds to the bedroom with doorway 190-3, with the resulting rendered view information 243 of Figure 2E for target panorama image 250g able to be stored in various manners. In particular, in the example of Figure 2G, the visual data of target panorama image 250g is used to render a bottom-up ceiling view perspective image 255g1 and a top-down floor view perspective image 255g2, including to use texturemapped pixel data to illustrate information from target panorama image 250g such as lights 130q, furniture 199a and rug 199b. While the example view images 255g1 and 255g2 include significant portions of the walls of the bedroom, the actual floor and ceiling views may use a more limited amount of wall data (or no wall data) in some embodiments, such as to correspond to smaller floor and ceiling view images 257g2 and 257g1, respectively (*e.g.,* two-dimensional view images that show only the locations of each of the walls in a one-dimensional manner). Information 256g is also illustrated to include structural layout information 261 for the bedroom (*e.g.,* as determined in step 280 of Figure 2E), along with the previously illustrated structural layout information 260 for the living room. Figure 2G further illustrates that only a very small amount of visual data may be present in common between target panorama images 250d and 250g, such as to correspond to a portion 220 of target panorama image 250g that is visible of the hallway and living room through the doorway 190-3, and with corresponding pixel data 238g2 illustrated in rendered views 255g2 and 257g2 - in this example, the overlapping visual data includes part of the inter-wall border 183-1, a small part of windows 196-1 and the north-facing wall below that part of the windows 196-1, a small amount of floor near the doorway 190-3 and continuing into the west end of the hallway and a slice of the living room, and the frame of doorway 190-3. One or more such structural elements that are visible in both target images 250d and 250g may be matched (*e.g.,* as potentially being the same structural element, optionally with an associated degree of likelihood and/or certainty) and then used to generate one or more potential alignments of those images' visual data (*e.g.,* by matching corresponding parts of the two target images for doorway 190-3 and/or inter-wall border 183-1 and/or the small visible part of windows 196-1 and/or the north-facing wall below that part of the windows 196-1 and/or some or all of the floor visible in both target images), as discussed further with respect to Figure 2H.

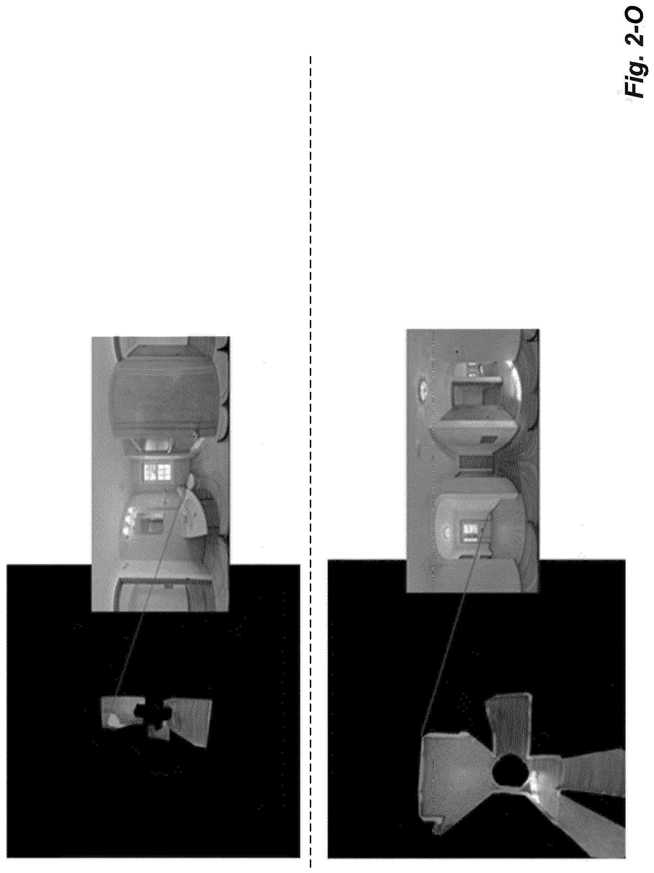

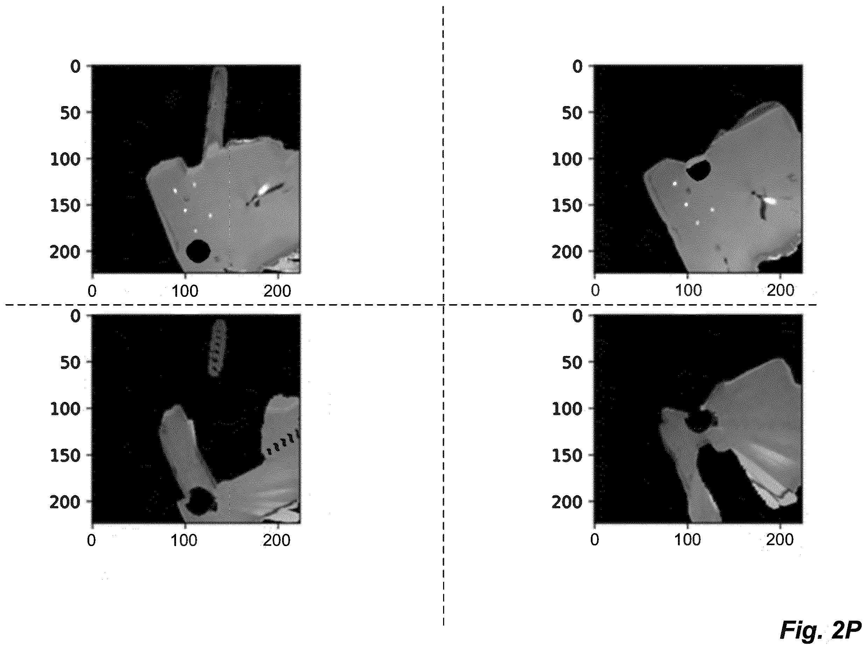

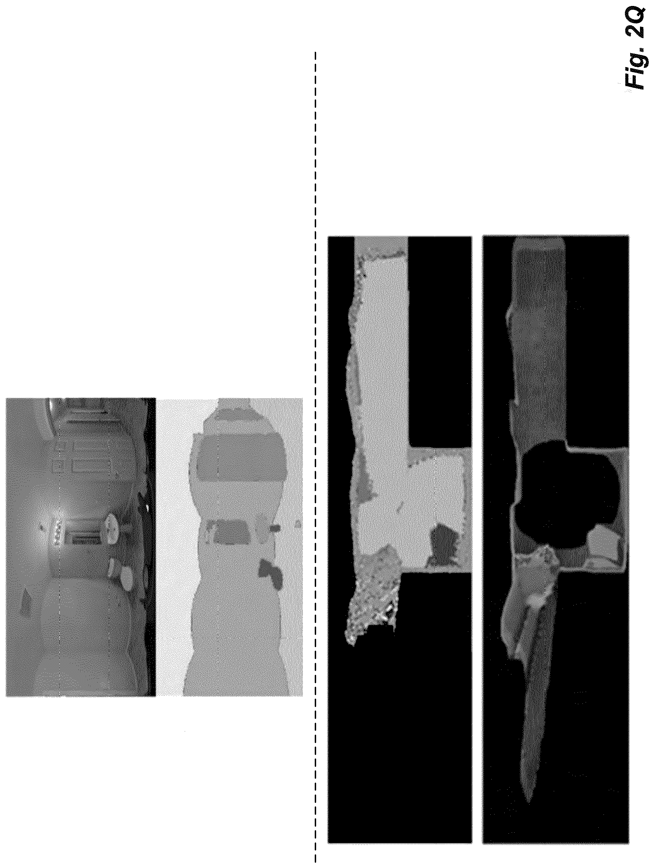

Figures 2O (referred to herein as '2-O' for clarity) through 2R illustrates additional examples of rendering floor views from target images, using actual photographs of real buildings. For example, Figure 2-O illustrates a texture map of rendered floor views shown on the left of example target panorama images shown on the right, using monocular-depth estimation to place RGB pixel values into a top-down view, with the top image and associated floor view showing texture mapped visual data that includes the toilet and tile floor and wood floor for a bathroom and hallway, and the bottom image and associated floor view showing textured mapped visual data that includes tile floor and wood floor for an entry way and hallway and part of an additional room - the overlapping portions of the hallway may be sufficient to align these target panorama images. In addition, Figure 2P illustrates an example of using automatically learned ceiling features, with the two left images showing a first set of associated floor and ceiling views, and the two right images showing a second set of associated floor and ceiling views, with the lights and/or fan of the two top ceiling views being identified and used to determine that the views are of the same ceiling in the two target panorama images (not shown) from which the views are rendered. Figure 2Q illustrates a version of the images of Figure 2N in the two top images, with a further example in the two bottom images of a floor view of the bathroom and hallway (in the bottommost image) and of further using the estimated monocular depth data to texture map the floor view with semantic information using color-coded semantic categories for the toilet, wall and floor, such as by a pretrained semantic segmentation network. Figure R further illustrates an example of overlaid color-coded semantic information on floor or ceiling views, such as with windows shown using red, doorways shown using green, and non-doorway wall openings shown using blue. In addition, in some embodiments, determination of alignment between the rendered views for a pair of two target panorama images may be treated as an image classification problem (where given an image, the category of the image subject is predicted, by predicting scores over a set of fixed classes) - the 2D view rendering may be treated as a binary classification problem, predicting whether RGB texture in a rendered view represents a correct rendering, with a corresponding machine learning model (*e.g.,* a model that is part of a convolutional neural network or other type of neural network, as part of a vision image transformer network, etc.) being trained with data with known true/false labels

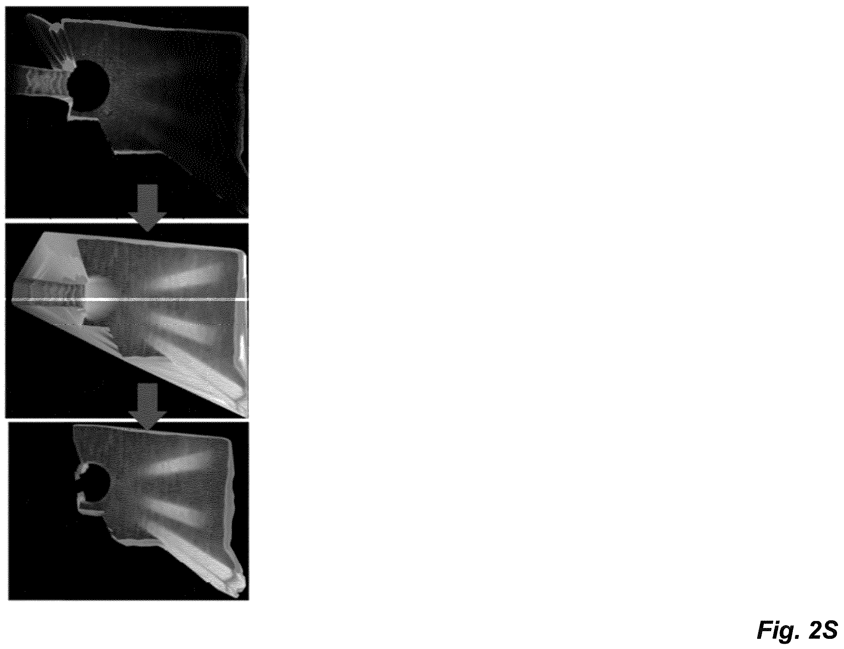

In addition, Figure 2S further illustrates information related to how floor and/or ceiling views may be generated, such as in situations in which a raw signal from the pixel values at all depth map locations is insufficient, and in which interpolation is used to generate a dense canvas from a sparse canvas shown in the top image. The middle image shows that such interpolation may also add unwanted and

undesirable interpolation artifacts. Accordingly, another step may be used to identify regions in which the signal was too sparse to interpolate accurately, in which case the view is convolved to be populated with sparse values with a box filter, as shown in the bottom image. As part of doing so, portions of an interpolated image where the signal is unreliable due to no measurements may be zeroed out, such that if a *KxK* sub-grid of an image has no sparse signals within it and is initialized to a default value of zero, then convolution of the subgrid with a box filter of all 1's will yield zero back. Thus, if the convolved output is zero in any *ij* cell, then there was no true support for interpolation in this region, and this interpolated value is masked out to zero, such as by multiplying the interpolated image with a binary unreliability mask to zero-out unreliable values.

Figure 2H continues the examples of Figures 2A-2G, and further illustrates information 256h that may result from pairwise alignment of the target panorama images 250d and 250g based on the shared doorway 190-3 and/or inter-wall border 183-1 and/or portions of window 196-1 and/or other small amount of overlapping visual data, such as corresponding to the potential alignment(s) determined in step 281 of Figure 2E and the subsequent potential alignment validation in step 283 of Figure 2E, and by using the resulting inter-image pose information along with the structural layout information for the living room and that bed room to fit that structural layout information together. In this example embodiment, it is illustrated that walls of the living room and bedroom may not be fitted together perfectly, such as to leave a gap 264h, such as a gap that may be incorrect and result from an initial imperfect pairwise alignment from the limited visual overlap between panorama images 250d and 250g (*e.g.,* to be later corrected during global optimization activities involving additional panorama images and their acquisition location), or a gap that is correct and reflects a width of the wall between the living room and bedroom (*i.e.,* the bedroom's western wall). While not illustrated in Figure 2H, in other embodiments a local alignment between two target images may be determined using types of information other than matching structural elements visible in both images, such as by using determined pose information for the two images relative to structural layout information for those two images (*e.g.,* structural layout information that may correspond to the same room or other building area), whether in addition to or instead of using information about such matching structural elements.

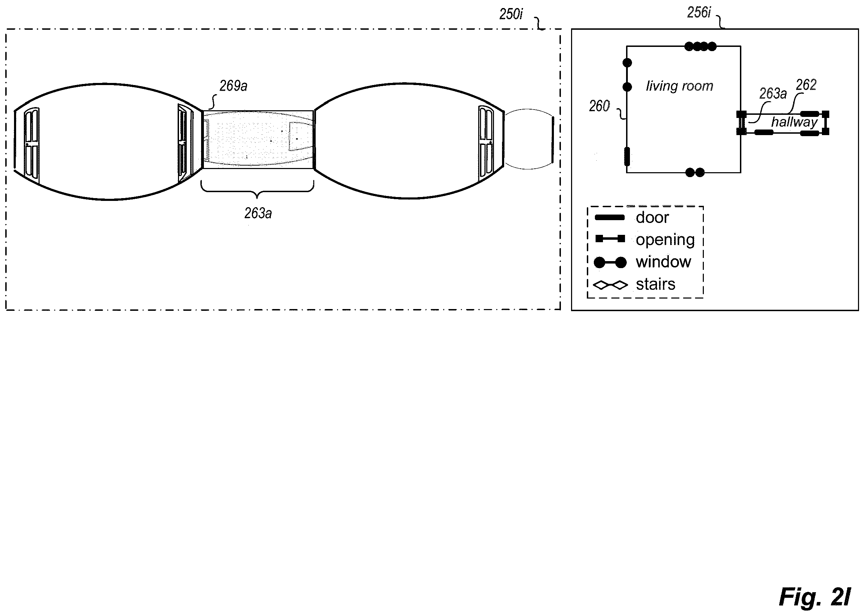

Figure 2I continues the examples of Figures 2A-2H, and further illustrates part of an additional target panorama image 250i captured from acquisition location 210G that may be pairwise aligned with target panorama image 250d in a manner analogous to that discussed with respect to Figures 2F-2H, and with resulting information 256i being illustrated that may result from aligning the inter-image pose of the target panorama images 250d and 250i, with the structural layout information 261 for the living room and 263 for the hallway being similarly fitted together based on the common information 269a visible through the wall opening 263a and a slight amount of the hallway in front of doorway 190-3.

Figure 2J continues the examples of Figures 2A-2I, and further illustrates information corresponding to step 285 of Figure 2E, including information 256j1 that includes information resulting from aligning at least target panorama images 250d, 250g and 250i together into a common coordinate system 205 (as shown using links 214-BD, 214-BG and 214-DG), and resulting information 256j2 being illustrated that may result from further using that alignment information and the structural layout information for the living room and the hallway and the bedroom being fitted together. Figure 2J further illustrates that the automated operations of step 285 may include identifying other links 214 between the target panorama images for other acquisition locations 210E-210N, and may optionally include using other determined alignment information to link two acquisition locations whose images do not include any overlapping visual coverage (*e.g.,* link 213-EH shown between acquisition locations 210E and 210H) and/or further linking at least some acquisition locations whose associated target images have no visual overlap with any other target image (*e.g.,* link 212-PB shown in Figure 2J between acquisition locations 210P and 210B), such as based on a determination that the visual data of a target panorama image for acquisition location 210P corresponds to a front yard and includes a view of entry doorway 190-1 and that the entry doorway 190-1 of the living room shown in the target panorama image for acquisition location 210B is likely to lead to the front yard (such that the two doorways visible in the two panorama images correspond to the same doorway). In some embodiments, given relative measurements between pairs of acquisition

locations of target panorama images, global inter-image pose information is generated for some or all of the target panorama images. For example, if a simple noise-free case existed, all of the measurements would agree with one another and could just be chained together, with a spanning tree of the resulting graph giving the global pose information by chaining transformations together. In actual cases with some measurements being noisy and incorrect, rotation averaging may be used to estimate rotations in a single common global coordinate system from pairwise relative rotations of the locally aligned pairwise information. As part of doing so, a series of cascaded cycle consistency checks may be used, including on translation directions in the common coordinate system frame if scale is known, to ensure that a cycle of three or more inter-connected acquisition locations (each having local pairwise alignment information) results in zero total translation in the cycle (*e.g.,* with relative rotations in a cycle triplet of three acquisition locations should compose to the identity rotation).

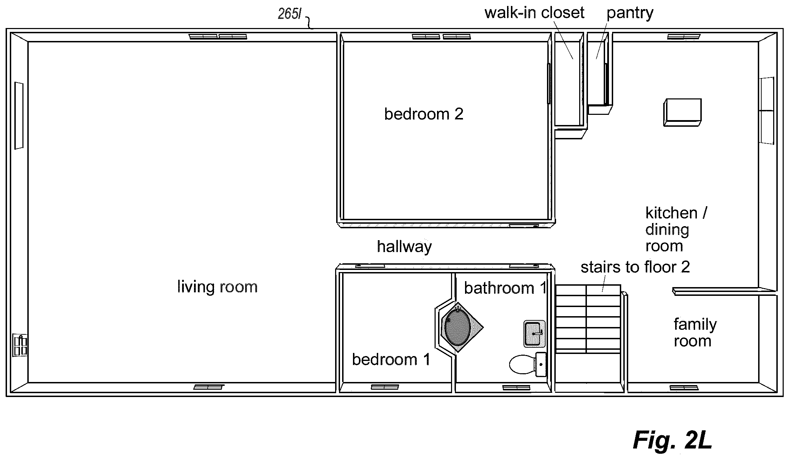

Figures 2K-2L continue the examples of Figure 2A-2J, and illustrate mapping information that may be generated from the types of analyses discussed in Figures 2E-2J. In particular, Figure 2K illustrates information 255k that includes an example floor plan 230k that may be constructed based on the described techniques, which in this example includes walls and indications of doorways and windows. In some embodiments, such a floor plan may have further information shown, such as about other features that are automatically detected by the analysis operations and/or that are subsequently added by one or more users. For example, floor plan 230k includes additional information of various types, such as may be automatically identified from analysis operations of visual data from images and/or from depth data, including one or more of the following types of information: room labels (*e.g.,* "living room" for the living room), room dimensions, visual indications of fixtures or appliances or other built-in features, visual indications of positions of additional types of associated and linked information (*e.g.,* of panorama images and/or perspective images acquired at specified acquisition positions, which an end user may select for further display; of audio annotations and/or sound recordings that an end user may select for further presentation; etc.), visual indications of doorways and windows, etc. - in other embodiments and situations, some or all such types of information may instead be provided by one or more MIGM system operator users and/or ICA system operator users. In addition, when the floor plan 230k is displayed to an end user, one or more user-selectable controls may be added to provide interactive functionality as part of a GUI (graphical user interface) screen 255k, such as to indicate a current floor that is displayed, to allow the end user to select a different floor to be displayed, etc., with a corresponding example user-selectable control 228 added to the GUI in this example - in addition, in some embodiments, a change in floors or other levels may also be made directly by user interactions with the displayed floor plan, such as via selection of a corresponding connecting passage (*e.g.,* a stairway to a different floor), and other visual changes may be made directly from the displayed floor plan by selecting corresponding displayed user-selectable controls (*e.g.,* to select a control corresponding to a particular image at a particular location, and to receive a display of that image, whether instead of or in addition to the previous display of the floor plan from which the image is selected). In other embodiments, information for some or all different floors may be displayed simultaneously, such as by displaying separate sub-floor plans for separate floors, or instead by integrating the room connection information for all rooms and floors into a single floor plan that is shown together at once. It will be appreciated that a variety of other types of information may be added in some embodiments, that some of the illustrated types of information may not be provided in some embodiments, and that visual indications of and user selections of linked and associated information may be displayed and selected in other manners in other embodiments. Figure 2L continues the examples of Figures 2A-2K, and illustrates additional information 265I that may be generated from the automated analysis techniques disclosed herein and displayed (*e.g.,* in a GUI similar to that of Figure 2K), which in this example is a 2.5D or 3D model floor plan of the house. Such a model 265I may be additional mapping-related information that is generated based on the floor plan 230k, with additional information about height shown in order to illustrate visual locations in walls of features such as windows and doors, or instead by combined final estimated room shapes that are 3D shapes. While not illustrated in Figure 2L, additional information may be added to the displayed walls in some embodiments, such as from images taken during image capture (*e.g.,* to render and illustrate actual paint, wallpaper or other surfaces from the house on the rendered model 265I), and/or may otherwise be used to add specified colors, textures or other visual information to walls and/or other surfaces, and/or other types of additional information shown in Figure 2K (*e.g.,* information about exterior areas and/or accessory structures) may be shown using such a rendered model.

In one non-exclusive example embodiment, the MIGM system uses combinatorial relative pose generation, learning-based relative pose classification, back-end synchronization over an SE(2) group and outlier rejection, and finally pose estimation via a greedily-constructed spanning tree - the SE(2) group is used for the outlier rejection, based on using SE(2) synchronization, as discussed in "SE-Sync: A certifiably correct algorithm for synchronization over the special Euclidean group" by Rosen et al. in The International Journal of Robotics Research (IJRR), 38(2-3):95-125, Mar. 2019. For example, if possible alignments are generated between rooms based on a pair of detected doorways or non-doorway wall openings or walls, and if all of the panoramas are localized, and if a single-room layout can be predicted from a panorama image, those functionalities can be combined together to generate a coherent floor plan in this example embodiment. As part of doing so, a 2D reconstruction problem may be treated as a binary classification problem, predicting whether RGB texture in rendered views correctly represents structural information for a corresponding room - such a machine learning model (*e.g.,* that is part of a convolutional neural network or other type of neural network, as part of a vision image transformer network, etc.) may be trained with data having known true/false labels.

Global floor plan reconstruction may further be used in this example embodiment to build up global information from local signals, such as local information derived from image input. For example, if two images are captured of completely disjoint rooms on opposite ends of a large home, no signal could be shared, leaving an infinite number of relative alignments in continuous space, or still yet a large number of relative alignments in discrete space if possible junction points are considered. Instead, overlapping portions of panoramas are identified, no matter how small the overlap, and all of the local measurements between pairs of images are used in a single pass to generate global structure. While an alternative approach would be to first estimate the topology from a panorama image, and

then afterwards generate a corresponding floor plan by localizing the panorama, localizing panoramas while jointly estimating their topology is a preferred approach. In addition, rather than manually defining features for roommerge costs (some of which are only applicable if an annotator can identify which panoramas were captured in different rooms, as layouts within the same room should instead maximize room intersection, while those captured in separate rooms should minimize room intersection), such features are learned from data in this example embodiment. Each window from panorama Pa should reproject onto a window in panorama Pb only if in the same room, which is an unknown latent variable, and IoU (Intersection over Union) should be high between the two overlaid room-layouts. A machine learning model (*e.g.,* that is part of a convolutional neural network or other type of neural network, as part of a vision image transformer network, etc.) is trained in this example embodiment to identify aspects such as shared floor texture around room openings, common objects (*e.g.,* refrigerators), or known priors on room adjacency (*e.g.,* the fact that bathrooms and bedrooms are often adjacent), as well as other signals present in image data, such as light source reflections, paneling direction of wood flooring, shared ceiling features, etc. Examples of pairwise signals available from unaligned panorama input are enumerated in the table below, which are generally complementary (*e.g.,* many weaknesses of monocular-depth signal can be alleviated by semantic segmentation information) - in many situations, no single signal is sufficient. Signals that provide positive room-room association clues include axis-alignment of walls between two layouts, or shared rare classes between two semantic segmentation maps (*e.g.,* fridge-to-fridge pixels or bathroom-to-bathroom pixels are more likely to occur within the same room), and because floor plan adjacency is governed by strong priors (*e.g.,* primary bedrooms are attached to primary bathrooms, hallway-to-bedroom adjacency, the fact that windows face outdoors, etc.), such signals can be learned, with a low probability that two bounding boxes would randomly project with very high IoU. Signals that provide negative room-room association clues include penetration of free space by walls between two alignments, mismatched door or window shapes, etc. The interior of each room layout is preferably empty, so a ray from camera to

layout boundary is uninhibited, and door shapes preferably match in height and width, within-room and cross-room.

| EDGE SIGNALS | STRENGTHS | WEAKNESSES |
|---|---|---|
| SfM output: relative poses | | requires full visibility/coverage and perfect HNet; repetitive structures lead to false positives |
| GT layout-based depth | w/ full visibility, ICP solves alignment | lack of vector representation, missing depth for open doors and islands |
| BEV images / cross-correlation using GT depth | if non-homogenous floor, perfect | homogeneous (or no overlap), different lighting, closed door. furniture |
| semantic segmentation | fix non-homogenous floor problem, quickly associate matching semantic elements | |
| | | |
| inferred depth | deal with furniture, objects | inaccurate around mirrors |
| learned priors | establish room-room relationships (e.g., bed-bath) or classify if aligned BEV-BEV texture/semantics match | |
| camera capture order | close to true adjacency | not true adjacency (estimate fidelity) |
| inferred or GT single-room layout | axis alignment prior | |
| inferred or GT window/-door bounding boxes | best possible "features", very limited space of possible alignments | closet doors vs. hallway-room or room-room doors are very different |

(continued)

| EDGE SIGNALS | STRENGTHS | WEAKNESSES |
| --- | --- | --- |
|  |  |  |
| global | IoU, compactness, etc. |  |

In this example embodiment, some domain knowledge is used when generating relative poses (also referred to as "alignments" for the purpose of this example embodiment), such as the fact that, because windows almost always face the outside perimeter of a building, when panoramas view the same window, i.e. are aligned at a window, the window normals should be in the same direction, meaning there can be no "rotated" configuration, as there is for doors. Combinatorial complexity can be tractably handled, such as when $O(n^2k^2)$ alignments are possible given $n$ panoramas with $k$ window, door, opening, or wall features each. Raycasting may be employed for texture mapping, such as by casting a ray out of every pixel in an image, following it along the ray to the predicted depth value representing a 3D surface, assigning a 3D coordinate (x; y; z) to the RGB value, and then applying to (x; y) on the texture map. In addition, one or more of different outlier rejection techniques may be used, including the following: estimating global measurements, and then discarding local measurements that are inconsistent with global estimates (however, global estimation is sensitive to outliers); using Similarity(2) chained triplet cycle error, in which relative Similarity(2) measurements are chained in a cycle, and deviation from identity is measured (however, two subsequent 180° errors, such as rotated door configurations, cancel out to zero); using global translation triplet cycle error, in which translation direction is placed in a global frame using global rotations, and then measuring deviation from identity; using 1D projection minimumfeedback arc set (MFAS), such as in 1D-SfM for finding outlier translation directions by projecting onto 1D subspaces, and checking consistency of order; etc.

In addition, in another non-exclusive example embodiment, the MIGM system may determine and/or validate a potential alignment between two target images by creating two texture maps (*e.g.*, without any pixel alignment between them), and computing their cross-correlation (*e.g.*, only using cross-correlation results at each shared non-zero pixel location) over a discrete set of possible translations and rotations. Furthermore, a 3D cost volume could be populated with likelihoods over these possible translations and rotations (*e.g.*, every 50 cm interval in x and in y and every 10 degree angular interval). If a deep convolutional neural network is further used to validate a potential alignment between two target images, the MIGM system may first embed the texture maps into a feature space, and then used that deep convolutional neural network to perform the cross correlation in the semantically meaningful feature space.

In addition, in one non-exclusive example embodiment, the MIGM system may generate and validate 2D floor plans using sparsely located 360° panoramas, whose semantic features (doors, windows, and openings) are used to hypothesize pairwise spatial room adjacency or overlap. The results may be validated through qualitative and quantitative an analysis, as well as ablation studies.

Indoor geometry reconstruction enables a variety of applications that include virtual tours, architectural analysis, virtual staging, and autonomous navigation. However, traditional Structure-From-Motion (SfM) techniques suffer from very limited reconstruction completeness, and accuracy for semantic SfM is still limited and cannot be effectively automated. For indoor residential floorplan reconstruction, discrete room pieces align at specific junction points (such as doors and walls), and repeated objects such as windows and doors can be used to hypothesize room adjacency or overlap, with each hypothesis providing relative room pose. Via a learned pairwise room alignment verifier, and given a room pair alignment hypothesis, the bird's eye view (BEV) of floors and ceilings can be used to predict the likelihood score of adjacency or overlap. Once relative poses are computed, global pose graph optimization can be performed, and the floorplan is generated by merging the room layouts, with post-processing available to account for noise in the room layouts. In some situations, the inputs are assumed to be a set of unordered 360 RGB panorama images captured from an indoor space, the camera is assumed to be of known height and fixed orientation parallel to the floor, and the images are assumed to cover all connecting doors between different rooms from capture, with neighboring images having zero or more degrees of visual overlap. The described system of this example embodiment can create floorplans from unaligned panoramas with baselines so large that traditional SfM techniques fail completely or mostly; alignments between scenes with zero or almost no overlap are estimated and validated; and pose graph optimization and global SfM are used in an indoor setting for outlier rejection. The system can be thought of as a deep verifier network (deep front-end) that feeds measurements to global SfM, but with outlier rejection able to be performed simply based on predicted scores.

In this example embodiment, the problem of global pose estimation of sparsely located panoramas for the purpose of floorplan reconstruction is addressed, with pose estimated in a 2D bird's-eye view (BEV) coordinate system. Formally, given an unordered collection of panoramas $\{\mathbf{I}i\}$, global pose estimation is defined as determining poses $\{^{w}T_i\}^{n}_{i=1} \in SE(2)$ of each panorama in global coordinate frame w, with the panoramas in equirectangular form having horizontal fields of view of 360° and vertical fields of view of 180°. The floorplan reconstruction problem involves generating a raster floor occupancy and per-room masks, using $\{\mathbf{I}_i\}$ and $\{^{w}\mathbf{T}_i\}^{n}_{i=1} \in SE(2)$. Global pose estimation involves building up global information from local signals, which include estimated relative poses between pairs of panoramas. The system of this example embodiment for generating the floorplan from sparsely located panoramas includes a front-end designed to hypothesize and compute relative pairwise poses, and a back-end designed to optimize global poses using them. The front-end first generates hypotheses of relative pose between a pair of rooms using their estimated room layout perimeters (*e.g.,* 2D BEV perimeters) and detected semantic objects on those perimeters (*e.g.,* windows, doors, and openings, referred to at times for this example embodiment as W/D/O). A hypothesis consists of pairing an object from panorama A with an object of the same type in panorama B (*e.g.,* pairing a door with another door, pairing walls, etc.). Hypothesizing that two paired objects are the same real-world object allows the relative SE(2) pose between the room layout from A and the room layout from B to be computed, with the hypothesis tested for plausibility. For a hypothesized relative pose, bird's-eye views of the floor and ceiling for both panoramas are rendered in the same BEV coordinate system (*e.g.,* using perpanorama depth distribution estimation), which produces overlapped top-down renderings, which are then used to generate a likelihood score that the overlapped images are a plausible match. Implausible matches are discarded, and the remaining plausible matches are used to construct a pose graph. The backend then globally optimizes the constructed pose graph. Finally, floor plans are created by: (1) clustering the panoramas by room; (2) fusing the collection of perpanorama room layout estimation given predicted panorama poses; and (3) positioning post-processed room layouts. As part of doing so, neural net machine learning models (*e.g.,* as part of one or more convolutional neural networks or other type of neural networks) or other types of machine learning models (*e.g.,* as part of one or more vision image transformer networks) may be used to estimate single-room layouts, detect W/D/O, and estimate monocular depth, providing levels of accuracy that support signal-to-noise capabilities of global pose optimization algorithms.

Since the floorplans in this example embodiment are 2D, alignment between pairs of panoramas has 3 degrees of freedom (DOF) corresponding to horizontal position and rotation, with scale not being a free parameter (assuming known, fixed camera height and a single floor plane). To handle wide baselines, semantic objects (*e.g.,* windows, doors, and openings) are used to generate alignment hypotheses in this example embodiment, and estimated room layout is additionally used (*e.g.,* using a machine learning model trained with partial room shape geometry to predict both the floor-wall boundary with an uncertainty score and locations of W/D/O). Each alignment hypothesis is generated with the assumption that W/D/O being aligned are in either the same room or different rooms. The outward surface normals of W/D/O are either in the same or opposite directions - a window is assumed to only be aligned in the direction of its interior normal, while a door or opening could be aligned in either direction. The hypothesis for rotation is refined using dominant axes of the two predicted room layouts. Exhaustively listing pairs of W/D/O can produce many hypotheses for alignment verification. The combinatorial complexity is halved by ensuring that each pair of matched W/D/O has widths with a ratio within [0:65; 1:0], such that a door that is 2 units wide cannot match to a door that is 1 units wide. Once the alignment hypotheses are found, they are verified.

While domain knowledge of indoor space such as room intersections and loop closure can be helpful in constructing a floorplan, visual cues can also be used in this example embodiment to verify pairwise panorama overlap. Bird's eye views (BEVs, which are orthographic) of the floor and ceiling can be used as visual cues for alignment verification, with extracted depth used to render the BEVs. Given the significant variation in lighting and image quality across panoramas, traditional photometric matching techniques may not be very effective, so a machine learning model (*e.g.,* that is part of a convolutional neural network or other type of neural network, as part of a vision image transformer network, etc.) is instead trained to implicitly verify spatial overlap based on these aligned texture signals. Given an alignment hypothesis, the BEVs of the floor and ceiling for both panoramas may be mapped to a common image coordinate system, with the four stacked views fed into a deep-learning-based pairwise alignment verification machine learning model to classify 2-view alignment. Given $n$ panoramas, each with k W/D/O, $O(n^2 k^2)$ alignments are possible and are verified, using a machine learning model with a stack of 4 aligned views (2 from each panorama) and a total of 12 channels, and being trained with softmax-cross entropy over 2 classes representing the "mismatch" and "match" classes. The classes may be generated by measuring the deviation of generated relative poses (alignments from window-window, opening-opening, or door-door pairs) against the groundtruth poses, with those below a certain amount of deviation considered "matches" and all others considered "mismatches".

With respect to global pose estimation and optimization, a set of pairwise alignments are generated and used in this example embodiment to construct a pose graph whose nodes are panoramas and edges are estimated relative poses. When multiple disjoint graphs result, only the largest connected component is considered, and global localization is performed using spanning tree pose aggregation and/or pose graph optimization. Floorplan reconstruction progresses from estimated panorama poses and room layouts to the output, performing panorama room grouping, highest confidence room contour extraction, and floorplan stitching. To refine a room layout, all the panoramas within that room are identified using 2D intersection over union (IoU) - since each panorama has its own layout with local shape confidence, a single global layout may be extracted by searching for the most confident contour points, such as by raycasting from panorama centers and voting for the most confident contour point along each ray, and with the final floorplan found by taking the union of (stitching) all room layouts.

In this example embodiment, a pair-wise alignment is considered to be a "match" if ground truth relative pose (*x, y,*

$\Theta) \in SE(2)$ and generated relative pose $(\check{x}, \check{y}, \check{\Theta}) \varepsilon SE(2)$ differ by less than 7° ($\Theta$) for doors and windows and less than 9° for openings (with a larger threshold used for openings because there is more variation in their endpoints), and if $\| [x,y]^T - [\check{x},\check{y}]^T \|_\infty < 0.35$ in normalized room coordinates (e.g., when camera height is scaled to 1). When texture mapping an orthographic view using a monocular estimated depth map in the example embodiment, all 3D points >= 1m below camera are used for rendering the floor and all points >= 0:5m above the camera are used for rendering the ceiling, resulting rendering a 10x10m region using a resolution of 0.02 m/pixel, creating a

500x500 image. For augmenting verifier data in the example embodiment, BEV texture maps are resized to 234x234 resolution, random 224x224 crops are sampled and randomly flipped and then normalized. With respect to training in the example embodiment, it is performed using pretrained weights and 50 epochs with an initial learning rate of 1x10⁻³, polynomial learning rate decay with a decay factor of 0.9 per iteration, a weight decay of 1x10⁻⁴, and a batch size of 256 examples.

With known camera height, a predicted floor-wall boundary in pixel space with vertices $\{(u,v)_k\}^K_{k=1}$ can be mapped in this example embodiment to 3D by first converting each vertex to spherical coordinates, and then to Cartesian coordinates, as follows:

$$\theta = \left( u \cdot \frac{2\pi}{(w-1)} \right) - \pi, \quad \theta \in [-\pi, \pi]$$
$$\varphi = \pi \left( 1 - \frac{v}{(h-1)} \right) - \frac{\pi}{2}, \quad \varphi \in \left[ -\frac{\pi}{2}, \frac{\pi}{2} \right], \tag{1}$$

where h and w is the height and width of input image in pixels.

Ray directions (x; y; z) in Cartesian space are then obtained by assuming that all points $(\Theta, \phi, P)$ lie on the unit sphere, i.e., $P=1$, and

$$x = \cos(\varphi)\sin(\theta)$$
$$y = \sin(\varphi) \tag{2}$$
$$z = \cos(\varphi)\cos(\theta).$$

Finally, the length of each ray is rescaled such that it intersects the ground plane at $y=0$, i.e., the magnitude of its $y$ coordinate is equal to the camera height $h_c$, with these rescaled ray directions now coordinates in meters.

An interpolation procedure is used when creating bird's eye view (BEV) texture maps. When generating the orthographic imagery, the raw signal from pixel values at all backprojected depth map locations is sparse and insufficient, and interpolation is used to generate a dense canvas from the sparse canvas. Another step is used to identify regions where the signal was too sparse to interpolate accurately, by convolving the canvas that is populated with sparse values with a

box filter, and zeroing-out portions of an interpolated image where the signal is unreliable due to no measurements. If a KxK subgrid of an image has no sparse signals within it and is initialized to a default value of zero, then convolution of the subgrid with a box filter of all 1's will be zero - thus, if the convolved output is zero in any $ij$ cell, then there was no true support for interpolation in this region, and this interpolated value is masked out. The interpolated image is multiplied with a binary unreliability mask to zero out unreliable values, and the canvas is populated from bottom to top.

To correct minor errors of W/D/O vertex localization in this example embodiment, vanishing points are computed and converted to a vanishing angle $\Theta_{vp}$ with direction voting from line segments, with the vanishing angle $\Theta_{vp}$ defined as the horizontal angle between the left edge of a panorama and the first vanishing point from the left side of the panoramic image. The panorama horizontal rotation is then refined by aligning the pair of vanishing angles, while maintaining the distance between the matching W/D/O. The angular adjustment can be represented by

$$\theta_{correction} = (\theta_{vp,1} - \theta_{vp,2}) - {}^2\theta_1$$

where $\Theta_{vp,1}, \Theta_{vp,2}$ are the vanishing angles of panorama 1 and panorama 2, and ${}^2\Theta_1$ corresponds to the relative rotation of panorama 1's pose in the room Cartesian coordinate system of panorama 2, i.e. of ${}^2T_1$. Panorama 1's room vertices are then rotated (in panorama 2's frame) about the W/D/O midpoint, and $\check{T}=(\check{x}, \check{y}, \check{\Theta})$ is recomputed by least-squares fitting between point sets to obtain $\check{T}_{corrected}=(\check{x}', \check{y}', \check{\Theta}')$ with fixed wall thickness.

With respect to global pose estimation in the example embodiment, global motion for $N$ images can be parameterized by $N$-1 motions. In the pose graph

$$\mathcal{G} = (\mathcal{V}, \mathcal{E})$$

when the graph G has a single connected component, the spanning tree is a set of edges such that every vertex in $V$ is reachable from every other vertex in $V$. For a graph with $N$ vertices, the minimum spanning tree always has $N$-1 edges. However, global pose estimation can have errors due to contamination by outliers. To compute a spanning tree using randomly ordered images, and starting from the first image as the root, images are incrementally included in sequence, adding each next image into the current tree at its shortest path from the root. Spanning tree solutions are susceptible to outlier edges in the tree, so pose graph optimization is used to exploit redundancy and utilize all the available information in the graph. MAP inference for SLAM problems with Gaussian noise models is equivalent to solving a nonlinear least squares problem, and comes down to maximizing the product of all factor graph potentials:

$$\mathbf{T}^{\mathrm{MAP}} = \arg\max_{T} \prod_{(i,j)\in\mathcal{E}} \phi_{ij}(\mathbf{T}_i, \mathbf{T}_j), \qquad (3)$$

where $\phi_{ij}(\mathbf{T}_i, \mathbf{T}_j)$ is a factor graph potential:

$$\phi_{ij}(\mathbf{T}_i, \mathbf{T}_j) \propto \exp\left\{ -\frac{1}{2}\|h_{ij}(\mathbf{T}_i, \mathbf{T}_j) - z_{ij}\|_{\Sigma_{ij}}^2 \right\}, \quad (4)$$

with $h_{ij}(T_i, T_j) = T_i^{-1} \cdot T_j$ and $z_{ij}$ is the estimated relative pose between images $i$ and $j$ from the alignment step described earlier.

The following objective function is then optimized using GTSAM:

$$\arg\min_{\mathbf{T}} \sum_{(i,j)\in\mathcal{E}} \rho\left(\|h_{ij}(\mathbf{T}_i, \mathbf{T}_j) - z_{ij}\|_{\Sigma_{ij}}^2\right), \qquad (5)$$

making updates $\mathbf{T}_i \oplus \xi := \mathbf{T}_i \circ \exp(\hat{\xi})$, where $\xi \in sc(2)$. Here, $\rho(\cdot)$ is a Huber noise model.

MAP inference over the pose graph with Gaussian noise models is done by maximizing the product of all factor graph potentials. The solution is initialized from a greedy spanning tree and then optimized using GTSAM - once the pose graph is optimized, the estimated poses and room layout are used to create the final floorplan.

Floorplan reconstruction in this example embodiment involves three steps: (1) panorama room grouping, (2) highest confidence room contour extraction, and (3) floorplan stitching, with details shown below in an example implementation algorithm.

---

**Algorithm 1 Floorplan Reconstruction**

---

**Inputs:**
$\{I_i\}$: A list of input panorama images.
$\{(C_i, \sigma_i)\}$: Room contour points and contour point confidence for panorama $I_i$
$\{^kT_i\}$: Estimated panorama poses from cluster $k$.
**Output:**
$S^{opt}_{floorplan}$: Optimized floor plan polygon shape.

**Solution:**
% Step 1: Panorama room grouping
Panorama connectivity graph: $\Gamma = \emptyset$
**for** $(^kT_i, {}^kT_j) \in \{^kT_i\}$ **do**
$\quad IoU_{ij} \leftarrow ComputeContourIoU(^kT_i, C_i, {}^kT_j, C_j)$
$\quad$ **if** $IoU_{ij} < Theshold$ **then**
$\quad\quad \Gamma.AddEdge(i,j)$
$\quad$ **end if**
**end for**
$\mathcal{G} = \{G^l, l = 1, ..., N_{rooms}\} \leftarrow \Gamma.GetConnectedComponents()$

% Step 2: Highest room contour extraction
**for** $G^l \in \mathcal{G}$: **do**
$\quad$ Let optimized room shape: $S^{opt}_l = \emptyset$
$\quad$ **for** $I_i \in G^l$ **do**
$\quad\quad C_{global} = \{Transform(C_m, T_m), I_m \in G^l\}$
$\quad\quad C^i_{local} = ProjectToView(C_{global}, T_i)$
$\quad\quad$ Let $\Sigma_{all} = \{\sigma_m, I_m \in G^l\}$
$\quad\quad$ %Vote for the most confident contour point in each panorama image column in panorama view $i$.
$\quad\quad C^i_{opt} = GetMostConfidentContour(C^i_{local}, \Sigma_{all})$
$\quad\quad S^i_{opt} = ConvertContourToShape(C^i_{opt})$
$\quad\quad S^{opt}_l \leftarrow S^{opt}_l \bigcup S^i_{opt}$
$\quad$ **end for**
**end for**

% Step 3: Floorplan stitching
$S^{opt}_{floorplan} = \bigcup_{l=0}^{N_{rooms}} S^{opt}_l$

---

Various details have been provided with respect to Figures 2A-2S, but it will be appreciated that the provided details are non-exclusive examples included for illustrative purposes, and other embodiments may be performed in other manners without some or all such details.

Figure 3 is a block diagram illustrating an embodiment of one or more server computing systems 300 executing an implementation of an MIGM system 340, and one or more server computing systems 380 executing an implementation of an ICA system 389 - the server computing system(s) and MIGM system may be implemented using a plurality of hardware components that form electronic circuits suitable for and configured to, when in combined operation, perform at least some of the techniques described herein. In the illustrated embodiment, each server computing system 300 includes one or more hardware central processing units ("CPU") or other hardware processors 305, various input/output ("I/O") components 310, storage 320, and memory 330, with the illustrated I/O components including a display 311, a network connection 312, a computer-readable media drive 313, and other I/O devices 315 (e.g., keyboards, mice or other pointing devices, microphones, speakers, GPS receivers, etc.). Each server computing system 380 may include hardware components similar to those of a server computing system 300, including one or more hardware CPU processors 381, various I/O components 382, storage 385 and memory 386, but with some of the details of server 300 being omitted in server 380 for the sake of brevity.

The server computing system(s) 300 and executing MIGM system 340 may communicate with other computing systems and devices via one or more networks 399 (e.g., the Internet, one or more cellular telephone networks, etc.), such as user client computing devices 390 (e.g., used to view floor plans, associated images and/or other related information), ICA server computing system(s) 380, one or more mobile computing devices 360, optionally one or more camera devices 375, optionally other navigable devices 395 that receive and use floor plans and optionally other generated information for navigation purposes (e.g., for use by semi-autonomous or fully autonomous vehicles or other devices), and optionally other computing systems that are not shown (e.g., used to store and provide additional information related to buildings; used to capture building interior data; used to store and provide information to client computing devices, such as additional supplemental information associated with images and their encompassing buildings or other surrounding environment; etc.). In some embodiments, some or all of the one or more camera devices 375 may directly communicate (e.g., wirelessly and/or via a cable or other physical connection, and optionally in a peer-to-peer manner) with one or more associated mobile computing devices 360 in their vicinity (e.g., to transmit captured target images, to receive instructions to initiate a target image acquisition, etc.), whether in addition to or instead of performing communications via network 399, and with such associated mobile computing devices 360 able to provide captured target images and optionally other captured data that is received from one or more camera devices 375 over the network 399 to other computing systems and devices (e.g., server computing systems 380 and/or 300).

In the illustrated embodiment, an embodiment of the MIGM system 340 executes in memory 330 in order to perform at least some of the described techniques, such as by using the processor(s) 305 to execute software instructions of the system 340 in a manner that configures the processor(s) 305 and computing system(s) 300 to perform automated operations that implement those described techniques. The illustrated embodiment of the MIGM system may include one or more components, not shown, to each perform portions of the functionality of the MIGM system, and the memory may further optionally execute one or more other programs 335 - as one specific example, a copy of the ICA system may execute as one of the other programs 335 in at least some embodiments, such as instead of or in addition to the ICA system 389 executing in memory 387 on the server computing system(s) 380. The MIGM system 340 may further, during its operation, store and/or retrieve various types of data on storage 320 (e.g., in one or more databases or other data structures), such as information 321 about target panorama images (e.g., acquired by one or more camera devices 375) and associated rendered rectilinear view images 323, information 325 about determined structural room layout for the target panorama images (e.g., locations of walls and other structural elements, locations of structural wall elements, image acquisition pose information, etc.), various types of floor plan information and other building mapping information 326 (e.g., generated and saved 2D floor plans with 2D room shapes and positions of wall elements and other elements on those floor plans and optionally additional information such as building and room dimensions for use with associated floor plans, existing images with specified positions, annotation information, etc.; generated and saved 2.5D and/or 3D model floor plans that are similar to the 2D floor plans but further include height information and 3D room shapes; etc.), optionally user information 322 about users of client computing devices 390 and/or operator users of mobile devices 360 who interact with the MIGM system, optionally training data for use with one or more machine learning models (e.g., as part of one or more convolutional neural networks or other neural networks, one or more vision image transformer network, etc.) and/or the resulting trained machine learning models (not shown), and optionally various other types of additional information 329. The ICA system 839 may similarly store and/or retrieve various types of data on storage 385 (e.g., in one or more databases or other data structures) during its operation and provide some or all such information to the MIGM system 340 for its use (whether in a push and/or pull manner), such as images 386 (e.g., 360° target panorama images acquired by one or more camera devices 375 and transferred to the server computing systems 380 by those camera devices and/or by one or more intermediate associated mobile computing devices 360), and optionally various types of additional information (e.g., various analytical information related to presentation or other use of one or more building interiors or other environments captured by an ICA system, not shown).

Some or all of the user client computing devices 390 (e.g., mobile devices), mobile computing devices 360, camera devices 375, other navigable devices 395 and other computing systems may similarly include some or all of the same types of components illustrated for server computing systems 300 and 380. As one nonlimiting example, the mobile computing devices 360 are each shown to include one or more hardware CPU(s) 361, I/O components 362, storage 365, imaging system 364, IMU hardware sensors 369, optionally depth sensors (not shown), and memory 367, with one or both of a browser and one or more client applications 368 (*e.g.*, an application specific to the MIGM system and/or ICA system) optionally executing within memory 367, such as to participate in communication with the MIGM system 340, ICA system 389, associated camera devices 375 and/or other computing systems. While particular components are not illustrated for the other navigable devices 395 or client computing systems 390, it will be appreciated they may include similar and/or additional components.

It will also be appreciated that computing systems 300 and 380 and camera devices 375 and the other systems and devices included within Figure 3 are merely illustrative and are not intended to limit the scope of the present invention. The systems and/or devices may instead each include multiple interacting computing systems or devices, and may be connected to other devices that are not specifically illustrated, including via Bluetooth communication or other direct communication, through one or more networks such as the Internet, via the Web, or via one or more private networks (*e.g.*, mobile communication networks, etc.). More generally, a device or other computing system may comprise any combination of hardware that may interact and perform the described types of functionality, optionally when programmed or otherwise configured with particular software instructions and/or data structures, including without limitation desktop or other computers (e.g., tablets, slates, etc.), database servers, network storage devices and other network devices, smart phones and other cell phones, consumer electronics, wearable devices, digital music player devices, handheld gaming devices, PDAs, wireless phones, Internet appliances, camera devices and accessories, and various other consumer products that include appropriate communication capabilities. In addition, the functionality provided by the illustrated MIGM system 340 may in some embodiments be distributed in various components, some of the described functionality of the MIGM system 340 may not be provided, and/or other additional functionality may be provided.

It will also be appreciated that, while various items are illustrated as being stored in memory or on storage while being used, these items or portions of them may be transferred between memory and other storage devices for purposes of memory management and data integrity. Alternatively, in other embodiments some or all of the software components and/or systems may execute in memory on another device and communicate with the illustrated computing systems via inter-computer communication. Thus, in some embodiments, some or all of the described techniques may be performed by hardware means that include one or more processors and/or memory and/or storage when configured by one or more software programs (e.g., by the MIGM system 340 executing on server computing systems 300) and/or data structures, such as by execution of software instructions of the one or more software programs and/or by storage of such software instructions and/or data structures, and such as to perform algorithms as described in the flow charts and other disclosure herein. Furthermore, in some embodiments, some or all of the systems and/or components may be implemented or provided in other manners, such as by consisting of one or more means that are implemented partially or fully in firmware and/or hardware (e.g., rather than as a means implemented in whole or in part by software instructions that configure a particular CPU or other processor), including, but not limited to, one or more application-specific integrated circuits (ASICs), standard integrated circuits, controllers (e.g., by executing appropriate instructions, and including microcontrollers and/or embedded controllers), field-programmable gate arrays (FPGAs), complex programmable logic devices (CPLDs), etc. Some or all of the components, systems and data structures may also be stored (e.g., as software instructions or structured data) on a non-transitory computer-readable storage mediums, such as a hard disk or flash drive or other non-volatile storage device, volatile or non-volatile memory (e.g., RAM or flash RAM), a network storage device, or a portable media article (e.g., a DVD disk, a CD disk, an optical disk, a flash memory device, etc.) to be read by an appropriate drive or via an appropriate connection. The systems, components and data structures may also in some embodiments be transmitted via generated data signals (e.g., as part of a carrier wave or other analog or digital propagated signal) on a variety of computer-readable transmission mediums, including wireless-based and wired/cable-based mediums, and may take a variety of forms (e.g., as part of a single or multiplexed analog signal, or as multiple discrete digital packets or frames). Such computer program products may also take other forms in other embodiments. Accordingly, embodiments of the present disclosure may be practiced with other computer system configurations.

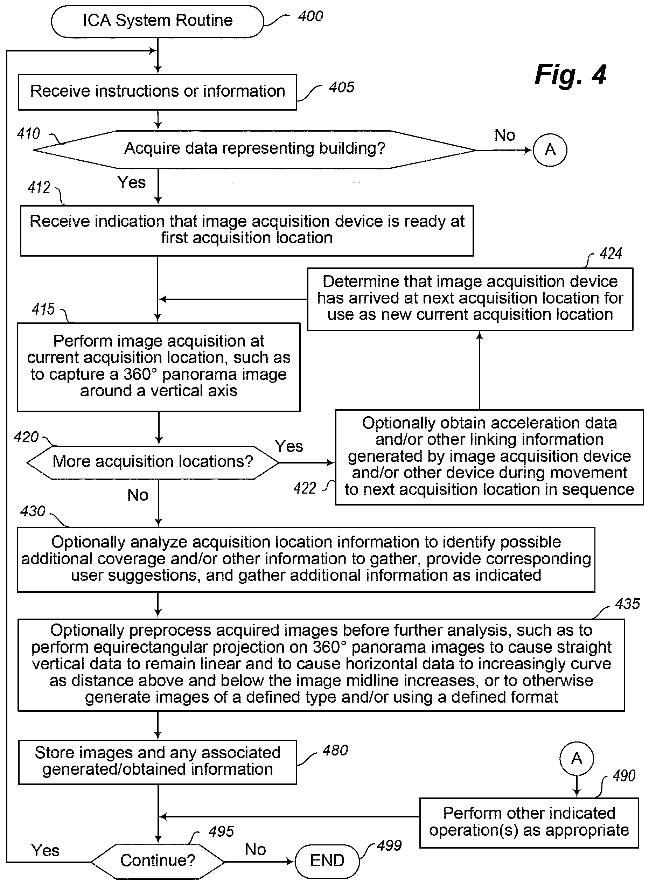

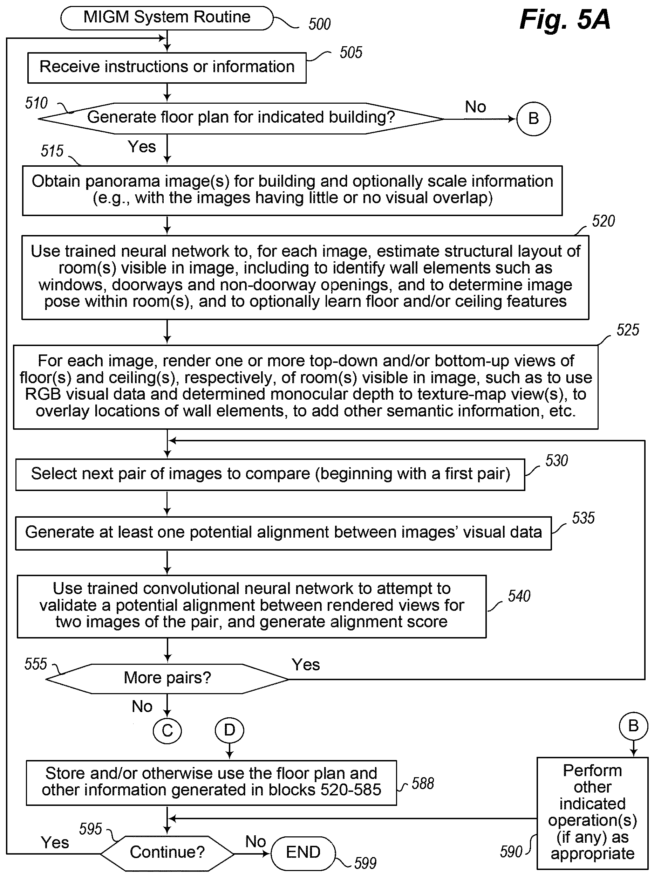

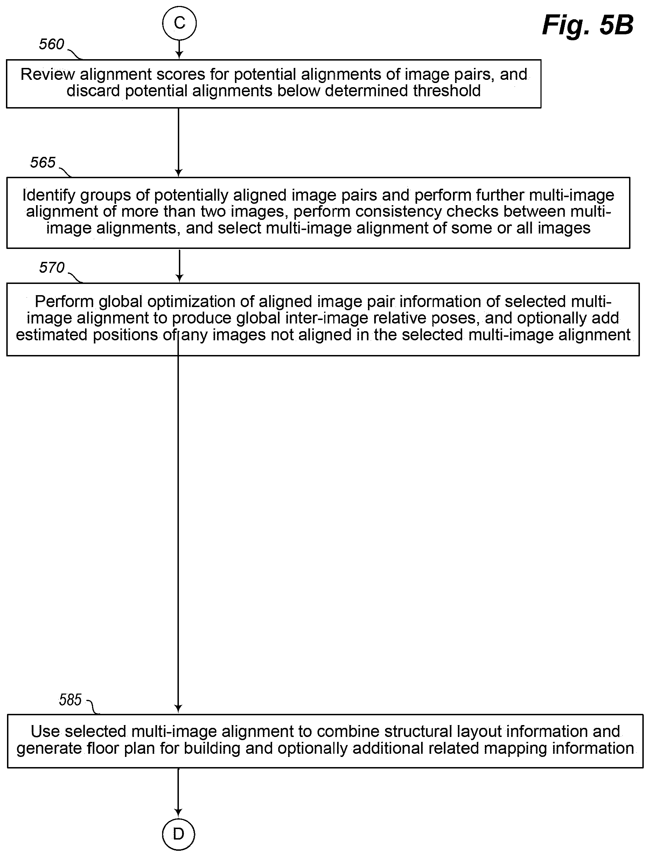

Figure 4 illustrates an example flow diagram of an embodiment of an ICA System routine 400. The routine may be performed by, for example, the ICA system 160 of Figure 1A, the ICA system 389 of Figure 3, and/or an ICA system as otherwise described herein, such as to acquire 360° target panorama images and/or other images within buildings or other structures (e.g., for use in subsequent generation of related floor plans and/or other mapping information, such as by an embodiment of an MIGM system routine, with one example of such a routine illustrated with respect to Figures 5A-5B; for use in subsequent determination of acquisition locations and optionally acquisition orientations of the target images; etc.). While portions of the example routine 400 are discussed with respect to acquiring particular types of images at particular locations, it will be appreciated that this or a similar routine may be used to acquire video or other data (e.g., audio) and/or other types of images that are not panoramic, whether instead of or in addition to such panorama images. In addition, while the illustrated embodiment acquires and uses information from the interior of a target building, it will be appreciated that other embodiments may perform similar techniques for other types of data, including for non-building structures and/or for information external to one or more target buildings of interest. Furthermore, some or all of the routine may be executed on a mobile device used by a user to participate in acquiring image information and/or related additional data, and/or by a system remote from such a mobile device.

The illustrated embodiment of the routine begins at block 405, where instructions or information are received. At block 410, the routine determines whether the received instructions or information indicate to acquire data representing a building (e.g., in the building interior), and if not continues to block 490. Otherwise, the routine proceeds to block 412 to receive an indication (e.g., from a user of a mobile computing device associated with one or more camera devices) to begin the image acquisition process at a first acquisition location. After block 412, the routine proceeds to block 415 in order to perform acquisition location image acquisition activities in order to acquire at least one 360° panorama image by at least one image acquisition device (and optionally one or more additional images and/or other additional data by a mobile computing device, such as from IMU sensors and/or depth sensors) for the acquisition location at the target building of interest, such as to provide horizontal coverage of at least 360° around a vertical axis. The routine may also optionally obtain annotation and/or other information from a user regarding the acquisition location and/or the surrounding environment, such as for later use in presentation of information regarding that acquisition location and/or surrounding environment.

After block 415 is completed, the routine continues to block 420 to determine if there are more acquisition locations at which to acquire images, such as based on corresponding information provided by the user of the mobile computing device and/or to satisfy specified criteria (e.g., at least a specified quantity of panorama images to be captured in each of some or all rooms of the target building and/or in each of one or more areas external to the target building). If so, the routine continues to block 422 to optionally initiate the capture of linking information (such as visual data, acceleration data from one or more IMU sensors, etc.) during movement of the mobile device along a travel path away from the current acquisition location and towards a next acquisition location for the building. As described elsewhere herein, the captured linking information may include additional sensor data (e.g., from one or more IMU, or inertial measurement units, on the mobile computing device or otherwise carried by the user) and/or additional visual information (e.g., panorama images, other types of images, panoramic or non-panoramic video, etc.) recorded during such movement, and in some embodiments may be analyzed to determine a changing pose (location and orientation) of the mobile computing device during the movement, as well as information about a room shape of the enclosing room (or other area) and the path of the mobile computing device during the movement. Initiating the capture of such linking information may be performed in response to an explicit indication from a user of the mobile computing device or based on one or more automated analyses of information recorded from the mobile computing device. In addition, the routine in some embodiments may further optionally determine and provide one or more guidance cues to the user regarding the motion of the mobile device, quality of the sensor data and/or visual information being captured during movement to the next acquisition location (e.g., by monitoring the movement of the mobile device), including information about associated lighting/environmental conditions, advisability of capturing a next acquisition location, and any other suitable aspects of capturing the linking information. Similarly, the routine may optionally obtain annotation and/or other information from the user regarding the travel path, such as for later use in presentation of information regarding that travel path or a resulting inter-panorama image connection link. In block 424, the routine then determines that the mobile computing device (and one or more associated camera devices) arrived at the next acquisition location (e.g., based on an indication from the user, based on the forward movement of the user stopping for at least a predefined amount of time, etc.), for use as the new current acquisition location, and returns to block 415 in order to perform the image acquisition activities for the new current acquisition location.

If it is instead determined in block 420 that there are not any more acquisition locations at which to acquire image information for the current building or other structure, the routine proceeds to block 430 to optionally analyze the acquisition position information for the building or other structure, such as to identify possible additional coverage (and/or other information) to acquire within the building interior or otherwise associated with the building. For example, the ICA system may provide one or more notifications to the user regarding the information acquired during capture of the multiple acquisition locations and optionally corresponding linking information, such as if it determines that one or more segments of the recorded information are of insufficient or undesirable quality, or do not appear to provide complete coverage of the building. In addition, in at least some embodiments, if minimum criteria for images (e.g., a minimum quantity and/or type of images) have not been satisfied by the captured images (e.g., at least two panorama images in each room, panorama images within a maximum specified distance of each other, etc.), the ICA system may prompt or direct the acquisition of additional panorama images to satisfy such criteria. After block 430, the routine continues to block 435 to optionally preprocess the acquired 360° target panorama images before subsequent use for generating related mapping information (*e.g.*, to place them in an equirectangular format, to determine vanishing lines and vanishing points, etc.). In block 480, the images and any associated generated or obtained information is stored for later use.

If it is instead determined in block 410 that the instructions or other information recited in block 405 are not to acquire images and other data representing a building, the routine continues instead to block 490 to perform any other indicated operations as appropriate, such as any housekeeping tasks, to configure parameters to be used in various operations of the system (*e.g.*, based at least in part on information specified by a user of the system, such as a user of a mobile

device who captures one or more building interiors, an operator user of the ICA system, etc.), to obtain and store other information about users of the system, to respond to requests for generated and stored information, etc.

Following blocks 480 or 490, the routine proceeds to block 495 to determine whether to continue, such as until an explicit indication to terminate is received, or instead only if an explicit indication to continue is received. If it is determined to continue, the routine returns to block 405 to await additional instructions or information, and if not proceeds to step 499 and ends.

Figures 5A-5B illustrate an example embodiment of a flow diagram for a Mapping Information Generation Manager (MIGM) System routine 500. The routine may be performed by, for example, execution of the MIGM system 140 of Figure 1A, the MIGM system 340 of Figure 3, the MIGM system discussed with respect to Figures 2E-2S, and/or an MIGM system as described elsewhere herein, such as to generate a floor plan for a building or other defined area based at least in part on visual data of one or more images of the area and optionally additional data captured by a mobile computing device, such as after pairwise alignment of target images having little-to-no overlapping visual coverage, and/or to generate other mapping information for a building or other defined area based at least in part on one or more images of the area and optionally additional data captured by a mobile computing device. In the example of Figures 5A-5B, the generated mapping information for a building (e.g., a house) includes a 2D floor plan and/or 3D computer model floor plan, but in other embodiments, other types of mapping information may be generated and used in other manners, including for other types of structures and defined areas, as discussed elsewhere herein.

The illustrated embodiment of the routine begins at block 505, where information or instructions are received. The routine continues to block 510 to determine whether to generate a floor plan for an indicated building, and if not continues to block 590. Otherwise, the routine continues to block 515 to obtain the target images for the building and optionally associated dimension/scale information (e.g., to retrieve stored target images that were previously acquired; to use target images supplied in block 505; to concurrently acquire such information, with Figure 4 providing one example embodiment of an ICA system routine for performing such image acquisition, including optionally waiting for one or more users or devices to move throughout one or more rooms of the building and acquire panoramas or other images at acquisition locations in building rooms and optionally other building areas, and optionally along with metadata information regarding the acquisition and/or interconnection information related to movement between acquisition locations, as discussed in greater detail elsewhere herein).

After block 515, the routine continues to block 520, where it uses a trained layout determination machine learning model (*e.g.*, as part of a neural network) to, for each target image, estimate structural layout information for one or more rooms visible in the target image, including to identify wall elements such as windows, doorways and non-doorway openings, and to determine an image pose within the structural layout, and optionally learn floor and/or ceiling features for use in subsequent rendered views. After block 520, the routine continues to block 525, where it renders, for each target image, one or more views of floor and/or ceilings visible in the target image, such as to use RGB visual data and determined estimated monocular depth data to texture-map the views, and/or to overlay locations of wall elements and/or other semantic information, etc.

After block 525, the routine continues to block 530 to select a next pair of the target images (beginning with a first), and then proceeds to block 535 to attempt to determine one or more potential alignments between the visual data of the target images (e.g., based at least in part on matching structural layout information for the target images, by using determined target image pose information, etc.). After block 535, the routine in block 540 proceeds to use a trained machine learning model (*e.g.*, as part of convolutional neural network) to attempt to validate a potential alignment between the two images of the pair using their rendered views, along with generating a corresponding alignment score or other alignment indication. After block 540, the routine continues to block 555, where it determines if there are more pairs of images to compare, and if so returns to block 530 to select a next pair of images. Otherwise, the routine continues to block 560 where it reviews the alignment scores for the potential alignments of the image pairs, and discards potential alignments according to one or more defined criteria (e.g., alignment scores below a determined threshold). The routine then continues to block 565, where it identifies groups of potentially aligned image pairs and combines them, including to perform further multi-image alignment of

the images of such groups, consistency checks between the multi-image alignments, and selection of the multi-image alignments for some or all of the images for further use. In block 570, the routine then performs a global optimization of the aligned image pair information of the selected multi-image alignments, to produce global inter-image relative pose information, and optionally further as estimated positions of any images not aligned in the selected multi-image alignment (e.g., by estimating positions using other techniques). The routine then continues to block 585, where it uses the globally optimized multi-image alignment to combine structural layout information for the building rooms and/ other building areas,

and to generate at least one corresponding floor plan for the building, as well as optionally additional related mapping information.

After block 585, the routine continues to block 588 to store the generated mapping information and/or other generated information, and to optionally further use some or all of the determined and generated information, such as to provide the generated 2D floor plan and/or 3D computer model floor plan for display on one or more client devices and/or to one or more other devices for use in automating navigation of those devices and/or associated vehicles or other entities, to provide and use information about determined room layouts/shapes and/or a linked set of panorama images and/or about additional information determined about contents of rooms and/or passages between rooms, etc.

In block 590, the routine continues instead to perform one or more other indicated operations as appropriate. Such other operations may include, for example, receiving and responding to requests for previously generated floor plans and/or previously determined room layouts/shapes and/or other generated information (e.g., requests for such information for display on one or more client devices, requests for such information to provide it to one or more other devices for use in automated navigation, etc.), obtaining and storing information about buildings for use in later operations (e.g., information about dimensions, numbers or types of rooms, total square footage, adjacent or nearby other buildings, adjacent or nearby vegetation, exterior images, etc.), etc.

After blocks 588 or 590, the routine continues to block 595 to determine whether to continue, such as until an explicit indication to terminate is received, or instead only if an explicit indication to continue is received. If it is determined to continue,

the routine returns to block 505 to wait for and receive additional instructions or information, and otherwise continues to block 599 and ends.

While not illustrated with respect to the automated operations shown in the example embodiment of Figures 5A-5B, in some embodiments human users may further assist in facilitating some of the operations of the MIGM system, such as for operator users and/or end users of the MIGM system to provide input of one or more types that is further used in subsequent automated operations.

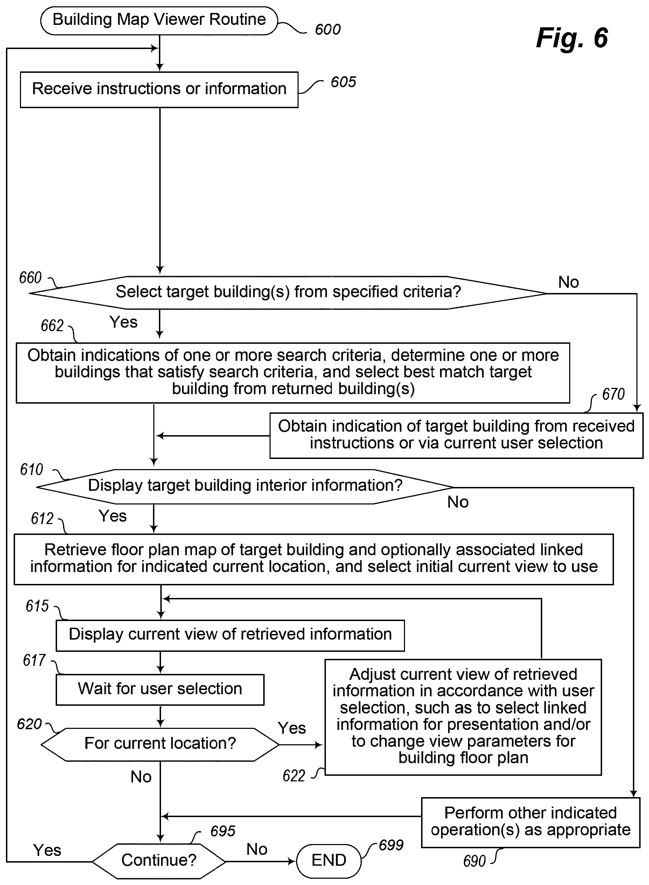

Figure 6 illustrates an example embodiment of a flow diagram for a Building Map Viewer system routine 600. The routine may be performed by, for example, execution of a map viewer client computing device 175 and its software system(s) (not shown) of Figure 1A, a client computing device 390 and/or mobile computing device 360 of Figure 3, and/or a mapping information viewer or presentation system as described elsewhere herein, such as to receive and display generated floor plans and/or other mapping information (e.g., a 3D model floor plan, determined room structural layouts/shapes, etc.) for a defined area that optionally includes visual indications of one or more determined image acquisition locations, as well as to optionally display additional information (e.g., images) associated with particular acquisition locations in the mapping information. In the example of Figure 6, the presented mapping information is for a building (such as an interior of a house), but in other embodiments, other types of mapping information may be presented for other types of buildings or environments and used in other manners, as discussed elsewhere herein.

The illustrated embodiment of the routine begins at block 605, where instructions or information are received. At block 660, the routine determines whether the received instructions or information in block 605 are to select one or more target buildings using specified criteria, and if not continues to block 670, where it obtains an indication of a target building to use from the user (e.g., based on a current user selection, such as from a displayed list or other user selection mechanism; based on information received in block 605; etc.). Otherwise, if it is determined in block 660 to select one or more target buildings from specified criteria, the routine continues instead to block 662, where it obtains indications of one or more search criteria to use, such as from current user selections or as indicated in the information or instructions received in block 605, and then

searches stored information about buildings to determine one or more of the buildings that satisfy the search criteria. In the illustrated embodiment, the routine then further selects a best match target building from the one or more returned buildings (e.g., the returned other building with the highest similarity or other matching rating for the specified criteria, or using another selection technique indicated in the instructions or other information received in block 605).

After blocks 662 or 670, the routine continues to block 610 to determine whether the received instructions or information in block 605 indicate to display or otherwise present information representing a building interior, and if not continues to block 690. Otherwise, the routine proceeds to block 612 to retrieve a floor plan for a building or other generated mapping information for the building, and optionally indications of associated linked information for the building interior and/or a surrounding location external to the building, and selects an initial view of the retrieved information (e.g., a view of the floor plan, a particular room shape, etc.). In block 615, the routine then displays or otherwise presents the current view of the retrieved information, and waits in block 617 for a user selection. After a user selection in block 617, if it is determined in block 620 that the user selection corresponds to adjusting the current view for a current location (e.g., to change one or more aspects of the current view), the routine continues to block 622 to update the current view in accordance with the user selection, and then returns to block 615 to update the displayed or otherwise presented information accordingly. The user selection and corresponding updating of the current view may include, for example, displaying or otherwise presenting a piece of associated linked information that the user selects (e.g., a particular image associated with a displayed visual indication of a determined acquisition location, such as to overlay the associated linked information over at least some of the previous display), and/or changing how the current view is displayed (e.g., zooming in or out; rotating information if appropriate; selecting a new portion of the floor plan to be displayed or otherwise presented, such as with some or all of the new portion not being previously visible, or instead with the new portion being a subset of the previously visible information; etc.).

If it is instead determined in block 610 that the instructions or other information received in block 605 are not to present information representing a building interior, the routine continues instead to block 690 to perform other indicated operations as appropriate, such as any housekeeping tasks, to configure parameters to be used in various operations of the system (e.g., based at least in part on information specified by a user of the system, such as a user of a mobile device who captures one or more building interiors, an operator user of the MIGM system, etc., including for use in personalizing information display for a particular user in accordance with his/her preferences), to obtain and store other information about users of the system, to respond to requests for generated and stored information, etc.

Following block 690, or if it is determined in block 620 that the user selection does not correspond to the current building area, the routine proceeds to block 695 to determine whether to continue, such as until an explicit indication to terminate is received, or instead only if an explicit indication to continue is received. If it is determined to continue (including if the user made a selection in block 617 related to a new location to present), the routine returns to block 605 to await additional instructions or information (or to continue directly on to block 612 if the user made a selection in block 617 related to a new location to present), and if not proceeds to step 699 and ends.

**Claims**

1. A non-transitory computer-readable medium (152) having stored contents that cause one or more computing devices (185) to perform automated operations including at least:

   obtaining, by the one or more computing devices (185), a plurality of panorama images (165) that are captured at a plurality of acquisition locations (210a, 210b) in a building (198) having multiple rooms and that include visual coverage of at least some of walls and a floor and a ceiling of one or more of the rooms, wherein each of the panorama images (165) includes 360 degrees of horizontal visual coverage around a vertical axis and provides red-green-blue, RGB, pixel data in an equirectangular format for the at least some of the walls and the floor and the ceiling of the one or more rooms;
   analyzing, by the one or more computing devices (185) and for each of the panorama images (165), color pixel data of that panorama image (165) to generate multiple types of information about at least one room visible in that panorama image (165), wherein the multiple types of information include a generated structural layout (242) indicating at least some walls of that at least one room, and include a determined position within that structural layout (242) of the acquisition location (210a) for one panorama image (165), and include one or more rendered views (255g1) of at least some of a floor or of a ceiling of that at least one room that include information generated using the color pixel data of that panorama image (165), wherein the one or more rendered views (255g1) for that panorama image (165) are rendered in two dimensions in a perspective or orthographic format and each includes some of the RGB pixel data of that panorama image (165) that is positioned in that rendered view based at least in part on the generated structural layout (255g1) for the at least one room visible in that panorama image (165) and the determined position of the acquisition location (210a) for that panorama image (165), the one or more rendered views (255g1) for that panorama image (165) including at least one of a floor view (255g1) of the at least some floor for that panorama image (165) or a ceiling view (255g2) of the at least some ceiling for that panorama image (165);
   determining, by the one or more computing devices (185) and using a trained machine learning model that is part of a convolutional neural network trained to validate local alignments between visual data included in rendered views (255g1) of two images (165), and for each of one or more image pairs each having two of the panorama images (165) that are captured in two of the multiple rooms, local alignment information between the acquisition locations (210a, 210b) of those two panorama images (165) based at least in part on comparing information for the one or more rendered views (255g1) for each of those two panorama images (165), including matching one or more structural elements (196-1) identified in overlapping visual coverage of the two panorama images (165) of that image pair;
   generating, by the one or more computing devices (185), global alignment information that includes positions for at least some of the plurality of acquisition locations (210a, 210b) in a common coordinate system (205), including combining the local alignment information determined between the acquisition locations (210a, 210b) for at least some of the one or more image pairs;

generating, by the one or more computing devices (185), a floor plan (230k) for at least some of the building (198), including fitting generated structural layouts for at least the one or more rooms using the positions from the global alignment information for the at least some of the plurality of acquisition locations (210a, 210b); and

providing, by the one or more computing devices (185), the generated floor plan (230k), to enable use of the generated floor plan (230k).

2. The non-transitory computer-readable medium of claim 1 wherein the plurality of panorama images include, for each of the multiple rooms, one of those panorama images captured in that room, wherein the generated floor plan includes generated structural layouts for all of the multiple rooms that are each a two-dimensional structural layout, and wherein the providing of the generated floor plan includes transmitting, by the one or more computing devices and to one or more client devices over one or more networks, the generated floor plan to cause display of the generated floor plan on the one or more client devices.

3. The non-transitory computer-readable medium of claim 1 wherein the one or more image pairs include at least a first image pair having two panorama images captured in different first and second rooms but having overlapping visual coverage through at least one of a doorway or a non-doorway wall opening of at least one of first and second rooms, and a second image pair having two panorama images captured in different third and fourth rooms but lacking any overlapping visual coverage, and wherein the determining of the local alignment information for each of the first and second image pairs includes validating the local alignment information for the first image pair based at least in part on matching the overlapping visual coverage of the two panorama images captured in the first and second rooms, and includes discarding the local alignment information for the second image pair before the combining of the local alignment information based on not validating the local alignment information for the second image pair.

4. The non-transitory computer-readable medium of claim 3 wherein the one or more image pairs further include a third image pair having two panorama images captured in different fifth and sixth rooms but lacking any overlapping visual coverage, and wherein the determining of the local alignment information for the third image pair includes validating the local alignment information for the third image pair despite a lack of any overlapping visual coverage based at least in part on matching visual data of the two panorama images captured in the fifth and sixth rooms to previously determined information about types of visual data present in types of adjacent rooms.

5. The non-transitory computer-readable medium of claim 1 wherein the information included in at least one of the one or more rendered views for each of the panorama images includes at least one of:

at least some of the color pixel data of that panorama image that is texture-mapped to pixel positions in the at least one rendered view using monocular depth information that is estimated from the acquisition location for that panorama image to surrounding structural elements based only on analysis of the color pixel data of that panorama image; and/or

overlaid information to indicate one or more locations of at least one of a doorway or a non-doorway wall opening or a window that are identified based only on analysis of the color pixel data of that panorama image; and/or

overlaid information to indicate one or more locations of at least one type of object or surface of the one or more rooms that are included in the visual coverage of that panorama image and that are identified based only on analysis of the color pixel data of that panorama image; and/or

at least some of the color pixel data of that panorama image that is texture-mapped to pixel positions in the at least one rendered view using monocular depth information that is estimated from the acquisition location for that panorama image to surrounding structural elements, and includes overlaid information to indicate one or more identified locations of at least one of a doorway or a non-doorway wall opening or a window.

6. The non-transitory computer-readable medium of claim 1 wherein the analyzing of the color pixel data of each of the panorama images includes using a second neural network trained to jointly determine layout information for rooms visible in images and determine image pose information for those images within those layouts, and wherein the stored contents include software instructions that, when executed, cause the one or more computing devices to perform further automated operations including determining, by the one or more computing devices and using a third neural network trained to segment rooms visible in images into structural wall elements, and for each of the panorama images, the color pixel data of that panorama image to generate further information about the at least one room visible in that panorama image that includes a determined location of at least one doorway or non-doorway wall opening for that at least one room on the generated structural layout for that at least one room and that further includes at least one additional determined location of at least one window for that at least one room.

7.  The non-transitory computer-readable medium of claim 1 wherein the one or more image pairs include a plurality of image pairs, and wherein the combining of the local alignment information includes combining local alignment information determined for multiple image pairs of the plurality of image pairs by generating one or more groups each having at least three acquisition locations that are all inter-connected via determined local alignment information, performing rotation averaging to estimate directions between the at least three acquisition locations in the common coordinate system, and performing one or more checks on the estimated directions to confirm that the estimated directions between the at least three acquisition locations are consistent.

8.  The non-transitory computer-readable medium of claim 1 wherein the structural layout generated for each of the panorama images from the analyzing of the color pixel data of that panorama image is at least one of:

    a generated three-dimensional shape of the at least one room visible in that panorama image, and wherein the determining of the local alignment information between the acquisition locations of the two panorama images for each of the one or more image pairs includes comparing the generated three-dimensional shapes for those two panorama images; and/or
    a generated three-dimensional shape of the at least one room visible in that panorama image, and wherein the fitting of the generated structural layouts for the at least one or more rooms includes combining the generated three-dimensional shapes from all of the panorama images based at least in part on at least one of doorways or non-doorway openings identified in the multiple rooms from analysis of the color pixel data of the panorama images.

9.  The non-transitory computer-readable medium of claim 1 wherein at least some of the panorama images each includes visual coverage for two or more rooms and the multiple types of information generated for that panorama image are for all of the two or more rooms, and wherein generating of the multiple types of information for each of the panorama includes analyzing a combination of the RGB pixel data of that panorama image and additional depth data acquired from the acquisition location of that panorama image using one or more depth-sensing devices.

10. The non-transitory computer-readable medium of claim 1 wherein the automated operations further include analyzing, by the one or more computing devices and for each of the panorama images, that panorama image to generate depth data from the acquisition location of that panorama image to the at least some walls of the at least one room visible in that panorama image, and wherein the one or more rendered views for that panorama image of the at least some of the floor or of the ceiling of the at least one room visible in that panorama image include at least some of the generated depth data.

11. The non-transitory computer-readable medium of claim 1 wherein the automated operations further include analyzing, by the one or more computing devices and for each of the panorama images, that panorama image to determine locations of objects visible in that panorama image, and wherein the one or more rendered views for that panorama image of the at least some of the floor or of the ceiling of the at least one room visible in that panorama image include indications of at least some of the determined locations of the objects.

12. A system (180) comprising:

    one or more hardware processors (132) of one or more computing systems (185); and
    one or more memories (152) with stored instructions that, when executed by at least one of the one or more hardware processors (132), cause the one or more computing systems (185) to perform automated operations including at least:

        obtaining a plurality of panorama images (165) that are captured at a plurality of acquisition locations (210a, 210b) for a building (198) having multiple rooms and that include visual coverage of at least some walls of one or more of the rooms, wherein each of the panorama images (165) includes 360 degrees of horizontal visual coverage around a vertical axis and provides red-green-blue, RGB, pixel data in an equirectangular format for the at least some of the walls of the one or more rooms;
        analyzing, for each of at least some of the panorama images (165), color pixel data of that panorama image to generate information about at least one room of the one or more rooms that is visible in that panorama image (165), including one or more rendered views (255g1) of at least some of one or more planar surfaces in that at least one room that include data generated using the color pixel data of that panorama image (165), wherein the one or more rendered views (255g1) for that panorama image (165) are rendered in two dimensions in a perspective or orthographic format and each includes some of the RGB pixel data of that panorama image (165) that is positioned in that rendered view (255g1) based at least in part on structural layout for the at least one room visible in that panorama image (165) and a position of the acquisition location (210a) for that panorama image (165), the one or more rendered views (255g1) for that panorama image (165) including at least one of a floor view (255g1) of at least some floor of the at least one room visible in that panorama image (165) or a ceiling view (255g2) of at least some ceiling of the at least one room visible in that panorama image (165);

determining, based at least in part on use of a trained neural network that is part of a convolutional neural network trained to validate local alignments between visual data included in rendered views (255g1) of two images, and for each of one or more image groups each having at least two panorama images (165) of the at least some panorama images (165), alignment information between the acquisition locations (210a, 210b) of those at least two panorama images (165) based at least in part on comparing information for the one or more rendered views (255g1) for each of those at least two panorama images (165), including matching one or more structural elements (196-1) identified in overlapping visual coverage of those at least two panorama images (165), the determining of the alignment information between those acquisition locations (210a. 210b) including determining positions that are at least relative to each other;

generating at least a partial floor plan (230k) for at least some of the building, including placing generated structural layouts for at least the one or more rooms using the determined positions for the acquisition locations (210a, 210b) of the at least two panorama images (165) for each of the one or more image groups; and

providing the generated at least partial floor plan (230k), to enable use of the generated floor plan (230k).

13. The system of claim 12 wherein the plurality of panorama images include, for each of the multiple rooms, one of those panorama images captured in that room and having visual coverage of at least some walls of that room, wherein the generated at least partial floor plan includes generated structural layouts for all of the multiple rooms, and wherein the providing of the generated at least partial floor plan includes transmitting, to one or more client devices over one or more networks, the generated at least partial floor plan to cause display of the generated at least partial floor plan on the one or more client devices.

14. The system of claim 12 wherein the trained neural network is a convolutional neural network trained to validate local alignments between visual data included in rendered views for two images, and

wherein the plurality of panorama images include, for each of the multiple rooms, one of those panorama images captured in that room and having visual coverage of at least some walls of that room and at least some of at least one of a floor of that room or a ceiling of that room, and

wherein the analyzing of the color pixel data for the at least some panorama images further includes using that color pixel data to generate the structural layouts for the at least one or more rooms, the generated structural layouts indicating the at least some walls of the at least one or more rooms, and

wherein the automated operations further include generating the local alignment information for each of the image groups based at least in part on matching one or more structural elements identified in overlapping visual coverage of the at least two panorama images of that image group, and

wherein, for each of the panorama images captured in one of the multiple rooms, that panorama image includes 360 degrees of horizontal visual coverage around a vertical axis and provides RGB (red-green-blue) pixel data in an equirectangular format for the at least some walls of that room and for the at least some of the at least one of the floor of that room or the ceiling of that room, and the one or more rendered views for that panorama image are rendered in two dimensions in a perspective or orthographic format and each includes some of the RGB pixel data of that panorama image that is positioned in that rendered view based at least in part on the generated structural layout for the at least one room visible in that panorama image and a determined position of the acquisition location for that panorama image in the generated structural layout for the at least one room, the one or more rendered views for that panorama image including at least one of a floor view of the at least some floor for that panorama image or a ceiling view of the at least some ceiling for that panorama image.

15. A computer-implemented method in which one or more computing devices (185) perform the automated operations of any one of claims 1-14.

**Patentansprüche**

1. Nichtflüchtiges, computerlesbares Medium (152), das gespeicherte Inhalte aufweist, die eine oder mehrere Computervorrichtungen (185) dazu veranlassen, automatisierte Vorgänge auszuführen, die mindestens Folgendes einschließen:

Erhalten, durch die eine oder mehrere Computervorrichtungen (185), einer Vielzahl von Panoramabildern (165), die an einer Vielzahl von Aufnahmestandorten (210a, 210b) in einem Gebäude (198), das mehrere Räume aufweist, aufgenommen wurden und die eine visuelle Abdeckung von mindestens einem Teil der Wände sowie eines Bodens und einer Decke eines oder mehrerer dieser Räume einschließen, wobei jedes der Panoramabilder (165) eine horizontale visuelle Abdeckung von 360 Grad um eine vertikale Achse einschließt und Rot-Grün-Blau-Pixeldaten (RGB) in einem äquirektangulären Format für mindestens einen Teil der Wände sowie des Bodens und der Decke des einen oder der mehreren Räume bereitstellt;

Analysieren, durch die eine oder mehrere Computervorrichtungen (185) und für jedes der Panoramabilder (165), von Farbpixeldaten dieses Panoramabildes (165), um verschiedene Arten von Informationen über mindestens einen in diesem Panoramabild (165) sichtbaren Raum zu generieren, wobei die verschiedenen Arten von Informationen ein generiertes strukturelles Layout (242) einschließen, das mindestens einige Wände dieses mindestens einen Raums angibt, sowie eine innerhalb dieses strukturellen Layouts (242) bestimmte Position des Aufnahmestandorts (210a) für ein Panoramabild (165), und eine oder mehrere gerenderte Ansichten (255g1) von mindestens einem Teil eines Bodens oder einer Decke dieses mindestens einen Raums einschließen, die Informationen einschließen, die unter Verwendung der Farbpixeldaten dieses Panoramabildes (165) generiert wurden, wobei die eine oder die mehreren gerenderten Ansichten (255g1) für dieses Panoramabild (165) zweidimensional in perspektivischer oder orthogonaler Darstellung gerendert sind und jeweils einen Teil der RGB-Pixeldaten dieses Panoramabildes (165), die in dieser gerenderten Ansicht mindestens teilweise auf der Grundlage des generierten strukturellen Layouts (255g1) für den mindestens einen in diesem Panoramabild (165) sichtbaren Raum positioniert sind, und die bestimmte Position des Aufnahmestandorts (210a) für dieses Panoramabild (165) einschließen, wobei die eine oder die mehreren gerenderten Ansichten (255g1) für dieses Panoramabild (165) mindestens eine von einer Bodenansicht (255g1) von mindestens einem Teil des Bodens für dieses Panoramabild (165) oder einer Deckenansicht (255g2) von mindestens einem Teil der Decke für dieses Panoramabild (165) einschließen;

Bestimmen, durch die eine oder mehrere Computervorrichtungen (185) und unter Verwendung eines trainierten Modells für maschinelles Lernen, das Teil eines konvolutionellen neuronalen Netzwerks ist, das darauf trainiert wurde, lokale Ausrichtungen zwischen visuellen Daten zu validieren, die in gerenderten Ansichten (255g1) von zwei Bildern (165) eingeschlossen sind, und für jedes von einem oder mehreren Bildpaaren, die jeweils zwei der Panoramabilder (165) aufweisen, die in zwei der mehreren Räume aufgenommen wurden, von lokalen Ausrichtungsinformationen zwischen den Aufnahmestandorten (210a, 210b) dieser beiden Panoramabilder (165), mindestens teilweise basierend auf einem Vergleich von Informationen für die eine oder mehrere gerenderte Ansichten (255g1) für jedes dieser beiden Panoramabilder (165), einschließlich Abgleichen eines oder mehrerer struktureller Elemente (196-1), die in der überlappenden visuellen Abdeckung der beiden Panoramabilder (165) dieses Bildpaares identifiziert wurden;

Generieren von globalen Ausrichtungsinformationen durch die eine oder mehrere Computervorrichtungen (185), die Positionen für mindestens einige der Vielzahl von Aufnahmestandorten (210a, 210b) in einem gemeinsamen Koordinatensystem (205) einschließen, einschließlich Zusammenführen der lokalen Ausrichtungsinformationen, die zwischen den Aufnahmestandorten (210a, 210b) für mindestens einige der einen oder mehreren Bildpaare bestimmt wurden;

Generieren eines Grundrisses (230k) für mindestens einen Teil des Gebäudes (198) durch die eine oder mehrere Computervorrichtungen (185), einschließlich Anpassen der generierten strukturellen Layouts für mindestens den einen oder die mehreren Räume unter Verwendung der Positionen aus den globalen Ausrichtungsinformationen für mindestens einen Teil der Vielzahl von Aufnahmestandorten (210a, 210b); und

Bereitstellen des generierten Grundrisses (230k) durch die eine oder die mehreren Computervorrichtungen (185), um die Nutzung des generierten Grundrisses (230k) zu ermöglichen.

2. Nichtflüchtiges, computerlesbares Medium nach Anspruch 1, wobei die Vielzahl von Panoramabildern für jeden der mehreren Räume eines der in diesem Raum aufgenommenen Panoramabilder einschließt, wobei der generierte Grundriss generierte strukturelle Layouts für alle der mehreren Räume einschließt, die jeweils ein zweidimensionales strukturelles Layout darstellen, und wobei das Bereitstellen des generierten Grundrisses das Übertragen des generierten Grundrisses durch die eine oder die mehreren Computervorrichtungen an eine oder mehrere Client-Vorrichtungen über ein oder mehrere Netzwerke einschließt, um die Anzeige des generierten Grundrisses auf der einen oder den mehreren Client-Vorrichtungen zu bewirken.

3. Nichtflüchtiges, computerlesbares Medium nach Anspruch 1, wobei das eine oder die mehreren Bildpaare mindestens ein erstes Bildpaar einschließen, das zwei Panoramabilder aufweist, die in unterschiedlichen ersten und zweiten Räumen aufgenommen wurden, jedoch eine überlappende visuelle Abdeckung durch mindestens eine Türöffnung oder eine Wandöffnung, die keine Türöffnung ist, in mindestens einem der ersten und zweiten Räume aufweisen, sowie ein zweites Bildpaar, das zwei Panoramabilder aufweist, die in unterschiedlichen dritten und vierten Räumen aufgenommen wurden, jedoch keine überlappende visuelle Abdeckung aufweisen, und wobei das Bestimmen der lokalen Ausrichtungsinformationen für jedes der ersten und zweiten Bildpaare das Validieren der lokalen Ausrichtungsinformationen für das erste Bildpaar einschließt, das mindestens teilweise auf dem Abgleichen der überlappenden visuellen Abdeckung der beiden in dem ersten und zweiten Raum aufgenommenen Panoramabilder basiert, und das Verwerfen der lokalen Ausrichtungsinformationen für das zweite Bildpaar vor dem Zusammenführen der lokalen Ausrichtungsinformationen einschließt, das auf dem Nichtvalidieren der lokalen Ausrichtungsinformationen für das zweite Bildpaar basiert.

4. Nichtflüchtiges, computerlesbares Medium nach Anspruch 3, wobei das eine oder die mehreren Bildpaare weiter ein drittes Bildpaar einschließen, das zwei Panoramabilder aufweist, die in unterschiedlichen fünften und sechsten Räumen aufgenommen wurden, jedoch keine überlappende visuelle Abdeckung aufweisen, und wobei das Bestimmen der lokalen Ausrichtungsinformationen für das dritte Bildpaar das Validieren der lokalen Ausrichtungsinformationen für das dritte Bildpaar trotz fehlender überlappender visueller Abdeckung einschließt, das mindestens teilweise auf dem Abgleichen visueller Daten der beiden im fünften und sechsten Raum aufgenommenen Panoramabilder mit zuvor bestimmten Informationen über Arten visueller Daten, die in benachbarten Räumen vorhanden sind, basiert.

5. Nichtflüchtiges, computerlesbares Medium nach Anspruch 1, wobei die Informationen, die in mindestens einer der einen oder mehreren gerenderten Ansichten für jedes der Panoramabilder eingeschlossen sind, mindestens eines von Folgendem einschließen:

   mindestens einige der Farbpixeldaten dieses Panoramabildes, die unter Verwendung monokularer Tiefeninformationen, die ausschließlich auf der Grundlage einer Analyse der Farbpixeldaten dieses Panoramabildes vom Aufnahmestandort für dieses Panoramabild auf umgebende Strukturelemente geschätzt werden, auf Pixelpositionen in der mindestens einen gerenderten Ansicht texturabgebildet werden; und/oder
   überlagerte Informationen, die einen oder mehrere Standorte mindestens einer von einer Türöffnung oder einer Wandöffnung, die keine Türöffnung ist, oder eines Fensters anzeigen, die ausschließlich auf der Grundlage einer Analyse der Farbpixeldaten dieses Panoramabildes identifiziert werden; und/oder
   überlagerte Informationen, die einen oder mehrere Standorte mindestens einer Art von Objekt oder Oberfläche in dem einen oder den mehreren Räumen anzeigen, die in der visuellen Abdeckung dieses Panoramabildes eingeschlossen sind und die ausschließlich auf der Grundlage einer Analyse der Farbpixeldaten dieses Panoramabildes identifiziert werden; und/oder
   mindestens einige der Farbpixeldaten dieses Panoramabildes, die unter Verwendung monokularer Tiefeninformationen, die anhand des Aufnahmestandorts für dieses Panoramabild auf umgebende Strukturelemente geschätzt werden, auf Pixelpositionen in der mindestens einen gerenderten Ansicht texturabgebildet werden, und überlagerte Informationen einschließen, um einen oder mehrere identifizierte Standorte mindestens einer Türöffnung, einer Wandöffnung, die keine Türöffnung ist, oder eines Fensters anzuzeigen.

6. Nichtflüchtiges, computerlesbares Medium nach Anspruch 1, wobei das Analysieren der Farbpixeldaten jedes der Panoramabilder die Verwendung eines zweiten neuronalen Netzes einschließt, das darauf trainiert ist, gemeinsam Layoutinformationen für in den Bildern sichtbare Räume zu bestimmen und Bildposeinformationen für diese Bilder innerhalb dieser Layouts zu bestimmen, und wobei der gespeicherte Inhalt Softwareanweisungen einschließt, die bei ihrer Ausführung bewirken, dass die eine oder die mehreren Computervorrichtungen weitere automatisierte Vorgänge ausführen, einschließlich des Bestimmens durch die eine oder die mehreren Computervorrichtungen unter Verwendung eines dritten neuronalen Netzes, das darauf trainiert ist, in Bildern sichtbare Räume in strukturelle Wandelemente zu segmentieren, und für jedes der Panoramabilder die Farbpixeldaten dieses Panoramabildes dazu veranlassen, weitere Informationen über den mindestens einen in diesem Panoramabild sichtbaren Raum zu generieren, die einen bestimmten Standort mindestens einer Türöffnung oder einer Wandöffnung, die keine Türöffnung ist, für diesen mindestens einen Raum auf dem generierten strukturellen Grundriss für diesen mindestens einen Raum einschließen und die weiter mindestens einen weiteren bestimmten Standort mindestens eines Fensters für diesen mindestens einen Raum einschließen.

7. Nichtflüchtiges, computerlesbares Medium nach Anspruch 1, wobei das eine oder die mehreren Bildpaare eine Vielzahl von Bildpaaren einschließen, und wobei das Zusammenführen der lokalen Ausrichtungsinformationen das Zusammenführen von lokalen Ausrichtungsinformationen einschließt, die für mehrere Bildpaare aus der Vielzahl von Bildpaaren bestimmt wurden, durch Generieren einer oder mehrerer Gruppen, von denen jede mindestens drei Aufnahmestandorte aufweist, die alle über bestimmte lokale Ausrichtungsinformationen miteinander verbunden sind, Ausführen einer Rotationsmittelung zur Schätzung der Richtungen zwischen den mindestens drei Aufnahmestandorten im gemeinsamen Koordinatensystem, und Ausführen einer oder mehrerer Überprüfungen der geschätzten Richtungen, um sicherzustellen, dass die geschätzten Richtungen zwischen den mindestens drei Aufnahmestandorten übereinstimmen.

8. Nichtflüchtiges, computerlesbares Medium nach Anspruch 1, wobei das für jedes der Panoramabilder durch die Analyse der Farbpixeldaten dieses Panoramabildes generierte strukturelle Layout mindestens eines aus Folgendem ist:

eine generierte dreidimensionale Form des mindestens einen Raums, der in diesem Panoramabild sichtbar ist, und wobei das Bestimmen der lokalen Ausrichtungsinformationen zwischen den Aufnahmestandorten der beiden Panoramabilder für jedes der einen oder mehreren Bildpaare das Vergleichen der generierten dreidimensionalen Formen für diese beiden Panoramabilder einschließt; und/oder
eine generierte dreidimensionale Form des mindestens einen Raums, der in diesem Panoramabild sichtbar ist, und wobei das Anpassen der generierten strukturellen Layouts für den mindestens einen oder die mehreren Räume das Zusammenführen der generierten dreidimensionalen Formen aus allen Panoramabildern einschließt, das mindestens teilweise auf mindestens einer der Türöffnungen oder Nicht-Türöffnungen basiert, die in den mehreren Räumen durch die Analyse der Farbpixeldaten der Panoramabilder identifiziert wurden.

9. Nichtflüchtiges, computerlesbares Medium nach Anspruch 1, wobei mindestens einige der Panoramabilder jeweils die visuelle Abdeckung von zwei oder mehr Räumen einschließen und die für dieses Panoramabild generierten mehreren Arten von Informationen sich auf alle der zwei oder mehr Räume beziehen, und wobei das Generieren der mehreren Arten von Informationen für jedes Panorama das Analysieren einer Kombination aus den RGB-Pixeldaten dieses Panoramabildes und zusätzlichen Tiefendaten einschließt, die am Aufnahmestandort dieses Panoramabildes unter Verwendung einer oder mehrerer Tiefenerfassungsvorrichtungen erfasst wurden.

10. Nichtflüchtiges, computerlesbares Medium nach Anspruch 1, wobei die automatisierten Vorgänge weiter das Analysieren dieses Panoramabildes durch die eine oder die mehreren Computervorrichtungen und für jedes der Panoramabilder einschließen, um Tiefendaten vom Aufnahmestandort dieses Panoramabildes zu den mindestens einigen Wänden des mindestens einen Raums, die in diesem Panoramabild sichtbar sind, zu generieren, und wobei die eine oder die mehreren gerenderten Ansichten für dieses Panoramabild, die mindestens einen Teil des Bodens oder der Decke des mindestens einen in diesem Panoramabild sichtbaren Raums zeigen, mindestens einige der generierten Tiefendaten einschließen.

11. Nichtflüchtiges, computerlesbares Medium nach Anspruch 1, wobei die automatisierten Vorgänge weiter das Analysieren dieses Panoramabildes durch die eine oder die mehreren Computervorrichtungen und für jedes der Panoramabilder einschließen, um die Standorte von Objekten zu bestimmen, die in diesem Panoramabild sichtbar sind, und wobei die eine oder die mehreren gerenderten Ansichten für dieses Panoramabild, die mindestens einen Teil des Bodens oder der Decke des mindestens einen in diesem Panoramabild sichtbaren Raums zeigen, Angaben zu mindestens einigen der bestimmten Standorte der Objekte einschließen.

12. System (180) umfassend:

einen oder mehrere Hardware-Prozessoren (132) eines oder mehrerer Computersysteme (185); und
einen oder mehrere Speicher (152) mit gespeicherten Anweisungen, die, wenn sie durch mindestens einen des einen oder der mehreren Hardware-Prozessoren (132) ausgeführt werden, bewirken, dass das eine oder die mehreren Computersysteme (185) automatisierte Vorgänge ausführen, die mindestens Folgendes einschließen:

Erhalten einer Vielzahl von Panoramabildern (165), die an einer Vielzahl von Aufnahmestandorten (210a, 210b) für ein Gebäude (198), das mehrere Räume aufweist, aufgenommen wurden und die eine visuelle Abdeckung mindestens einiger Wände eines oder mehrerer der Räume einschließen, wobei jedes der Panoramabilder (165) eine horizontale visuelle Abdeckung von 360 Grad um eine vertikale Achse einschließt und Rot-Grün-Blau-Pixeldaten (RGB) in einem äquirektangulären Format für mindestens einige der Wände des einen oder der mehreren Räume bereitstellt;

Analysieren, für jedes von mindestens einigen der Panoramabilder (165), von Farbpixeldaten dieses Panoramabildes, um Informationen über mindestens einen Raum der einen oder mehreren Räume zu generieren, der in diesem Panoramabild (165) sichtbar ist, einschließlich einer oder mehrerer gerenderter Ansichten (255g1) von mindestens einem Teil einer oder mehreren ebenen Flächen in diesem mindestens einen Raum, die Daten einschließen, die unter Verwendung der Farbpixeldaten dieses Panoramabildes (165) generiert wurden, wobei die eine oder die mehreren gerenderten Ansichten (255g1) für dieses Panoramabild (165) zweidimensional in perspektivischer oder orthogonaler Darstellung gerendert sind und jeweils einen Teil der RGB-Pixeldaten dieses Panoramabildes (165), die in dieser gerenderten Ansicht (255g1) mindestens teilweise auf der Grundlage des strukturellen Layouts für den mindestens einen in diesem Panoramabild sichtbaren Raum positioniert sind (165), und eine Position des Aufnahmestandorts (210a) für dieses Panoramabild (165) einschließen, wobei die eine oder die mehreren gerenderten Ansichten (255g1) für dieses Panoramabild (165) mindestens eine von einer Bodenansicht (255g1) von mindestens einem Teil des Bodens des mindestens einen Raums, der in diesem Panoramabild (165) sichtbar ist, oder einer Deckenansicht (255g2) von mindestens einem Teil der Decke des mindestens einen Raums, der in diesem Panoramabild (165) sichtbar ist, einschließen;

Bestimmen, mindestens teilweise unter Verwendung eines trainierten neuronalen Netzwerks, das Teil eines konvolutionellen neuronalen Netzwerks ist, das darauf trainiert ist, lokale Ausrichtungen zwischen visuellen Daten zu validieren, die in gerenderten Ansichten (255g1) von zwei Bildern eingeschlossen sind, und für jede einer oder mehrerer Bildgruppen, von denen jede mindestens zwei Panoramabilder (165) aufweist, von den mindestens einigen Panoramabildern (165), von Ausrichtungsinformationen zwischen den Aufnahmestandorten (210a, 210b) dieser mindestens zwei Panoramabilder (165) mindestens teilweise basierend auf dem Vergleich von Informationen für die eine oder mehrere gerenderten Ansichten (255g1) für jedes dieser mindestens zwei Panoramabilder (165), einschließlich des Abgleichens eines oder mehrerer struktureller Elemente (196-1), die in der überlappenden visuellen Abdeckung dieser mindestens zwei Panoramabilder (165) identifiziert wurden, wobei das Bestimmen der Ausrichtungsinformationen zwischen diesen Aufnahmestandorten (210a, 210b) das Bestimmen von Positionen einschließt, die mindestens relativ zueinander sind;

Generieren mindestens eines Teilgrundrisses (230k) für mindestens einen Teil des Gebäudes, einschließlich Anordnen generierter struktureller Layouts für mindestens einen oder mehrere Räume unter Verwendung der bestimmten Positionen der Aufnahmestandorte (210a, 210b) der mindestens zwei Panoramabilder (165) für jede der einen oder mehreren Bildgruppen; und

Bereitstellen des generierten mindestens Teilgrundrisses (230k), um die Verwendung des generierten Grundrisses (230k) zu ermöglichen.

13. System nach Anspruch 12, wobei die Vielzahl von Panoramabildern für jeden der mehreren Räume eines der in diesem Raum aufgenommenen Panoramabilder einschließt, das die visuelle Abdeckung von mindestens einigen Wänden dieses Raums aufweist, wobei der generierte mindestens Teilgrundriss generierte strukturelle Layouts für alle der mehreren Räume einschließt, und wobei das Bereitstellen des generierten mindestens Teilgrundrisses das Übertragen des generierten mindestens Teilgrundrisses an ein oder mehrere Client-Geräte über ein oder mehrere Netzwerke einschließt, um die Anzeige des generierten mindestens Teilgrundrisses auf dem einen oder den mehreren Client-Geräten zu bewirken.

14. System nach Anspruch 12, wobei das trainierte neuronale Netzwerk ein konvolutionelles neuronales Netzwerk ist, das darauf trainiert ist, lokale Ausrichtungen zwischen visuellen Daten, die in gerenderten Ansichten für zwei Bilder eingeschlossen sind, zu validieren, und

wobei die Vielzahl von Panoramabildern für jeden der mehreren Räume eines der in diesem Raum aufgenommenen Panoramabilder einschließt, das die visuelle Abdeckung von mindestens einigen Wänden dieses Raums sowie von mindestens einem von mindestens Teil des Bodens oder der Decke dieses Raums aufweist, und

wobei das Analysieren der Farbpixeldaten für die mindestens einigen Panoramabilder weiter das Verwenden dieser Farbpixeldaten zum Generieren der strukturellen Layouts für den mindestens einen oder die mehreren Räume einschließt, wobei die generierten strukturellen Layouts die mindestens einigen Wände des mindestens einen oder der mehreren Räume anzeigen, und

wobei die automatisierten Vorgänge weiter das Generieren der lokalen Ausrichtungsinformationen für jede der Bildgruppen einschließen, das mindestens teilweise auf dem Abgleichen eines oder mehrerer struktureller Elemente basiert, die in der überlappenden visuellen Abdeckung der mindestens zwei Panoramabilder dieser Bildgruppe identifiziert wurden, und

wobei jedes der in einem der mehreren Räume aufgenommenen Panoramabilder eine horizontale visuelle Abdeckung von 360 Grad um eine vertikale Achse einschließt und RGB-Pixeldaten (Rot-Grün-Blau) in einem äquirektangulären Format für die mindestens einige Wände dieses Raums sowie für mindestens einen Teil von mindestens einem von dem Boden dieses Raums oder der Decke dieses Raums bereitstellt, und die eine oder die mehreren gerenderten Ansichten für dieses Panoramabild zweidimensional in perspektivischer oder orthogonaler Darstellung gerendert sind und jeweils einen Teil der RGB-Pixeldaten dieses Panoramabildes, die in dieser gerenderten Ansicht mindestens teilweise auf der Grundlage des generierten strukturellen Layouts für den mindestens einen in diesem Panoramabild sichtbaren Raum positioniert sind, und eine bestimmte Position des Aufnahmestandorts für dieses Panoramabild in dem generierten strukturellen Layout für den mindestens einen Raum einschließen, wobei die eine oder die mehreren gerenderten Ansichten für dieses Panoramabild mindestens eine von einer Bodenansicht von mindestens einem Teil des Bodens für dieses Panoramabild oder einer Deckenansicht von mindestens einem Teil der Decke für dieses Panoramabild einschließen.

15. Computerimplementiertes Verfahren, bei dem eine oder mehrere Computervorrichtungen (185) die automatisierten Vorgänge nach einem der Ansprüche 1 bis 14 ausführen.


**Revendications**

1. Support non transitoire lisible par ordinateur (152) présentant des contenus stockés qui amènent un ou plusieurs dispositifs informatiques (185) à réaliser des opérations automatisées incluant au moins :

l'obtention, par les un ou plusieurs dispositifs informatiques (185), d'une pluralité d'images de panorama (165) qui sont capturées au niveau d'une pluralité d'emplacements d'acquisition (210a, 210b) dans un bâtiment (198) présentant de multiples pièces et qui incluent une couverture visuelle d'au moins une partie des murs et d'un sol et d'un plafond d'une ou plusieurs des pièces,
dans lequel chacune des images de panorama (165) inclut 360 degrés de couverture visuelle horizontale autour d'un axe vertical et fournit des données de pixels rouge-vert-bleu, RVB, dans un format équirectangulaire pour l'au moins une partie des murs et du sol et du plafond des une ou plusieurs pièces ;
l'analyse, par les un ou plusieurs dispositifs informatiques (185) et pour chacune des images de panorama (165), de données de pixels de couleur de cette image de panorama (165) pour générer de multiples types d'information sur au moins une pièce visible dans cette image de panorama (165), dans lequel les multiples types d'informations incluent une disposition structurelle générée (242) indiquant au moins une partie des murs de cette au moins une pièce et incluent une position déterminée au sein de cette disposition structurelle (242) de l'emplacement d'acquisition (210a) pour une image de panorama (165) et incluent une ou plusieurs vues rendues (255g1) d'au moins une partie d'un sol ou d'un plafond de cette au moins une pièce qui incluent des informations générées à l'aide des données de pixels de couleur de cette image de panorama (165), dans lequel les une ou plusieurs vues rendues (255g1) pour cette image de panorama (165) sont rendues dans deux dimensions sous forme de perspective ou de projection orthographique et incluent chacune une partie des données de pixels RVB de cette image de panorama (165) qui est positionnée dans cette vue rendue sur la base au moins en partie de la disposition structurelle générée (255g1) pour l'au moins une pièce visible dans cette image de panorama (165) et de la position déterminée de l'emplacement d'acquisition (210a) pour cette image de panorama (165), les une ou plusieurs vues rendues (255g1) pour cette image de panorama (165) incluant au moins l'une parmi une vue de sol (255g1) de l'au moins une partie de sol pour cette image de panorama (165) ou une vue de plafond (255g2) de l'au moins partie de plafond pour cette image de panorama (165) ;
la détermination, par les un ou plusieurs dispositifs informatiques (185) et à l'aide d'un modèle d'apprentissage machine entraîné qui fait partie d'un réseau neuronal convolutif entraîné pour valider des alignements locaux entre des données visuelles incluses dans des vues rendues (255g1) de deux images (165) et pour chacune d'une ou plusieurs paires d'images présentant chacune deux des images de panorama (165) qui sont capturées dans deux des multiples pièces, des informations d'alignement local entre les emplacements d'acquisition (210a, 210b) de ces deux images de panorama (165) sur la base au moins en partie d'informations de comparaison pour les une ou plusieurs vues rendues (255g1) pour chacune de ces deux images de panorama (165), incluant la correspondance d'un ou plusieurs éléments structurels (196-1) identifiés dans une couverture visuelle de chevauchement des deux images de panorama (165) de cette paire d'images ;
la génération, par les un ou plusieurs dispositifs informatiques (185), d'informations d'alignement global qui incluent des positions pour au moins une partie de la pluralité d'emplacements d'acquisition (210a, 210b) dans un système de coordonnées commun (205), incluant la combinaison des informations d'alignement local déterminées entre les emplacements d'acquisition (210a, 210b) pour au moins une partie des une ou plusieurs paires d'images ;
la génération, par les un ou plusieurs dispositifs informatiques (185), d'un plan de sol (230k) pour au moins une partie du bâtiment (198), incluant l'ajustement de dispositions structurelles générées pour au moins les une ou plusieurs pièces à l'aide des positions provenant des informations d'alignement global pour l'au moins une partie de la pluralité d'emplacements d'acquisition (210a, 210b) ; et
la fourniture, par les un ou plusieurs dispositifs informatiques (185), du plan de sol généré (230k), pour permettre une utilisation du plan de sol généré (230k).

2. Support non transitoire lisible par ordinateur selon la revendication 1, dans lequel la pluralité d'images de panorama incluent, pour chacune des multiples pièces, l'une des images de panorama capturées dans cette pièce, dans lequel le plan de sol généré inclut des dispositions structurelles générées pour la totalité des multiples pièces qui sont chacune une disposition structurelle bidimensionnelle, et dans lequel la fourniture du plan de sol généré inclut la transmission, par les un ou plusieurs dispositifs informatiques et à un ou plusieurs dispositifs clients sur un ou plusieurs réseaux, du plan de sol généré pour provoquer un affichage du plan de sol généré sur les un ou plusieurs dispositifs clients.

3. Support non transitoire lisible par ordinateur selon la revendication 1, dans lequel les une ou plusieurs paires d'images incluent au moins une première paire d'images présentant deux images de panorama capturées dans des première et deuxième pièces différentes mais présentant une couverture visuelle de chevauchement par le biais d'au moins l'une parmi une embrasure ou une ouverture de mur qui n'est pas une embrasure d'au moins l'une des première et deuxième pièces et une deuxième paire d'images présentant deux images de panorama capturées dans des troisième et quatrième pièces différentes mais sans aucune couverture visuelle de chevauchement, et dans lequel la détermination des informations d'alignement local pour chacune des première et deuxième paires d'images inclut la validation des informations d'alignement local pour la première paire d'images sur la base au moins en partie de la correspondance de la couverture visuelle de chevauchement des deux images de panorama capturées dans les première et deuxième pièces, et inclut le fait d'ignorer les informations d'alignement local pour la deuxième paire d'images avant la combinaison des informations d'alignement local sur la base de la non-validation des informations d'alignement local pour la deuxième paire d'images.

4. Support non transitoire lisible par ordinateur selon la revendication 3 dans lequel les une ou plusieurs paires d'images incluent en outre une troisième paire d'images présentant deux images de panorama capturées dans des cinquième et sixième pièces différentes mais sans aucune couverture visuelle de chevauchement, et dans lequel la détermination des informations d'alignement local pour la troisième paire d'images inclut la validation des informations d'alignement local pour la troisième paire d'images malgré une absence d'une quelconque couverture visuelle de chevauchement sur la base au moins en partie de la correspondance de données visuelles des deux images de panorama capturées dans les cinquième et sixième pièces avec des informations déterminées précédemment concernant des types de données visuelles présents dans des types de pièces adjacentes.

5. Support non transitoire lisible par ordinateur selon la revendication 1, dans lequel les informations incluses dans au moins l'une des une ou plusieurs vues rendues pour chacune des images de panorama inclut au moins l'une parmi :

au moins une partie des données de pixels de couleur de cette image de panorama qui sont mappées en texture sur des positions de pixels dans l'au moins une vue rendue à l'aide d'informations de profondeur monoculaire qui sont estimées à partir de l'emplacement d'acquisition pour cette image de panorama vers des éléments structurels environnants sur la base uniquement de l'analyse des données de pixels de couleur de cette image de panorama ; et/ou
des informations superposées pour indiquer un ou plusieurs emplacements d'au moins l'une parmi une embrasure ou une ouverture de mur qui n'est pas une embrasure ou une fenêtre qui sont identifiées sur la base uniquement de l'analyse des données de pixels de couleur de cette image de panorama ; et/ou
des informations superposées pour indiquer un ou plusieurs emplacements d'au moins un type d'objet ou de surface des une ou plusieurs pièces qui sont incluses dans la couverture visuelle de cette image de panorama et qui sont identifiées sur la base uniquement de l'analyse des données de pixels de couleur de cette image de panorama ; et/ou
au moins une partie des données de pixels de couleur de cette image de panorama qui sont mappées en texture sur des positions de pixels dans l'au moins une vue rendue à l'aide d'informations de profondeur monoculaire qui sont estimées à partir de l'emplacement d'acquisition pour cette image de panorama vers des éléments structurels environnants et inclut des informations superposées pour indiquer un ou plusieurs emplacements identifiés d'au moins l'une parmi une embrasure ou une ouverture de mur qui n'est pas une embrasure ou une fenêtre.

**6.** Support non transitoire lisible par ordinateur selon la revendication 1, dans lequel l'analyse des données de pixels de couleur de chacune des images de panorama inclut l'utilisation d'un second réseau neuronal entraîné pour déterminer conjointement des informations de disposition pour des pièces visibles dans des images et déterminer des informations de pose d'image pour les images au sein de ces dispositions, et dans lequel les contenus stockés incluent des instructions logicielles qui, lorsqu'elles sont exécutées, amènent les un ou plusieurs dispositifs informatiques à réaliser des opérations automatisées supplémentaires incluant la détermination, par les un ou plusieurs dispositifs informatiques et à l'aide d'un troisième réseau neuronal entraîné pour segmenter des pièces visibles dans des images en éléments de mur structuraux, et pour chacune des images de panorama, les données de pixels de couleur de cette image de panorama pour générer des informations supplémentaires sur l'au moins une pièce visible dans cette image de panorama qui inclut un emplacement déterminé d'au moins une embrasure ou une ouverture de mur qui n'est pas une embrasure pour cette au moins une pièce sur la disposition structurelle générée pour cette au moins une pièce et qui inclut en outre au moins un emplacement déterminé additionnel d'au moins une fenêtre pour cette au moins une pièce.

**7.** Support non transitoire lisible par ordinateur selon la revendication 1, dans lequel les une ou plusieurs paires d'images incluent une pluralité de paires d'images, et dans lequel la combinaison des informations d'alignement local inclut la combinaison d'informations d'alignement local déterminées pour de multiples paires d'images de la pluralité de paires d'images en générant un ou plusieurs groupes présentant chacun au moins trois emplacements d'acquisition qui sont tous interconnectés via des informations d'alignement local déterminées, la réalisation d'une moyenne de rotation pour estimer des directions entre les au moins trois emplacements d'acquisition dans le système de coordonnées commun, et la réalisation d'une ou plusieurs vérifications sur les directions estimées pour confirmer que les directions estimées entre les au moins trois emplacements d'acquisition sont cohérentes.

**8.** Support non transitoire lisible par ordinateur selon la revendication 1, dans lequel la disposition structurelle générée pour chacune des images de panorama à partir de l'analyse des données de pixels de couleur de cette image de panorama est au moins l'une parmi :

une forme tridimensionnelle générée de l'au moins une pièce visible dans cette image de panorama et dans lequel la détermination des informations d'alignement local entre les emplacements d'acquisition des deux images de panorama pour chacune des une ou plusieurs paires d'images inclut la comparaison des formes tridimensionnelles générées pour ces deux images de panorama ; et/ou
une forme tridimensionnelle générée de l'au moins une pièce visible dans cette image de panorama et dans lequel l'ajustement des dispositions structurelles générées pour les au moins une ou plusieurs pièces inclut la combinaison des formes tridimensionnelles générées à partir de la totalité des images de panorama sur la base au moins en partie d'au moins l'une parmi des embrasures ou des ouvertures qui ne sont pas des embrasures identifiées dans les multiples pièces à partir de l'analyse des données de pixels de couleur des images de panorama.

**9.** Support non transitoire lisible par ordinateur selon la revendication 1, dans lequel au moins une partie des images de panorama incluent chacune une couverture visuelle pour deux pièces ou plus et de multiples types d'informations générées pour cette image de panorama sont pour la totalité des deux pièces ou plus, et dans lequel la génération des multiples types d'informations pour chaque panorama inclut l'analyse d'une combinaison des données de pixels RVB de cette image de panorama et des données de profondeur additionnelles acquises à partir de l'emplacement d'acquisition de cette image de panorama à l'aide d'un ou plusieurs dispositifs de détection de profondeur.

**10.** Support non transitoire lisible par ordinateur selon la revendication 1, dans lequel les opérations automatisées incluent l'analyse, par les un ou plusieurs dispositifs informatiques et pour chacune des images de panorama, cette image de panorama pour générer des données de profondeur à partir de l'emplacement d'acquisition de cette image de panorama vers l'au moins une partie des murs de l'au moins une pièce visible dans cette image de panorama, et dans lequel les une ou plusieurs vues rendues pour cette image de panorama de l'au moins une partie du sol ou du plafond de l'au moins une pièce visible dans cette image de panorama incluent au moins une partie des données de profondeur générées.

**11.** Support non transitoire lisible par ordinateur selon la revendication 1, dans lequel les opérations automatisées incluent en outre l'analyse, par les un ou plusieurs dispositifs informatiques et pour chacune des images de panorama, de cette image de panorama pour déterminer des emplacements d'objets visibles dans cette image de panorama, et dans lequel les une ou plusieurs vues rendues pour cette image de panorama de l'au moins une partie du sol ou du plafond de l'au moins une pièce visible dans cette image de panorama incluent des indications d'au moins une partie des emplacements déterminés des objets.

12. Système (180) comprenant :

un ou plusieurs processeurs matériels (132) d'un ou plusieurs sytèmes informatiques (185) ; et
une ou plusieurs mémoires (152) avec des instructions stockées qui, lorsqu'elles sont exécutées par au moins l'un des un ou plusieurs processeurs matériels (132), amènent les un ou plusieurs systèmes informatiques (185) à réaliser des opérations automatisées incluant au moins :

l'obtention d'une pluralité d'images de panorama (165) qui sont capturées au niveau d'une pluralité d'emplacements d'acquisition (210a, 210b) pour un bâtiment (198) présentant de multiples pièces et qui incluent une couverture visuelle d'au moins une partie des murs d'une ou plusieurs des pièces, dans lequel chacune des images de panorama (165) inclut 360 degrés de couverture visuelle horizontale autour d'un axe vertical et fournit des données de pixels rouge-vert-bleu, RVB, dans un format équirectangulaire pour l'au moins une partie des murs des une ou plusieurs pièces ;
l'analyse, pour chacune de l'au moins une partie des images de panorama (165), de données de pixels de couleur de cette image de panorama pour générer des informations sur au moins une pièce des une ou plusieurs pièces qui est visible dans cette image de panorama (165), incluant une ou plusieurs vues rendues (255g1) d'au moins une partie d'une ou plusieurs surfaces planes dans au moins une pièce qui incluent des données générées à l'aide des données de pixels de couleur de cette image de panorama (165), dans lequel les une ou plusieurs vues rendues (255g1) pour cette image de panorama (165) sont rendues en deux dimensions sous forme de perspective ou de projection orthographique et chacune inclut une partie des données de pixels RVB de cette image de panorama (165) qui est positionnée dans cette vue rendue (255g1) sur la base au moins en partie d'une disposition structurelle pour l'au moins une pièce visible dans cette image de panorama (165) et d'une position de l'emplacement d'acquisition (210a) pour cette image de panorama (165), les une ou plusieurs vues rendues (255g1) pour cette image de panorama (165) incluant au moins l'une parmi une vue de sol (255g1) d'au moins une partie du sol de l'au moins une pièce visible dans cette image de panorama (165) ou une vue de plafond (255g2) d'au moins un plafond de l'au moins une pièce visible dans cette image de panorama (165) ;
la détermination, sur la base au moins en partie de l'utilisation d'un réseau neuronal entraîné qui fait partie d'un réseau neuronal convolutif entraîné pour valider des alignements locaux entre des données visuelles incluses dans des vues rendues (255g1) de deux images et pour chacun des un ou plusieurs groupes d'images présentant au moins deux images de panorama (165) de l'au moins une partie d'images de panorama (165), des informations d'alignement entre les emplacements d'acquisition (210a, 210b) de ces au moins deux images de panorama (165) sur la base au moins en partie d'informations de comparaison pour les une ou plusieurs vues rendues (255g1) pour chacune de ces au moins deux images de panorama (165), incluant la correspondance d'un ou plusieurs éléments structurels (196-1) identifiés dans la couverture visuelle de chevauchement de ces au moins deux images de panorama (165),

la détermination des informations d'alignement entre ces emplacements d'acquisition (210a, 210b) incluant la détermination de positions qui sont au moins relatives entre elles ;

la génération d'au moins un plan de sol partiel (230k) pour au moins une partie du bâtiment, incluant le placement de dispositions structurelles générées pour au moins les une ou plusieurs pièces à l'aide des positions déterminées pour les emplacements d'acquisition (210a, 210b) des au moins deux images de panorama (165) pour chacun des un ou plusieurs groupes d'images ; et
la fourniture de l'au moins un plan de sol partiel généré (230k), pour permettre l'utilisation du plan de sol généré (230k).

13. Système selon la revendication 12, dans lequel la pluralité d'images de panorama incluent, pour chacune des multiples pièces, l'une des images de panorama capturées dans cette pièce et présentant une couverture visuelle d'au moins une partie des murs de cette pièce, dans lequel l'au moins un plan de sol partiel généré inclut des dispositions structurelles générées pour la totalité des multiples pièces et dans lequel la fourniture de l'au moins un plan de sol partiel généré inclut la transmission, à un ou plusieurs dispositifs clients sur un ou plusieurs réseaux, de l'au moins un plan de sol partiel généré pour amener l'affichage de l'au moins un plan de sol partiel généré sur les un ou plusieurs dispositifs clients.

**14.** Système selon la revendication 12, dans lequel le réseau neuronal entraîné est un réseau neuronal convolutif entraîné pour valider des alignements locaux entre des données visuelles incluses dans des vues rendues pour deux images, et

dans lequel la pluralité d'images de panorama incluent, pour chacune des multiples pièces, l'une des images de panorama capturées dans cette pièce et présentant une couverture visuelle d'au moins une partie des murs de cette pièce et d'au moins une partie d'au moins l'un parmi un sol de cette pièce ou un plafond de cette pièce, et dans lequel l'analyse des données de pixels de couleur pour l'au moins une partie des images de panorama inclut en outre l'utilisation de ces données de pixels de couleur pour générer les dispositions structurelles pour les au moins une ou plusieurs pièces, les dispositions structurelles générées indiquant l'au moins une partie des murs des au moins une ou plusieurs pièces, et

dans lequel les opérations automatisées incluent en outre la génération des informations d'alignement local pour chacun des groupes d'images sur la base au moins en partie de la correspondance d'un ou plusieurs éléments structurels identifiés dans la couverture visuelle de chevauchement des au moins deux images de panorama de ce groupe d'images, et

dans lequel, pour chacune des images de panorama capturées dans une des multiples pièces, cette image de panorama inclut 360 degrés de couverture visuelle horizontale autour d'un axe vertical et fournit des données de pixels RVB (rouge-vert-bleu) dans un format équirectangulaire pour l'au moins une partie des murs de cette pièce et pour les au moins quelques-unes de l'au moins un parmi le sol de cette pièce ou le plafond de cette pièce, et les une ou plusieurs vues rendues pour cette image de panorama sont rendues en deux dimensions sous forme de perspective ou de projection orthographique et chacune inclut une partie des données de pixels RVB de cette image de panorama qui est positionnée dans cette vue rendue sur la base au moins en partie de la disposition structurelle générée pour l'au moins une pièce visible dans cette image de panorama et une position déterminée de l'emplacement d'acquisition pour cette image de panorama dans la disposition structurelle générée pour l'au moins une pièce, les une ou plusieurs vues rendues pour cette image de panorama incluant au moins l'une parmi une vue de sol de l'au moins une partie de sol pour cette image de panorama ou une vue de plafond de l'au moins une partie de plafond pour cette image de panorama.

**15.** Procédé mis en œuvre par ordinateur dans lequel un ou plusieurs dispositifs informatiques (185) réalisent les opérations automatisées selon l'une quelconque des revendications 1 à 14.

server computing system(s) *180*

Mapping Information Generation Manager (MIGM) System *140*

room layouts / building floor plans / other mapping information *145*

Image Capture & Analysis (ICA) System *160*

360° panorama images *165*

MIGM system user client computing devices *105*

network(s) *170*

map viewer user client computing devices *175*

camera device(s) *184*

mobile computing device

memory *152*

ICA Application *154*

browser *162*

sensor modules *148*

gyroscope *148a*

accelerometer *148b*

compass *148c*

depth sensor(s) *136*

imaging system *135*

display system *142*

control system *147*

processor(s) *132*

*185*

*Fig. 1A*

*Fig. 1B*

EP 4 174 772 B1

**Fig. 2A**

Fig. 2B

Fig. 2C

Fig. 2D

**255e**

MIGM System *140*

for each image, use trained neural network to estimate structural layout of room(s) visible in image *280*, including to identify wall elements such as windows, doorways and non-doorway openings, and to determine image pose within room(s), and to optionally learn floor and/or ceiling features

structural layouts and image poses and optionally floor / ceiling features *242*

final floor plan *249*, optionally with indicated image locations

combine structural layouts *286*

globally optimize aligned image pair information to produce global inter-image relative poses *285*

globally aligned panorama information *246*

for each image, render one or more top-down and bottom-up views *281* respectively of floor(s) and ceiling(s) of room(s) visible in image, such as to use RGB visual data and determined monocular depth to texture-map view(s), to overlay locations of wall elements, to add other semantic information, etc.

local aligned image pair information *245*

discard misaligned pair information *284*

multiple panorama images *241* for building (*e.g., with the images having little or no visual overlap*), optionally with floor / ceiling height information (*e.g., from camera height or other known distance*)

select next pair of images A and B to compare, retrieve estimated structural layout information and rendered views for each, and attempt to generate at least one potential alignment between the images' visual data *282*

image pair alignment information *244*

panorama image A and rendered views *243a*

panorama image B and rendered views *243b*

potential alignment validation by convolutional neural network *283*

Yes More pairs? No

rectilinear floor and ceiling views *243*

**Fig. 2E**

EP 4 174 772 B1

Fig. 2F

Fig. 2G

255g1

190-3

183-1

257g1

130q

199a

196-4

255g2

190-3

183-1

238g2

257g2

199b

199a

199b

196-4

250g

196-1

220b

130q

263a

183-1  190-3

199a

199b

196-4

256g

260

living room

263a

190-3

261

bedroom 1

door
opening
window

EP 4 174 772 B1

48

*Fig. 2H*

256h

260

living room

190-3

261

264h

bedroom 1

door
opening
window
stairs

Fig. 2I

**Fig. 2J**

*Fig. 2K*

floor 1 · 228

255k

front yard

living room

room labels

ambient sound recording

bedroom 2
20' x 25'

walk-in closet

pantry

white tile floor

patio / back yard

patio door

red Corian island

deck

shed / garage / ADU

audio annotations

kitchen / dining room

hallway

bedroom 1

bathroom 1

stairs to floor 2

family room

side yard

fixtures / appliances / built-in features

room dimensions

perspective image

360° panorama image

230k

entry door

door

window

**Fig. 2L**

EP 4 174 772 B1

Fig. 2M

54

*Fig. 2N*

Fig. 2-O

Fig. 2P

Fig. 2Q

*Fig. 2R*

*Fig. 2S*

## MIGM server computing system(s) 300

### memory 330

MIGM System 340

other programs 335

CPU 305

### I/O components 310

display 311

network connection 312

computer-readable media drive 313

other I/O devices 315

### storage 320

360° panorama image information 324

room layout and inter-room opening/window information 325

rendered views 323

building floor plans and other mapping information 326

additional information 328

user information 322

## mobile image acquisition device(s) 360

CPU 361

I/O components 362

storage 365

### memory 367

browser / client application 368

imaging system 364

IMU hardware sensors 369

camera device(s) 375

## ICA server computing system(s) 380

CPU 381

I/O components 382

memory 387

storage 385

ICA System 389

360° panorama image information 386

other navigable devices 395

network 399

client computing device(s) 390

*Fig. 3*

EP 4 174 772 B1

**ICA System Routine** — *400*

**Fig. 4**

Receive instructions or information — *405*

*410* — Acquire data representing building? — **No** → (A)

**Yes**

*412* — Receive indication that image acquisition device is ready at first acquisition location

*424* — Determine that image acquisition device has arrived at next acquisition location for use as new current acquisition location

*415* — Perform image acquisition at current acquisition location, such as to capture a 360° panorama image around a vertical axis

*420* — More acquisition locations? — **Yes** → Optionally obtain acceleration data and/or other linking information generated by image acquisition device and/or other device during movement to next acquisition location in sequence — *422*

**No**

*430* — Optionally analyze acquisition location information to identify possible additional coverage and/or other information to gather, provide corresponding user suggestions, and gather additional information as indicated

*435* — Optionally preprocess acquired images before further analysis, such as to perform equirectangular projection on 360° panorama images to cause straight vertical data to remain linear and to cause horizontal data to increasingly curve as distance above and below the image midline increases, or to otherwise generate images of a defined type and/or using a defined format

Store images and any associated generated/obtained information — *480*

(A) — *490*

Perform other indicated operation(s) as appropriate

*495* — **Yes** ← Continue? — **No** → END — *499*

**Fig. 5A**

( MIGM System Routine )⸱ 500

Receive instructions or information ⸱ 505

510 ⟨ Generate floor plan for indicated building? ⟩ No → (B)

515 Yes

Obtain panorama image(s) for building and optionally scale information (e.g., with the images having little or no visual overlap)

520

Use trained neural network to, for each image, estimate structural layout of room(s) visible in image, including to identify wall elements such as windows, doorways and non-doorway openings, and to determine image pose within room(s), and to optionally learn floor and/or ceiling features

525

For each image, render one or more top-down and/or bottom-up views of floor(s) and ceiling(s), respectively, of room(s) visible in image, such as to use RGB visual data and determined monocular depth to texture-map view(s), to overlay locations of wall elements, to add other semantic information, etc.

530

Select next pair of images to compare (beginning with a first pair)

535

Generate at least one potential alignment between images' visual data

540

Use trained convolutional neural network to attempt to validate a potential alignment between rendered views for two images of the pair, and generate alignment score

555 ⟨ More pairs? ⟩ Yes

No

(C) (D)

(B)

Store and/or otherwise use the floor plan and other information generated in blocks 520-585 ⸱ 588

Perform other indicated operation(s) (if any) as appropriate 590

595 Yes ⟨ Continue? ⟩ No → ( END ) ⸱ 599

**Fig. 5B**

C

560
Review alignment scores for potential alignments of image pairs, and discard potential alignments below determined threshold

565
Identify groups of potentially aligned image pairs and perform further multi-image alignment of more than two images, perform consistency checks between multi-image alignments, and select multi-image alignment of some or all images

570
Perform global optimization of aligned image pair information of selected multi-image alignment to produce global inter-image relative poses, and optionally add estimated positions of any images not aligned in the selected multi-image alignment

585
Use selected multi-image alignment to combine structural layout information and generate floor plan for building and optionally additional related mapping information

D

**Fig. 6**

Building Map Viewer Routine ⟩〜 *600*

↓

Receive instructions or information ⟋ *605*

↓

*660* ⟨ Select target building(s) from specified criteria? ⟩ No →

↓ Yes *662*

Obtain indications of one or more search criteria, determine one or more buildings that satisfy search criteria, and select best match target building from returned building(s)

⟋ *670*

Obtain indication of target building from received instructions or via current user selection

↓

*610* ⟨ Display target building interior information? ⟩ No

↓ Yes *612*

Retrieve floor plan map of target building and optionally associated linked information for indicated current location, and select initial current view to use

↓

*615* Display current view of retrieved information

↓

*617* Wait for user selection

↓

*620* ⟨ For current location? ⟩ Yes →

Adjust current view of retrieved information in accordance with user selection, such as to select linked information for presentation and/or to change view parameters for building floor plan

*622*

↓ No

Perform other indicated operation(s) as appropriate

*690*

⟋ *695*

Yes ← ⟨ Continue? ⟩ No → ⟨ END ⟩ ⟋ *699*

65

**REFERENCES CITED IN THE DESCRIPTION**

**Patent documents cited in the description**

- US 20210125397 A
- US 20210225081 A
- US 20130278755 A